(19) **Europäisches Patentamt European Patent Office Office européen des brevets**

(11) **EP 4 779 753 A1**

(12) **EUROPEAN PATENT APPLICATION**
published in accordance with Art. 153(4) EPC

(43) Date of publication:
**22.07.2026 Bulletin 2026/30**

(21) Application number: **24865189.5**

(22) Date of filing: **22.08.2024**

(51) International Patent Classification (IPC):
**H01M 10/48** (2006.01)       **G01R 31/382** (2019.01)
**G01R 31/385** (2019.01)      **G01R 31/387** (2019.01)
**G01R 31/389** (2019.01)      **G01R 31/392** (2019.01)
**G01R 31/396** (2019.01)      **H02J 7/00** (2026.01)

(52) Cooperative Patent Classification (CPC):
**G01R 31/382; G01R 31/385; G01R 31/387;
G01R 31/389; G01R 31/392; G01R 31/396;
H01M 10/48; H02J 7/00;** Y02E 60/10

(86) International application number:
**PCT/JP2024/029780**

(87) International publication number:
**WO 2025/057685 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.09.2023   JP 2023148760
17.06.2024   JP 2024097399**

(71) Applicant: **DENSO CORPORATION
Kariya-city, Aichi 448-8661 (JP)**

(72) Inventors:
• **MORINAGA, Takeshi**
  **Kariya-city, Aichi 448-8661 (JP)**
• **HARADA, Tomoyuki**
  **Kariya-city, Aichi 448-8661 (JP)**
• **UCHIDA, Keisuke**
  **Kariya-city, Aichi 448-8661 (JP)**
• **AKIYAMA, Keiko**
  **Kariya-city, Aichi 448-8661 (JP)**

(74) Representative: **Kuhnen & Wacker
Patent- und Rechtsanwaltsbüro PartG mbB
Prinz-Ludwig-Straße 40 A
85354 Freising (DE)**

(54) **BATTERY STATE DETECTION DEVICE AND PROGRAM**

(57)    A battery system includes a battery module (11) in which battery cells (13) are connected in series, and state of each battery cell is detected by a state detection unit. A battery state detection device (20) includes an acquisition unit, a parameter change amount calculation unit, and an abnormality detection unit. The acquisition unit acquires state detection values of the respective battery cells detected by the state detection unit. The parameter change amount calculation unit uses, as a state parameter of each battery cell, either a state detection value acquired by the acquisition unit or a state calculation value, where the state calculation value is calculated based on the state detection value and indicates the state of the battery cell. The parameter change amount calculation unit also calculates, as a parameter change amount, a change in the state parameter over a predetermined period. The abnormality detection unit sequentially sets each of the battery cells, one by one, as a target cell for abnormality detection, and detects an abnormality of the target cell based on whether a predetermined deviation occurs in the parameter change amount of the target cell relative to the parameter change amount of another of the battery cells.

EP 4 779 753 A1

# FIG. 1

# EP 4 779 753 A1

**Description**

## CROSS REFERENCE TO RELATED APPLICATIONS

This application is based on Japanese Patent Application No. 2023-148760 filed on September 13, 2023, and Japanese Patent Application No. 2024-097399 filed on June 17, 2024, the disclosures of which are incorporated herein by reference.

## TECHNICAL FIELD

The present disclosure relates to a battery state detection device and program.

## BACKGROUND ART

Conventionally, various techniques have been proposed for determining the presence or absence of abnormalities in storage batteries installed in vehicles and the like. For example, in the technique described in Patent Literature 1, in a battery module formed by connecting storage devices with busbars, an instantaneous resistance value of the battery module is measured immediately after the start of constant-current charging. Furthermore, after a certain period has elapsed since the start of constant-current charging, a diffusion resistance value of the battery module is measured. Subsequently, a ratio of the instantaneous resistance value to the diffusion resistance value is calculated, and this ratio is compared with a predetermined threshold. Based on the result of this comparison, the presence or absence of connection abnormalities in the busbar is determined.

## PRIOR ART LITERATURE

### PATENT LITERATURE

Patent Literature 1: JP2015-068821A

## SUMMARY OF THE INVENTION

Thermal runaway is one type of abnormality in storage batteries, and various techniques have also been proposed for detecting thermal runaway. For example, when thermal runaway occurs in a battery, internal short-circuiting in a battery cell arises as an initial stage. Accordingly, techniques have been considered in which changes in internal resistance or terminal voltage of a battery cell are determined by comparison with predetermined thresholds, and based on the result of this determination, it is determined whether an internal short-circuit abnormality has occurred in the battery cell.

However, when an internal short-circuit occurs in a battery cell as a precursor to thermal runaway, fluctuations in diffusion resistance arise gradually over time in the early stages of the internal short-circuit. Therefore, under conditions where voltage fluctuations due to charging and discharging or vehicle noise occur, such as in vehicles, there is concern that it may not be possible to accurately detect internal short-circuits in the battery cell. In particular, when detecting abnormalities using individual cells, there is concern that false detections may occur due to environmental factors such as temperature.

The present disclosure has been made in view of the above issues, and its object is to provide a battery state detection device and program capable of detecting internal short-circuit abnormalities in battery cells, which are precursors to thermal runaway, quickly and with high accuracy.

A battery state detection device of the present disclosure is applicable to a battery system including a battery module that has battery cells connected in series. A state detection unit detects the state of each battery cell. The battery state detection device includes an acquisition unit, a parameter change amount calculation unit, and an abnormality detection unit. The acquisition unit acquires state detection values of the respective battery cells detected by the state detection unit. The parameter change amount calculation unit uses, as a state parameter of each battery cell, either a state detection value acquired by the acquisition unit or a state calculation value, where the state calculation value is calculated based on the state detection value and indicates the state of the battery cell. The parameter change amount calculation unit calculates, as a parameter change amount, a change in the state parameter over a predetermined period. The abnormality detection unit sequentially sets each of the battery cells, one by one, as a target cell for abnormality detection, and detects an abnormality of the target cell based on whether a predetermined deviation occurs in the parameter change amount of the target cell relative to the parameter change amount of another of the battery cells.

According to the above configuration, abnormality detection for each battery cell in the battery module is performed not by detecting abnormalities in individual cells alone, but by relative abnormality detection in comparison with the other battery cells. Therefore, even when voltage fluctuations or noise occur in a current path of the battery module, abnormality detection can be performed while suppressing the influence of such effects. Additionally, in the battery module, false detection caused by environmental conditions such as temperature is reduced. Therefore, even in cases where an internal short circuit occurs as an initial stage of thermal runaway and the variation in diffusion resistance in the battery cell occurs gradually over time, it is possible to promptly identify differences in the parameter change amount between normal and abnormal cells and accurately detect the abnormal cell. As a result, it is possible to detect internal short-circuit abnormalities in the battery cell, which are signs of impending thermal runaway, quickly and with high accuracy.

A battery state detection device of the present disclosure is applicable to a battery system including a battery module that has battery cells connected in series. A state detection unit detects the state of each battery cell. The battery state detection device includes a first abnormality detection unit, a second abnormality detection unit, and a switching execution unit. The first abnormality detection unit detects abnormalities of the respective battery cells by a calculation process with a relatively small computational load based on state detection values of the respective battery cells detected by the state detection unit. The second abnormality detection unit detects abnormalities of the respective battery cells by a calculation process with a relatively large computational load based on state detection values of the respective battery cells detected by the state detection unit. The switching execution unit switches, based on a predetermined switching condition, whether to detect abnormalities of the respective battery cells by the first abnormality detection unit or by the second abnormality detection unit.

According to the above configuration, two types of abnormality determinations can be performed for detecting abnormalities in each battery cell, and these abnormality determinations are switched according to predetermined switching conditions. Here, when the battery cell is used over a long period, situations may arise in which cell abnormalities are more likely to be detected and situations in which they are less likely to be detected. In this case, by switching the abnormality determination processing according to predetermined switching conditions, it is possible to achieve appropriate abnormality detection while reducing excessive computational load.

BRIEF DESCRIPTION OF DRAWINGS

The above and other objects, features and advantages of the present disclosure will become more apparent from the following detailed description made with reference to the accompanying drawings.

FIG. 1 is an overall configuration diagram of a battery system.
FIG. 2 is a diagram for explaining a cell voltage of each battery cell in a battery module.
FIG. 3 is a diagram illustrating an equivalent circuit of the battery cell.
FIG. 4 is a time chart illustrating changes in cell voltage of each battery cell.
FIG. 5 is a flowchart illustrating abnormality detection process for battery cells according to a first embodiment.
FIG. 6 is a flowchart illustrating the abnormality detection process for the battery cells according to the first embodiment.
FIG. 7 is a time chart for specifically explaining the abnormality detection process of the battery cell.
FIG. 8 is a diagram for explaining an overview of cell abnormality detection according to a second embodiment.
FIG. 9 is a flowchart illustrating abnormality detection process for battery cells according to the second embodiment.
FIG. 10 is a flowchart illustrating the abnormality detection process for the battery cells according to the second embodiment.
FIG. 11 is a flowchart illustrating abnormality detection process for battery cells according to a third embodiment.
FIG. 12 is a flowchart illustrating the abnormality detection process for the battery cells according to the third embodiment.
FIG. 13 is a flowchart illustrating the abnormality detection process for the battery cells according to the third embodiment.
FIG. 14 is a flowchart illustrating abnormality detection process for battery cells according to a fourth embodiment.
FIG. 15 is a flowchart illustrating the abnormality detection process for the battery cells according to the fourth embodiment.
FIG. 16 is a flowchart illustrating the abnormality detection process for the battery cells according to the fourth embodiment.
FIG. 17 is a diagram illustrating a configuration of a battery system according to a fifth embodiment.
FIG. 18 is a flowchart illustrating abnormality detection process for battery cells according to a fifth embodiment.
FIG. 19 is a time chart illustrating changes in cell voltage in a battery pack.
FIG. 20 is a flowchart illustrating abnormality detection process for battery cells according to a sixth embodiment.
FIG. 21 is a diagram illustrating a configuration of a battery system according to a seventh embodiment.

FIG. 22 is a flowchart illustrating abnormality detection process for battery cells according to the seventh embodiment.

FIG. 23 is a flowchart illustrating abnormality detection process for battery cells according to an eighth embodiment.

FIG. 24 is a flowchart illustrating abnormality detection process for battery cells in another example.

FIG. 25 is a time chart illustrating changes in cell voltage and cell temperature during internal short-circuit process.

FIG. 26 is a diagram illustrating a configuration of a battery system.

FIG. 27 is a flowchart illustrating abnormality detection process for battery cells in another example.

FIG. 28 is a diagram illustrating voltage-capacity characteristics of a battery cell.

FIG. 29 is a flowchart illustrating abnormality detection process for battery cells in another example.

DETAILED DESCRIPTION

A battery system according to the present embodiment will be described below. In the present embodiment, the battery system mounted on an electric vehicle such as a hybrid vehicle or an electric vehicle will be described with reference to the drawings. This battery system includes a high-voltage battery whose terminal voltage between positive and negative sides reaches several hundred volts. It should be noted that this battery system can also be applied to aerial vehicles such as drones, as well as ships, construction machinery, agricultural machinery, and the like, in addition to electric vehicles.

First Embodiment

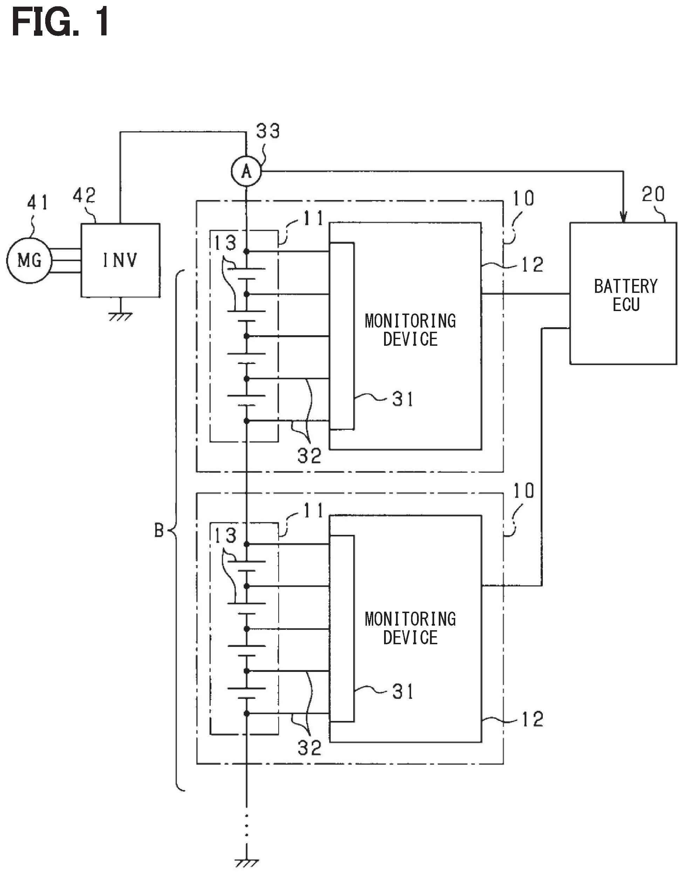

First, with reference to FIG. 1, an overview of the battery system in a vehicle will be described. In FIG. 1, the battery system includes battery units 10 and a battery ECU 20 that centrally manages each of these battery units 10. The battery unit 10 includes a battery module 11 and a monitoring device 12 that monitors the battery module 11. The battery module 11 is configured by connecting battery cells 13 in series. Each battery cell 13 is constituted, for example, by a lithium-ion secondary battery, a nickel-metal hydride secondary battery, or the like. The lithium ion secondary battery is a secondary battery that uses lithium as a charge carrier, and may include not only general lithium ion secondary batteries that use a liquid electrolyte, but also so-called all-solid-state batteries that use a solid electrolyte.

The battery modules 11 of each battery unit 10 are connected in series to constitute a battery pack B. The battery pack B is a high-voltage battery that generates a terminal voltage of several hundred volts. It should be noted that the battery pack B may be configured such that each battery module 11 is connected in parallel, or that each battery module 11 is connected in both series and parallel.

The monitoring device 12 of each battery unit 10 serves as a slave unit, with the battery ECU 20 acting as a master unit. The battery ECU 20 and the monitoring devices 12 are capable of mutually communicating with each other via wired or wireless communication means. The battery ECU 20 is constituted by a microcomputer including a central processing device (i.e., CPU), a read only memory (i.e., ROM), and a random access memory (i.e., RAM). The battery ECU 20 executes various processes related to battery control based on programs stored in the ROM. The battery ECU 20 executes control related to charging or discharging of the battery pack B, for example. The monitoring device 12 acquires information related to the battery module 11 in response to commands from the battery ECU 20, and transmits that information to the battery ECU 20. The monitoring device 12 may acquire information related to the battery module 11 at predetermined intervals. It should be noted that the monitoring device 12 is also referred to as a satellite monitoring device. In the present embodiment, the battery ECU 20 corresponds to a battery state detection device.

The monitoring device 12 has a voltage sensor 31 that detects a terminal-to-terminal voltage of each battery cell 13. Specifically, in the battery module 11, an electrical path 32 is connected to both ends of each battery cell 13, and the voltage sensor 31 is connected to this electrical path 32. The voltage sensor 31 corresponds to a state detection unit, and the terminal-to-terminal voltage (cell voltage) detected by the voltage sensor 31 corresponds to a state detection value. Furthermore, a current sensor 33 for detecting an electric current flowing through each battery cell 13 is provided in the cell series path of the battery module 11.

A rotary electric machine unit, which serves as an electrical load driven by power supplied from the battery pack B, is connected to the battery pack B. The rotary electric machine unit includes a rotary electric machine 41 and an inverter 42, which serves as a power converter for supplying phase current to the rotary electric machine 41. The rotary electric machine 41 serves as a main power unit of the vehicle and is capable of transmitting power to drive wheels (not shown). The rotary electric machine 41 is, for example, a three-phase AC motor, and in the inverter 42, the current supplied to each phase winding is controlled by switching on and off the upper and lower arm switches (semiconductor switching elements) provided for each phase winding.

When thermal runaway occurs in the battery module 11, a process leading up to thermal runaway begins with an internal short circuit in the battery cell 13 at the initial stage, followed sequentially by gas generation, cell case deformation, and ignition. In this case, it is desirable to detect an internal short circuit in the battery cell 13 in order to quickly identify early signs of thermal runaway. In the present embodiment, an internal short-circuit abnormality is detected based on a change amount of change in the cell voltage of each battery cell 13.

The following describes changes in the cell voltage of battery cell 13 resulting from an internal short circuit.

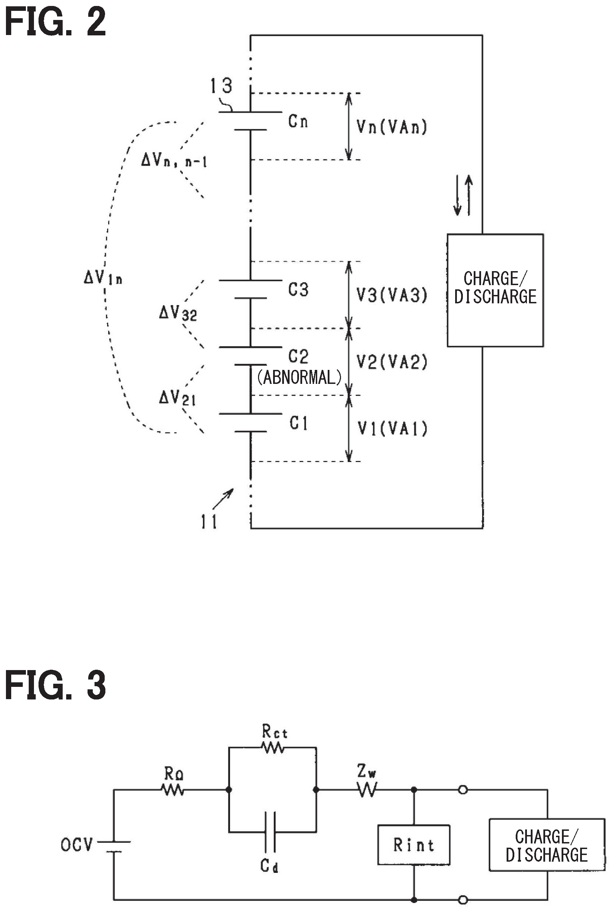

FIG. 2 is a diagram for explaining the cell voltage of each battery cell 13 in the battery module 11. In FIG. 2, n battery cells 13 are connected in series in the battery module 11, and each battery cell 13 is referred to, in order from a lower potential side, as a first cell C1, a second cell C2, a third cell C3, ..., and a n-th cell Cn. The terminal voltages of the cells C1 to Cn are referred to as cell voltages V1 to Vn, respectively. The change amount in each cell voltage V1 to Vn over a predetermined period is referred to as a voltage variation VA1 to VAn. For each adjacent pair of battery cells 13 in the series path, a difference between their voltage variations VA1 to VAn is defined as voltage difference values $\Delta V21$, $\Delta V32$, ..., $\Delta Vn,n-1$.

The voltage difference values $\Delta V21$, $\Delta V32$, ..., $\Delta Vn,n-1$ are calculated by subtracting, in ascending or descending order of the cell series sequence, the voltage variation VA of one battery cell 13 from that of its adjacent cell in the series path. Here, the voltage difference value is obtained by subtracting the voltage variation VA of the lower potential battery cell 13 from the voltage variation VA of the higher potential battery cell 13. For example, the voltage difference value $\Delta V21$ is obtained by subtracting the voltage variation VA1 of the first cell C1 from the voltage variation VA2 of the second cell C2. Similarly, the voltage difference value $\Delta V32$ is obtained by subtracting the voltage variation VA2 of the second cell C2 from the voltage variation VA3 of the third cell C3. It should be noted that the voltage difference value $\Delta V$ between battery cells 13 may be any value that represents a difference in voltage variation VA between two of the n battery cells 13. For example, the voltage difference value $\Delta V31$ is obtained by subtracting the voltage variation VA1 of the first cell C1 from the voltage variation VA3 of the third cell C3, and the voltage difference value $\Delta V1n$ is obtained by subtracting the voltage variation VAn of the nth cell Cn from the voltage variation VA1 of the first cell C1.

FIG. 3 is a diagram illustrating an equivalent circuit 13 of the battery cell. The battery cell 13 is configured by connecting, in series, an electromotive force OCV, a solution resistance $R\Omega$, a parallel circuit of a charge transfer resistance Rct and an interface capacitance Cd, and a diffusion resistance Zw. In the battery cell 13, when an internal short circuit occurs, a path between the positive electrode and the negative electrode is short-circuited by an internal short-circuit resistance Rint, causing a short-circuit current to flow within the cell.

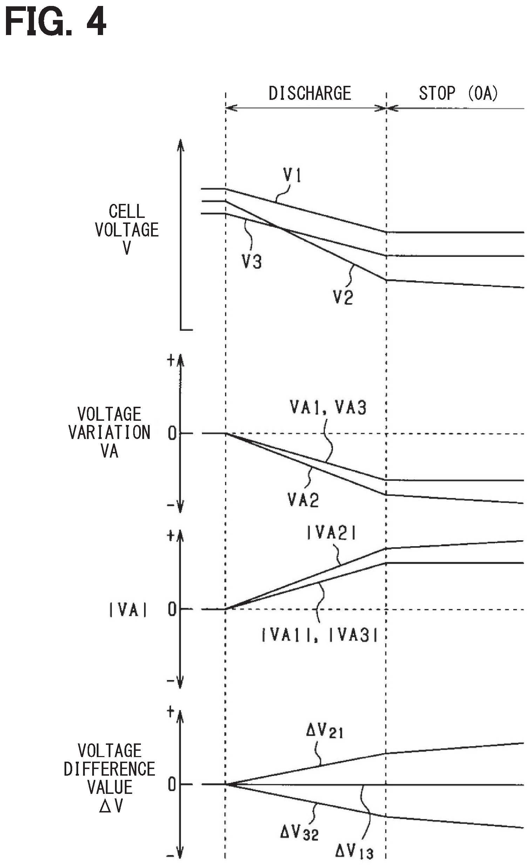

FIG. 4 is a timing chart showing changes in the cell voltages of the battery cells 13 in the battery module 11. Here, as examples, voltage changes of the first cell C1 to the third cell C3 among the n battery cells 13 shown in FIG. 2 are illustrated. Assuming that an internal short-circuit abnormality has occurred in the second cell C2, changes in the cell voltages of each battery cell 13 and changes in the voltage differential values between the battery cells 13 will be described.

When the internal short-circuit abnormality occurs in the second cell C2, a short-circuit current flows inside the cell of the second cell C2. Therefore, when the cell voltages of each battery cell 13 decrease during discharge of the battery module 11, the rate of voltage drop per unit time of the cell voltage V2 of the second cell C2 (i.e., the slope of the voltage change) becomes greater than that of the cell voltages V1 and V3 of the first cell C1 and the third cell C3. Here, when an amount of voltage change from the start of discharge for each cell C1 to C3, with the start of discharge as the reference (initial value), is denoted as VA1 to VA3, the voltage variations VA1 to VA3 all gradually increase in the negative direction over time. However, the magnitude of the change for the second cell C2 differs from that of the other cells C1 and C3. In terms of absolute values, a relationship among the voltage variations VA1 to VA3 is such that $|VA2| > |VA1|$ and $|VA2| > |VA3|$.

Additionally, a voltage difference value $\Delta V21$, which is a difference between the absolute values of the voltage variations VA1 and VA2 for cells C1 and C2, gradually increases in the positive direction over time. Conversely, a voltage difference value $\Delta V32$, which is a difference between the absolute values of the voltage variations VA2 and VA3 for cells C2 and C3, gradually increases in the negative direction over time. It should be noted that, for cells C1 and C3, a voltage difference value $\Delta V13$ remains substantially constant (approximately zero) over time.

In FIG. 4, a period is shown during which the energization of the battery module 11 is stopped after discharge has been performed in the battery module 11. During the period when energization is stopped, the cell voltages V1 and V3 of cells C1 and C3 remain constant, whereas in the second cell C2, the cell voltage V2 decreases due to the flow of short-circuit current. Therefore, even after the completion of discharge, the voltage difference value $\Delta V21$ increases in the positive direction, and the voltage difference value $\Delta V32$ increases in the negative direction.

In the present embodiment, attention is focused on the voltage changes of each battery cell 13 as described above, and internal short-circuit anomalies of the battery cells 13 are detected based on these changes. In summary, the voltage variation VA of each battery cell 13 is calculated, and each of the battery cells 13 is sequentially set as a target cell for anomaly detection. For each target cell, it is determined whether a predetermined deviation in the voltage variation VA exists with respect to the other battery cells 13. Based on this determination, anomalies in the target cell are detected.

In the present embodiment, in particular, for a target cell, differences in voltage variation VA between the target cell and two or more different battery cells 13 are calculated as voltage difference values $\Delta V$. Based on these voltage difference values $\Delta V$, it is determined whether a predetermined deviation has occurred in the target cell with respect to the other battery cells 13. Based on the result of this determination, the anomalies in the target cell are detected. It should be noted that the cell voltage V, as a state detection value, corresponds to a state parameter, the voltage variation VA corresponds to a parameter change amount, and the voltage difference value ΔV corresponds to a change amount difference value. An anomaly detection process in the present embodiment will be described in detail below.

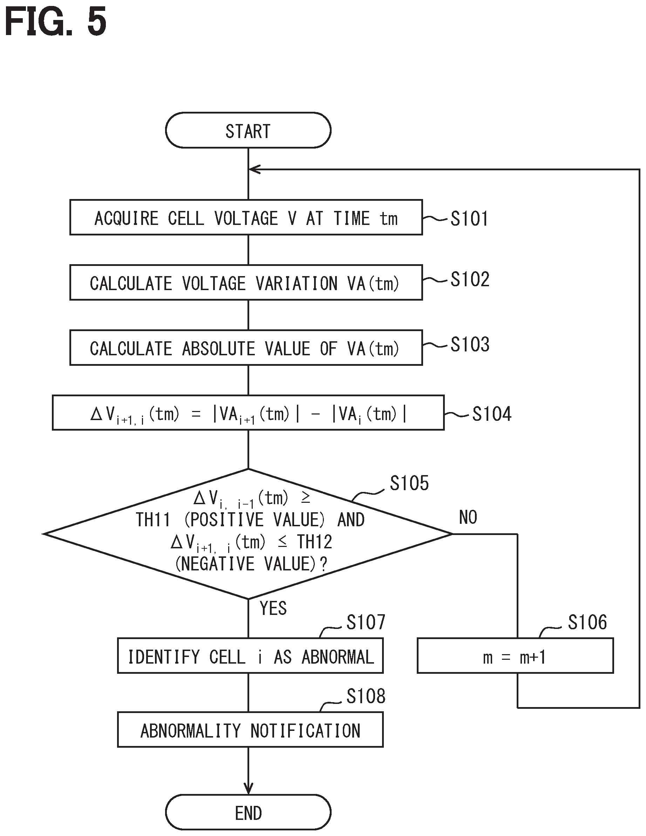

FIG. 5 is a flowchart illustrating the procedure for the anomaly detection processing of the battery cells 13, and this process is executed by the battery ECU 20. The battery ECU 20 executes the anomaly detection for the battery cells 13 in each battery module 11.

In step S101, a cell voltage V(tm) of each battery cell 13 at time point tm is acquired from the monitoring device 12. The time point tm is a point in time that occurs at a predetermined time interval, and the cell voltage V of each battery cell 13 is acquired at this predetermined interval. The interval is, for example, on the order of several tens to several hundreds of milliseconds, for example 10 to 100 milliseconds. However, the interval may also be several seconds, several minutes, or several hours.

In step S102, for each battery cell 13, the voltage variation VA(tm), which is the change amount in cell voltage V(tm) from the initial value (voltage initial value), is calculated (VA(tm) = V(tm) - initial value). In step S103, the absolute value of the voltage variation VA(tm) is calculated. The voltage variation VA(tm) is the change amount in the cell voltage V(tm) from the initial value over a predetermined period, with the period from the initial value to the present time being defined as the predetermined period. The initial value may be any value set for each battery cell 13 at an arbitrary timing, and once set, it is maintained until the next setting timing occurs. The initial value may be reset at predetermined periodic intervals (for example, every few days to several months), or it may be reset according to a predetermined travel distance of the vehicle, or according to a predetermined number of vehicle starts, or according to the timing of switching between discharge and charge of the battery module 11. In addition, when an equalization process for equalizing the cell voltages of each battery cell 13 is performed in the battery module 11, the initial value may be reset based on the execution of this equalization process. It should be noted that step S101 corresponds to an acquisition unit, and step S102 corresponds to a parameter variation calculation unit.

Subsequently, in Step S104, for all battery cells 13, the difference in the absolute values of the voltage variations VA(tm) between each pair of adjacent battery cells 13 in the series path is calculated as the voltage difference value $\Delta V_{i+1,i}(tm)$. The voltage difference value $\Delta V_{i+1,i}(tm)$ may be calculated using the following equation (1).

$$\Delta V_{i+1,i}(tm) = | VA_{i+1}(tm) | - | VA_i(tm) | \ldots(1)$$

It should be noted that the subscripts i+1 and i indicate the cell numbers from 1 to n. The voltage difference value $\Delta V_{i+1,i}(tm)$ is calculated for all combinations of every pair of adjacent cells in the battery module 11.

When each battery cell 13 in the battery module 11 is individually designated as the target cell for the abnormality detection, the voltage difference value $\Delta V_{i,i-1}(tm)$ between the target cell (cell Ci) and the first adjacent cell (cell Ci-1) on the negative electrode side of the target cell is calculated, and the voltage difference value $\Delta V_{i+1,i}(tm)$ between the target cell (cell Ci) and the second adjacent cell (cell Ci+1) on the positive electrode side of the target cell is also calculated. Each of these voltage difference values, $\Delta V_{i,i-1}(tm)$ and $\Delta V_{i+1,i}(tm)$, is a value obtained by subtracting the absolute value of the voltage variation VA(tm) of each battery cell 13 in descending order of the cell series arrangement. It is also possible to calculate each voltage difference value $\Delta V(tm)$ by subtraction in ascending order of the cell series arrangement. The voltage difference value $\Delta V_{i,i-1}(tm)$ between the target cell and the first adjacent cell on the negative electrode side corresponds to a first difference value, and the voltage difference value $\Delta V_{i+1,i}(tm)$ between the target cell and the second adjacent cell on the positive electrode side corresponds to a second difference value. Furthermore, the first adjacent cell and the second adjacent cell are battery cells 13 different from the target cell, and they also correspond to a first non-target cell and a second non-target cell, respectively. Step S104 corresponds to a difference value calculation unit.

Subsequently, in step S105, each battery cell 13 (cells C1 to Cn) is sequentially designated as the target cell, and for each target cell, the voltage difference values $\Delta V_{i,i-1}(tm)$ and $\Delta V_{i+1,i}(tm)$ are compared with a predetermined threshold value. More specifically, it is determined whether the voltage difference value $\Delta V_{i,i-1}(tm)$, calculated for the combination of the target cell and the first adjacent cell on the negative electrode side, is equal to or greater than a predetermined positive-side threshold TH11, and whether the voltage difference value $\Delta V_{i+1,i}(tm)$, calculated for the combination of the target cell and the second adjacent cell on the positive electrode side, is equal to or less than a predetermined negative-side threshold TH12.

The positive-side threshold TH11 is a threshold defined by a positive value (TH11 > 0), and the negative-side threshold TH12 is a threshold defined by a negative value (TH12 < 0). Each threshold value, TH11 and TH12, has an identical absolute value. However, the absolute values of the thresholds TH11 and TH12 may also be different.

A specific determination method in step S105 may be chosen arbitrarily. Essentially, it is sufficient as long as, for the target cell Ci, the polarities of the voltage difference values $\Delta V_{i,i-1}(tm)$ and $\Delta V_{i+1,i}(tm)$ are opposite (one positive, one negative), and the absolute values of the voltage difference values $\Delta V_{i,i-1}(tm)$ and $\Delta V_{i+1,i}(tm)$ are each determined to be greater than or equal to their respective predetermined thresholds.

When, for all battery cells 13, there is no case where the voltage difference value $\Delta V_{i,i-1}(tm)$ is equal to or greater than the positive-side threshold TH11, and the voltage difference value $\Delta V_{i+1,i}(tm)$ is equal to or less than the negative-side threshold TH12, then step S105 is negated, a value "m" is incremented by one in step S106, and the process returns to step S101. Further, when any of the battery cells 13 among all the battery cells 13 meets a condition that the voltage difference value $\Delta V_{i,i-1}(tm)$ is equal to or greater than the positive-side threshold TH11 and the voltage difference value $\Delta V_{i+1,i}(tm)$ is equal to or less than the negative-side threshold TH12, then step S105 is affirmed, and the process proceeds to step S107.

At this time, when an internal short-circuit abnormality has not occurred in the battery cell 13 serving as the target cell, the condition in step S105 will not be satisfied for that battery cell 13. Conversely, when an internal short-circuit abnormality has occurred in the target battery cell 13, the condition in step S105 will be satisfied for that battery cell 13.

In step S107, it is determined that an abnormality has occurred in the battery cell 13 for which the condition in step S105 has been satisfied. In other words, it is determined that, among the battery cells 13, a predetermined deviation has occurred in the voltage variation VA(tm) of at least one battery cell 13 (the target cell) relative to the other battery cells 13. Subsequently, in step S108, notification of the occurrence of an abnormality is provided. At this time, for example, it is preferable to notify a vehicle user of the occurrence of an abnormality by turning on an abnormality warning lamp. It is also preferable to store diagnostic information indicating the occurrence of the abnormality in memory.

In the battery module 11, the first cell C1 with the lowest potential and the nth cell Cn with the highest potential each have an adjacent cell only on one side in the series cell path. Therefore, for each of these cells C1 and Cn, it is preferable to modify the processing in steps S104 and S105 as follows.

When the first cell C1 is designated as the target cell, the battery ECU 20 calculates two types of voltage difference values $\Delta V(tm)$ by combining the first cell C1 with each of the two battery cells 13 located on its positive electrode side. More specifically, the absolute value of the difference in voltage variation VA(tm) between the first cell C1 and the nth cell Cn is calculated as the voltage difference value $\Delta V_{1n}(tm)$, and the absolute value of the difference in voltage variation VA(tm) between the first cell C1 and the second cell C2 is calculated as the voltage difference value $\Delta V_{21}(tm)$. Then, it is determined whether the voltage difference value $\Delta V_{1n}(tm)$ is equal to or greater than the positive-side threshold TH11, and whether the voltage difference value $\Delta V_{21}(tm)$ is equal to or less than the negative-side threshold TH12. It should be noted that the voltage difference value $\Delta V_{1n}(tm)$ is calculated with the cell order of subtraction reversed compared to the voltage difference value $\Delta V_{21}(tm)$, and is obtained by subtracting the voltage variation VA_n of the nth cell Cn on the high potential side from the voltage variation VA_1 of the first cell C1 on the low potential side in the battery module 11. When the first cell C1 is an abnormal cell, the voltage difference value $\Delta V_{1n}(tm)$ will be calculated as a positive value. Then, when the voltage difference value $\Delta V_{1n}(tm)$ is equal to or greater than the positive-side threshold TH11 and the voltage difference value $\Delta V_{21}(tm)$ is equal to or less than the negative-side threshold TH12, it is determined that the first cell C1 is abnormal.

Here, the second cell C2 and the nth cell Cn correspond to the first non-target cell and the second non-target cell, respectively. In addition, it is also possible to calculate the voltage difference value $\Delta V(tm)$ using other combinations, such as designating the second cell C2 and the third cell C3 as the first non-target cell and the second non-target cell, respectively.

Furthermore, when the nth cell Cn is designated as the target cell, the battery ECU 20 combines the nth cell Cn with each of the two battery cells 13 on its negative electrode side, respectively, and calculates two types of voltage difference values $\Delta V(tm)$. More specifically, a difference in absolute values of the voltage variation VA(tm) between the nth cell Cn and the (n-1)th cell Cn-1 is calculated as the voltage difference value $\Delta V_{n,n-1}(tm)$, and a difference in absolute values of the voltage variation VA(tm) between the first cell C1 and the nth cell Cn is calculated as the voltage difference value $\Delta V_{1n}(tm)$. Then, it is determined whether the voltage difference value $\Delta V_{n,n-1}(tm)$ is equal to or greater than the positive-side threshold TH11, and whether the voltage difference value $\Delta V_{1n}(tm)$ is equal to or less than the negative-side threshold TH12. When the voltage difference value $\Delta V_{n,n-1}(tm)$ is equal to or greater than the positive-side threshold TH11, and the voltage difference value $\Delta V_{1n}(tm)$ is equal to or less than the negative-side threshold TH12, it is determined that the nth cell Cn is abnormal.

Here, the first cell C1 and the (n-1)th cell Cn-1 correspond to the first non-target cell and the second non-target cell, respectively. Additionally, it is also possible to calculate the voltage difference value $\Delta V(tm)$ using other combinations, such as designating the (n-2)th cell Cn-2 and the (n-1)th cell Cn-1 as the first non-target cell and the second non-target cell, respectively.

For all battery cells 13 in the battery module 11, it is also possible to combine each target cell with either two battery cells 13 on one side (non-target cells), calculate two types of voltage difference values $\Delta V(tm)$, and detect abnormalities in the target cell based on these two types of voltage difference values $\Delta V(tm)$. In short, as long as a configuration is such that, for the target cell, the difference in the absolute values of the voltage variations VA(tm) with two or more different battery cells 13 is calculated as the voltage difference value $\Delta V(tm)$, and this voltage difference value $\Delta V(tm)$ is used as a parameter for abnormality determination, it is sufficient.

The combinations of battery cells 13 used to calculate the voltage difference value $\Delta V(tm)$ may be such that, for the target battery cell 13, both an adjacent cell and a non-adjacent cell are combined, or two non-adjacent battery cells 13 are combined with the target cell. For example, it is also possible to configure the calculation of the voltage difference value ΔV(tm) by combining the target cell with two battery cells 13 that are spaced one cell apart, or with two battery cells 13 that are spaced two cells apart. When the target cell is the cell C3, it is preferable to calculate the voltage difference value ΔV(tm) by combining the cell C3 with the cell C1, and also calculate the voltage difference value ΔV(tm) by combining the cell C3 with the cell C5.

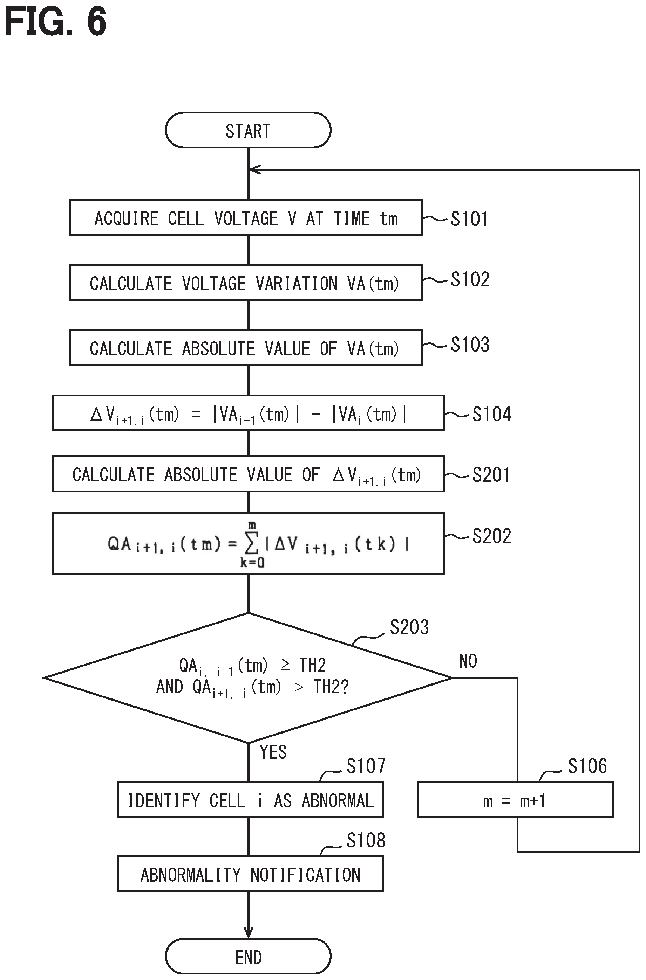

It is also possible to modify the abnormality detection processing of FIG. 5 as shown in FIG. 6. The processing in FIG. 6 is a modification of part of the processing in FIG. 5, with steps S201 to S203 being different from those in FIG. 5.

In FIG. 6, as described above, in steps S101 to S103, the cell voltage V(tm) of each battery cell 13 at time point tm is acquired, the voltage variation VA(tm) from the initial value is calculated, and the absolute value of the voltage variation VA(tm) is calculated. Further, in step S104, a difference between the absolute values of the voltage variations VA(tm) of two adjacent cells in the series path is calculated as the voltage difference value ΔVi+1,i(tm).

Thereafter, in step S201, the absolute value of the voltage difference value ΔVi+1,i(tm) is calculated, and in the subsequent step S202, the absolute values of the voltage difference values ΔVi+1,i(tm) calculated for each time point tm are accumulated to calculate the difference accumulation value QAi+1,i(tm). At this time, at a predetermined cycle, the absolute value of the voltage difference value ΔVi,i-1(tm) between the target cell and the first adjacent cell (first non-target cell) is accumulated, and the difference accumulation value QAi,i-1(tm) is calculated. Also, at the predetermined cycle, the absolute value of the voltage difference ΔVi+1,i(tm) between the target cell and the second adjacent cell (second non-target cell) is accumulated, and the difference accumulation value QAi+1,i(tm) is calculated. It should be noted that the difference accumulation value QAi,i-1(tm) corresponds to a first difference accumulation value, and the difference accumulation value QAi+1,i(tm) corresponds to a second difference accumulation value.

Thereafter, in step S203, each battery cell 13 (cells C1 to Cn) is sequentially set as the target cell, and for each target cell, the difference accumulation values QAi,i-1(tm) and QAi+1,i(tm) are compared with a predetermined threshold value. More specifically, it is determined whether the difference accumulation value QAi,i-1(tm), calculated for the combination of the target cell and the first adjacent cell on the negative electrode side, is equal to or greater than the predetermined threshold TH2, and also whether the difference accumulation value QAi+1,i(tm), calculated for the combination of the target cell and the second adjacent cell on the positive electrode side, is equal to or greater than the threshold TH2.

Then, when none of the battery cells 13 meet a condition that both the difference accumulation value QAi,i-1(tm) is equal to or greater than the threshold TH2 and the difference accumulation value QAi+1,i(tm) is equal to or greater than the threshold TH2, step S203 is negated, the value "m" is incremented by one in step S106, and the process returns to step S101. In addition, when any of the battery cells 13 among all the battery cells 13 meet the condition that both the difference accumulation value QAi,i-1(tm) is equal to or greater than the threshold TH2 and the difference accumulation value QAi+1,i(tm) is equal to or greater than the threshold TH2, step S203 is affirmed and the process proceeds to step S107.

In step S107, it is determined that an abnormality has occurred in the battery cell 13 for which the condition in step S203 has been met. Subsequently, in step S108, notification of the occurrence of an abnormality is provided.

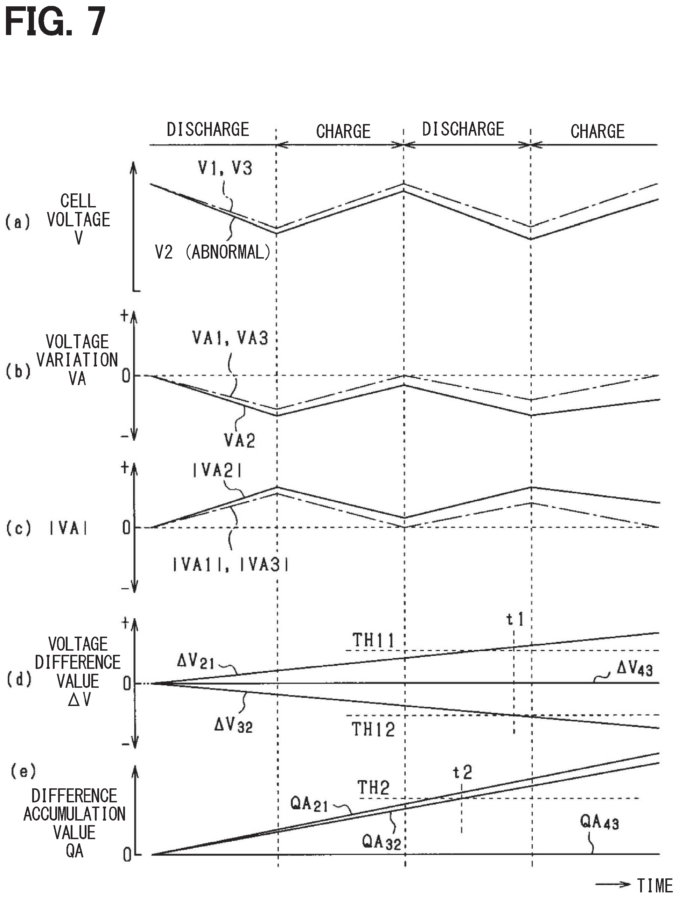

FIG. 7 is a time chart for specifically explaining the abnormality detection process of the battery cell 13. In FIG. 7, the changes over time of each parameter shown in (a) to (e) are illustrated. Here, it is assumed that discharging and charging are repeatedly performed in the battery module 11. In addition, three battery cells 13 (cells C1 to C3) are shown, with one of them (here, the second cell C2) designated as an abnormal cell in which internal short-circuit abnormality has occurred. The changes in cell voltage and other parameters over time are illustrated for both the normal cells (except for the second cell) and the abnormal cell. In FIG. 7, the cell voltage V and voltage variation VA of the normal cells are shown by a dash-dot-dash line, while those of the abnormal cell are shown by a solid line.

In FIG. 7, during a discharge period, the cell voltage V of each battery cell 13 decreases, and during a charging period, the cell voltage V of each battery cell 13 increases. At that time, the voltage variation VA differs between the normal cells and the abnormal cell. Therefore, for the abnormal cell (cell C2), the difference in voltage variation VA between the abnormal cell and the adjacent cell on the negative electrode side (voltage difference value ΔV21), and the difference in voltage variation VA between the abnormal cell and the adjacent cell on the positive electrode side (voltage difference value ΔV32), each take on values with opposite polarities. Furthermore, each of these differences is larger than the differences calculated between normal cells that do not include the abnormal cell. In addition, as the internal short circuit in the abnormal cell gradually progresses, the voltage difference values ΔV21 and ΔV32 between the normal cell and the abnormal cell gradually increase.

In FIG. 7, at timing t1, the voltage difference value ΔV21 is equal to or greater than the positive threshold TH11, and the voltage difference value ΔV32 is equal to or less than the negative threshold TH12. As a result, it is regarded that a predetermined deviation in the voltage variation VA has occurred in the second cell C2 compared to the other battery cells 13, and the second cell C2 is determined to be abnormal. In this case, when the internal short circuit occurs in the battery cell 13, fluctuations in the diffusion resistance occur gradually, and voltage variation in the abnormal cell becomes minimal. However, by performing relative comparison between cells, it is possible to detect differences between abnormal and normal cells at an early stage.

It should be noted that, as a comparative example, the voltage difference value ΔV43 is shown in FIG. 7. The voltage difference value ΔV43 is a difference between the voltage variations VA3 and VA4 of cells C3 and C4, both of which are normal cells, and it does not exceed the thresholds TH11 or TH12. Although not shown in figures, the changes in the cell voltage V and the voltage variation VA of cell C4 are the same as those of cells C1 and C3.

In addition, by accumulating the voltage difference values $\Delta V_{i+1,i}$ for each battery cell 13, the differential accumulated value $QA_{i+1,i}$ is calculated. As explained with reference to FIG. 6, when the differential accumulated value $QA_{i+1,i}$ is used as a parameter for abnormality determination, both differential accumulated values QA21 and QA32 exceed the threshold TH2 at timing t2, whereby the second cell C2 is determined to be abnormal. The differential accumulated value $QA_{i+1,i}$ is continuously calculated over a period that includes both charging/discharging and non-energized states of the battery module 11, and by performing the abnormality detection based on the differential accumulated value $QA_{i+1,i}$, the accuracy of abnormality detection can be improved. Even when an equalization process for equalizing the cell voltages of each battery cell 13 is carried out in the battery module 11, it is possible to cumulatively grasp the differences in voltage variations VA between the battery cells 13, thereby enabling earlier and more accurate detection of signs of abnormality.

It should be noted that, as a comparative example, the differential accumulated value QA43 is shown in FIG. 7. The differential accumulated value QA43 is an accumulated value obtained by integrating the voltage difference ΔV43 between cells C3 and C4, both of which are normal cells, and does not exceed the threshold TH2.

It is possible to obtain the following excellent effects according to the present embodiment described in detail.

In the battery module 11, the abnormality detection for each battery cell 13 is performed not as detection of abnormalities in individual cells, but as relative abnormality detection in comparison with other battery cells 13. Therefore, even when voltage fluctuations or noise occur in the current path of the battery module 11, the abnormality detection can still be performed while reducing the influence of such effects. Additionally, in the battery module 11, false detection caused by environmental conditions such as temperature is reduced. Therefore, even in cases where an internal short circuit occurs as an initial stage of thermal runaway and the variation in diffusion resistance in the battery cell 13 occurs gradually over time, it is possible to promptly identify differences in the voltage variation VA(tm) between normal and abnormal cells and accurately detect the abnormal cell. As a result, it is possible to detect internal short-circuit abnormalities in the battery cell 13, which are signs of impending thermal runaway, quickly and with high accuracy.

For the target cell of the battery module 11, the differences in voltage variations VA(tm) with two or more different battery cells 13 are each calculated as voltage difference values ΔV(tm), and based on these voltage difference values ΔV(tm), it is determined whether the predetermined deviation in the voltage variation VA(tm) has occurred in the target cell relative to the other battery cells 13. In this case, when an abnormal cell is included among the battery cells 13 of the battery module 11, a difference will arise between the voltage difference value ΔV(tm) calculated from the voltage variations VA(tm) of two normal cells and the voltage difference value ΔV(tm) calculated from the voltage variations VA(tm) of two cells that include an abnormal cell. Therefore, it is possible to accurately detect abnormalities in the target cell.

For the target cell Ci, the abnormality detection is performed based on the conditions that the polarities of the voltage difference values $\Delta V_{i,i-1}(tm)$ and $\Delta V_{i+1,i}(tm)$ are opposite to each other, and that the absolute values of the voltage difference values $\Delta V_{i,i-1}(tm)$ and $\Delta V_{i+1,i}(tm)$ are each greater than or equal to a respective threshold. As a result, it is possible to properly detect abnormal cells while taking into account the differences in voltage changes between normal cells and abnormal cells.

In an abnormal cell where an internal short circuit has occurred, the voltage variation VA(tm) becomes larger than the voltage variation VA(tm) of a normal cell, and this condition continues throughout the charging and discharging of the battery module 11. Therefore, by continuously monitoring the voltage difference value ΔV(tm) for each battery cell 13, the accuracy of the internal short circuit detection can be improved. Regarding this, by using the difference integration value $QA_{i+1,i}(tm)$, which is the accumulated value of the voltage difference values ΔV(tm) calculated for each battery cell 13, as a parameter for the abnormality determination, the accuracy of abnormality detection can be improved.

The following describes other embodiments that differ from the above first embodiment, focusing on the differences from the first embodiment.

Second Embodiment

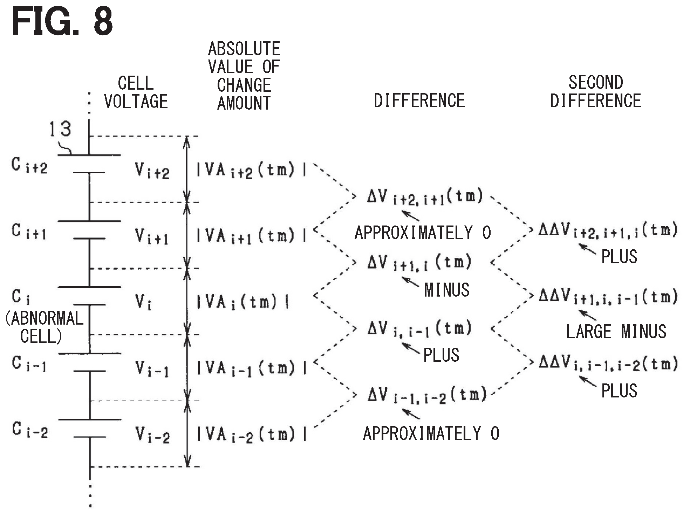

Here, first, an overview of cell abnormality detection in the present embodiment will be described with reference to FIG. 8. In FIG. 8, five battery cells 13 (cells Ci-2, Ci-1, Ci, Ci+1, Ci+2) are shown in a battery module 11, and for each cell Ci-2 to Ci+2, the amount of voltage change from the initial value during charging and discharging is VAi-2(tm) to VAi+2(tm). Furthermore, for each pair of adjacent battery cells 13 in the series path, the voltage difference value ΔV(tm), which is a difference in the absolute values of the voltage variations VA(tm), is, in order from the lower potential side, ΔVi-1,i-2(tm), ΔVi,i-1(tm), ΔVi+1,i(tm), and ΔVi+2,i+1(tm). In addition, the second difference value ΔΔV(tm), which is a difference of the voltage difference values ΔV(tm), is, in order from the lower potential side, ΔΔVi,i-1,i-2(tm), ΔΔVi+1,i,i-1(tm), and ΔΔVi+2,i+1,i(tm). The second difference value ΔΔVi+1,i,i-1(tm) is calculated based on the voltage variations VAi-1(tm), VAi(tm), and VAi+1(tm) of each cell in three consecutive battery cells 13 connected in series.

In this case, when "cell Ci" among the above five cells Ci-2 to Ci+2 is an abnormal cell, the voltage variation VAi(tm) of cell Ci will have a larger negative value compared to the voltage variations VA(tm) of the other cells. Therefore, among the voltage difference values ΔV(tm), which are differences in the absolute values of the voltage variations VA(tm) for each pair of cells, the voltage difference value ΔVi,i-1(tm) between the abnormal cell (cell Ci) and its adjacent cell on the negative side becomes a positive value, while the voltage difference value ΔVi+1,i(tm) between the abnormal cell (cell Ci) and its adjacent cell on the positive side becomes a negative value. The other voltage difference values, ΔVi-1,i-2(tm) and ΔVi+2,i+1(tm), are approximately zero.

Furthermore, among the second difference values ΔΔV(tm), ΔΔVi+1,i,i-1(tm) is obtained by subtracting the positive value ΔVi,i-1(tm) from the negative value ΔVi+1,i(tm). Therefore, the second difference value ΔΔVi+1,i,i-1(tm) becomes an extremely large negative value, resulting in a conspicuous difference compared to the other second difference values ΔΔV(tm). In other words, the second difference value ΔΔVi+1,i,i-1(tm) serves as a clear indicator of the deviation in the voltage variation VAi(tm) at the abnormal cell. In the present embodiment, by using the second difference value ΔΔV(tm) as a parameter for the abnormality determination, abnormal cells can be accurately detected.

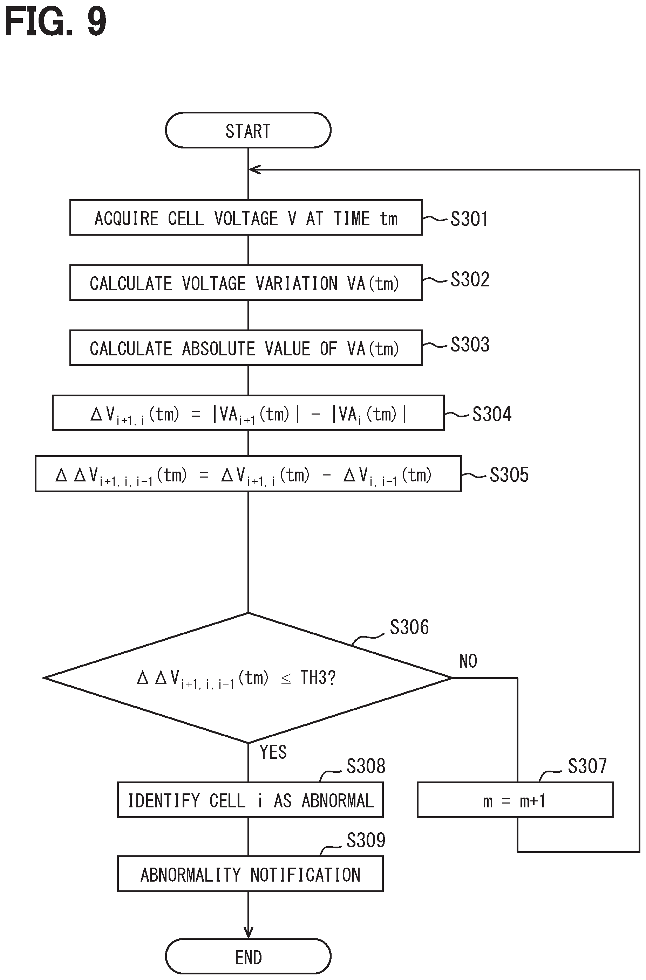

FIG. 9 is a flowchart illustrating the procedure for the anomaly detection processing of the battery cells 13 of the present embodiment, and this process is executed by the battery ECU 20.

In FIG. 9, at step S301, the cell voltage V(tm) of each battery cell 13 at time point tm is acquired. In step S302, for each battery cell 13, the voltage variation VA(tm), which is the change in cell voltage from the initial value, is calculated. In the subsequent step S303, the absolute value of the voltage variation VA(tm) is calculated. Furthermore, in step S304, a difference between the absolute values of the voltage variations VA(tm) of two adjacent battery cells 13 in the series path is calculated as the voltage difference value ΔVi+1,i(tm). It should be noted that steps S301 to S304 are processes similar to steps S101 to S104 in FIG. 5.

Subsequently, in step S305, a difference between two adjacent voltage difference values, ΔVi+1,i(tm) and ΔVi,i-1(tm), in the series arrangement of battery cells 13 is calculated as the second-order difference value ΔΔVi+1,i,i-1(tm). The second-order difference value ΔΔVi+1,i,i-1(tm) may be calculated using the following equation (2).

$$\Delta\Delta Vi+1,i,i-1(tm) = \Delta Vi+1,i(tm) - \Delta Vi,i-1(tm) \ldots(2)$$

The second-order difference value ΔΔVi+1,i,i-1(tm) is calculated for all combinations of three consecutive battery cells 13 in series within the battery module 11.

Subsequently, in step S306, it is determined whether the second-order difference value ΔΔVi+1,i,i-1(tm) is equal to or less than a predetermined negative threshold TH3. Then, when the second-order difference value ΔΔVi+1,i,i-1(tm) is not equal to or less than the negative threshold TH3 for all battery cells 13, step S306 is negated, a value "m" is incremented by 1 in step S307, and the process returns to step S301. Furthermore, when the second-order difference value ΔΔVi+1,i,i-1(tm) becomes equal to or less than the negative threshold TH3 for any of the battery cells 13 among all the battery cells 13, step S306 is affirmed, and the process proceeds to step S308.

In step S308, it is determined that an abnormality has occurred in the battery cell 13 for which the condition in step S306 has been satisfied. In other words, it is determined that a predetermined deviation has occurred in the voltage variation VA(tm) of the target cell relative to the other battery cells 13. Thereafter, in step S309, notification of the occurrence of an abnormality is performed.

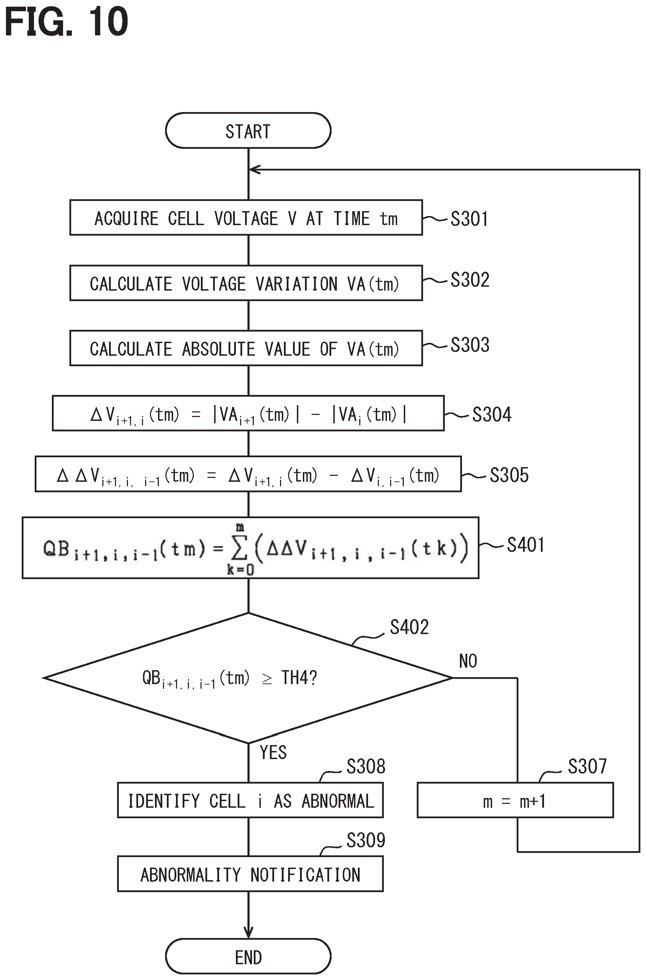

The abnormality detection process shown in FIG. 9 can also be modified as shown in FIG. 10. The process in FIG. 10 is a modification of part of the process in FIG. 9, and steps S401 to S402 involve different processing compared to FIG. 9.

In FIG. 10, as described above, in steps S301 to S304, the voltage difference value ΔVi+1,i(tm) is calculated for each time point tm, and in step S305, the second difference value ΔΔVi+1,i,i-1(tm) is calculated.

Thereafter, in step S401, the second difference values ΔΔVi+1,i,i-1(tm) calculated for each time point tm are accumulated to compute the second difference accumulated value QBi+1,i,i-1(tm). In step S402, for all combinations of three consecutive battery cells 13 in series in the battery module 11, it is determined whether the second difference accumulated value QBi+1,i,i-1(tm) is equal to or greater than a predetermined threshold TH4. The threshold TH4 is a positive-side threshold.

When, for all battery cells 13, the second difference value ΔΔVi+1,i,i-1(tm) does not reach or exceed the threshold TH4, step S402 is negated, the value "m" is incremented by 1 in step S307, and the process returns to step S301. Additionally, when the second difference value ΔΔVi+1,i,i-1(tm) reaches or exceeds the threshold TH4 in any of the battery cells 13 among all the battery cells 13, step S402 is affirmed and the process proceeds to step S308. In step S308, it is determined that an abnormality has occurred in the battery cell 13, and in step S309, notification of the occurrence of the abnormality is issued.

In a case where the central battery cell 13 (cell Ci) among three consecutive battery cells 13 connected in series becomes an abnormal cell due to internal short-circuiting, the voltage variation VAi(tm) of the abnormal cell becomes larger than that of a normal cell, and the voltage difference value ΔVi,i-1(tm) calculated between the abnormal cell and the adjacent cell on the negative electrode side, and the voltage difference value ΔVi+1,i(tm) calculated between the abnormal cell and the adjacent cell on the positive electrode side, have opposite polarities. Therefore, in three consecutive battery cells 13 connected in series, the second difference value $\Delta\Delta Vi+1,i,i-1(tm)$, which is calculated as the difference between the voltage difference values $\Delta Vi,i-1(tm)$ and $\Delta Vi+1,i(tm)$, clearly indicates the deviation in the voltage variation $VAi(tm)$ of the abnormal cell. Regarding this, by using the second difference value $\Delta\Delta Vi+1,i,i-1(tm)$, which is calculated based on the voltage variation $VA(tm)$ of three consecutive battery cells 13 connected in series, as a parameter for the abnormality determination, it is possible to appropriately detect abnormal cells.

Under circumstances where an internal short circuit has occurred in an abnormal cell, the polarities of the voltage difference value $\Delta Vi,i-1(tm)$ calculated between the abnormal cell and the adjacent cell on the negative electrode side, and the voltage difference value $\Delta Vi+1,i(tm)$ calculated between the abnormal cell and the adjacent cell on the positive electrode side, continue to be opposite (positive and negative are reversed). Therefore, by continuously monitoring the second difference value $\Delta\Delta Vi+1,i,i-1(tm)$, which is the difference between the voltage difference values $\Delta Vi,i-1(tm)$ and $\Delta Vi+1,i(tm)$, the accuracy of the internal short-circuit detection is improved. Regarding this, by using the second difference accumulated value $QBi+1,i(tm)$, which is a cumulative value of the second difference $\Delta\Delta Vi+1,i,i-1(tm)$, as a parameter for the abnormality determination, it is possible to improve the accuracy of the abnormality detection.

Third Embodiment

In the present embodiment, in the battery module 11, a degree of deviation of the voltage variation $VA(tm)$ of the target cell from an average value of the voltage variations $VA(tm)$ of each battery cell 13 is calculated as the deviation degree. Based on this deviation degree, it is determined whether a predetermined deviation in the voltage variation $VA(tm)$ has occurred in the target cell compared to the other battery cells 13.

In addition, when an internal short circuit occurs in any of the battery cells 13 in the battery module 11, the average value of the voltage variations $VA(tm)$ of each battery cell 13 will change due to the influence of the short circuit. In this case, when detecting abnormalities in the target cell based on the degree of deviation of the voltage variation $VA(tm)$ of the target cell relative to the average value of the voltage variations $VA(tm)$ of each battery cell 13, there is a concern that the detection accuracy may decrease. Therefore, in the present embodiment, the average value of the voltage variations $VA(tm)$ of the remaining battery cells 13, excluding one battery cell 13 (the target cell), among the battery cells 13 in the battery module 11 is used as a reference. The degree of deviation of the voltage variation $VA(tm)$ of the target cell is calculated based on this reference, and abnormality detection is performed according to the calculated degree of deviation.

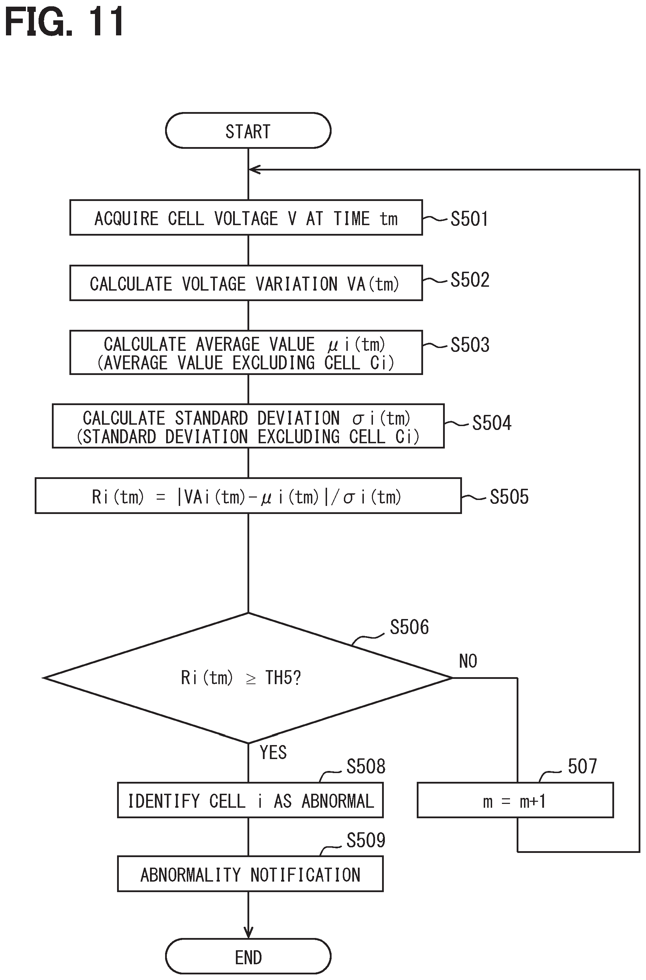

FIG. 11 is a flowchart illustrating the procedure for the anomaly detection processing of the battery cells 13 of the present embodiment, and this process is executed by the battery ECU 20.

In FIG. 11, in step S501, the cell voltage $V(tm)$ of each battery cell 13 at time point tm is acquired, and in step S502, for each battery cell 13, the voltage variation $VA(tm)$, which is the change amount in cell voltage from the initial value, is calculated. It should be noted that steps S501 to S502 are the same processing as steps S101 to S102 in FIG. 5.

Subsequently, in step S503, the average value $\mu i(tm)$ of the voltage variations $VA(tm)$ is calculated for each battery cell 13 in the battery module 11. In the present embodiment, when each battery cell 13 of the battery module 11 is individually designated as a target cell for abnormality detection, the average value $\mu i(tm)$ of the voltage variations $VA(tm)$ is calculated without using the voltage variation $VA(tm)$ of the target battery cell 13. In other words, the voltage variation $VA(tm)$ of the target battery cell 13 is excluded when calculating the average value $\mu i(tm)$ of the voltage variations $VA(tm)$. At this time, the average value $\mu i(tm)$ is calculated for each combination corresponding to the number of cells, using the respective voltage variations $VA(tm)$.

For example, when cell C1 is set as the target cell, the voltage variation $VA1(tm)$ of cell C1 is excluded, and the average value $\mu 1(tm)$ is calculated based on the remaining voltage variations $VA(tm)$. Similarly, when cell C2 is designated as the target cell, the voltage variation $VA2(tm)$ of cell C2 is excluded, and the average value $\mu 2(tm)$ is calculated based on the remaining voltage variations $VA(tm)$.

In step S504, a standard deviation $\sigma i(tm)$ of the voltage variations $VA(tm)$ is calculated for each battery cell 13 in the battery module 11. The standard deviation $\sigma i(tm)$ may be calculated as the square root of the variance, which is the mean of the squared differences between the voltage variation $VAi(tm)$ of each battery cell 13 and the average value $\mu i(tm)$. In the present embodiment, the standard deviation $\sigma i(tm)$ of the voltage variation $VA(tm)$ is calculated without using the voltage variation $VA(tm)$ of the battery cell 13 serving as the target cell. Instead, the calculation is performed using the voltage variations $VA(tm)$ of the remaining battery cells 13 other than the target cell, and the average value $\mu i(tm)$ obtained by excluding the target cell. At this time, the standard deviation $\sigma i(tm)$ is calculated individually for each voltage variation $VA(tm)$ corresponding to each combination of cell numbers.

For example, when cell C1 is the target cell, the standard deviation $\sigma 1(tm)$ is calculated using the voltage variations $VA(tm)$ of cells other than cell C1, and the average value $\mu 1(tm)$ obtained by excluding the voltage variation $VA1(tm)$ of cell C1. Similarly, when cell C2 is the target cell, the standard deviation $\sigma 2(tm)$ is calculated using the voltage variations $VA(tm)$ of cells other than cell C2, and the average value $\mu 2(tm)$ obtained by excluding the voltage variation VA2(tm) of cell C2.

In step S505, for each battery cell 13 serving as the target cell, the ratio of the absolute value of the difference between the voltage variation VAi(tm) and the average value μi(tm) to the standard deviation σi(tm) is calculated as the degree of deviation Ri(tm). The degree of deviation Ri(tm) is calculated using the following equation (3).

$$Ri(tm) = |\, VAi(tm) - \mu i(tm)\, |\, /\, \sigma i(tm) \quad \ldots (3)$$

The degree of deviation Ri(tm) indicates the extent to which the voltage variation VA(tm) of the target cell deviates from the average value of the voltage variations VA(tm) of each battery cell 13. Moreover, the degree of deviation Ri(tm) represents the ratio of the deviation (VAi(tm) - μi(tm)) to the standard deviation σi(tm) for each battery cell 13.

Subsequently, in step S506, it is determined for all battery cells 13 whether the degree of deviation Ri(tm) is equal to or greater than a predetermined threshold TH5. The threshold TH5 is a positive-side threshold. When the degree of deviation Ri(tm) for all battery cells 13 does not reach the threshold TH5, step S506 is denied, a value m is incremented by 1 in step S507, and the process returns to step S501. When the degree of deviation Ri(tm) in any of the battery cells 13 is equal to or greater than the threshold TH5, step S506 is affirmed and the process advances to step S508. In step S508, it is determined that an abnormality has occurred in the battery cell 13 for which the condition in step S506 has been satisfied. Thereafter, in step S509, notification of the occurrence of the abnormality is issued.

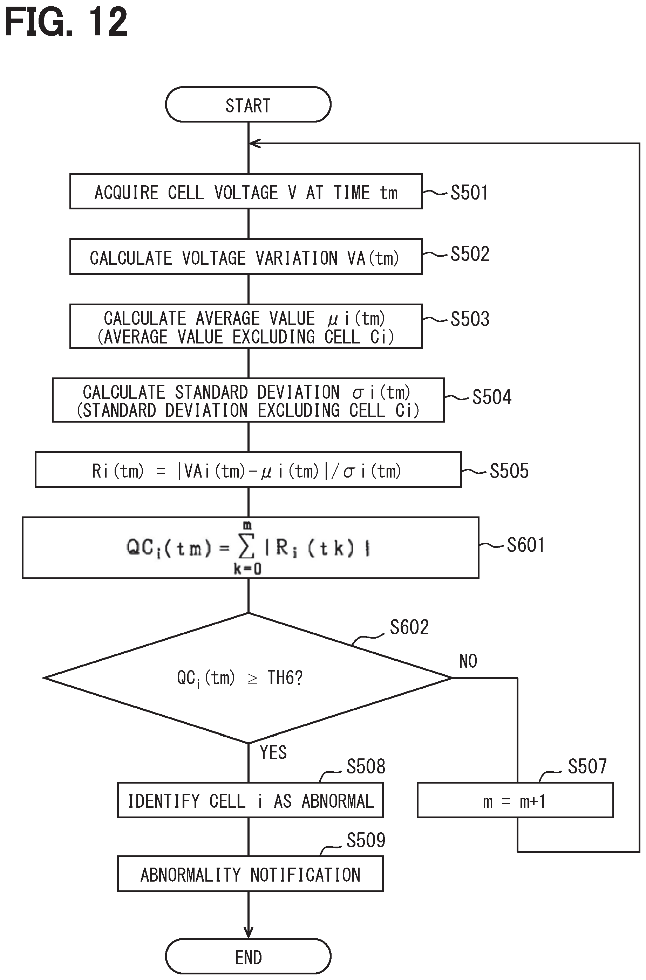

It is also possible to modify the abnormality detection process of FIG. 11 as shown in FIG. 12. The process of FIG. 12 is a modification of part of the process in FIG. 11, with steps S601 to S602 being different from those in FIG. 11.

In FIG. 12, as described above, in steps S501 to S502, the voltage variation VA(tm) is calculated at each time point tm. Further, in step S503, for each battery cell 13 of the battery module 11, the average value μi(tm) of the voltage variation VA(tm) is calculated. In step S504, for each battery cell 13, the standard deviation σi(tm) of the voltage variation VA(tm) is calculated. In step S505, for each target battery cell 13, the ratio of the absolute value of the difference between the voltage variation VAi(tm) and the average value μi(tm) to the standard deviation σi(tm) is calculated as the degree of deviation Ri(tm). In this case, as described above, the voltage variation VA(tm) of the target battery cell 13 is excluded when calculating the average value μi(tm) and the standard deviation σi(tm).

Subsequently, in step S601, for each battery cell 13, the degree of deviation Ri(tm) is accumulated to calculate an accumulated degree of deviation value QCi(tm). In step S602, it is determined whether the accumulated degree of deviation value QCi(tm) is equal to or greater than a predetermined threshold TH6. The threshold TH6 is a positive-side threshold.

Then, when the accumulated degree of deviation value QCi(tm) has not reached the threshold TH6 for any of the battery cells 13, step S602 is answered in the negative, m is incremented by 1 in step S507, and the process returns to step S501. Additionally, when the accumulated degree of deviation value QCi(tm) in any of the battery cells 13 reaches or exceeds the threshold TH6, step S602 is affirmed and the process proceeds to step S508. In step S508, it is determined that an abnormality has occurred in the battery cell 13, and in step S509, notification of the occurrence of the abnormality is provided.

The configuration is such that the degree of deviation of the voltage variation VA(tm) of the target cell is calculated based on the average value of the voltage variations VA(tm) of the remaining battery cells 13, excluding the target cell, among the battery cells 13 in the battery module 11, and this degree of deviation is used as an abnormality determination parameter. As a result, the accuracy of the abnormality detection can be improved.

In an abnormal cell where an internal short circuit has occurred, a relatively large degree of deviation in the voltage variation VA(tm) continues, so by using the accumulated degree of deviation QCi(tm), which is the accumulated value of the degree of deviation Ri(tm), as a parameter for abnormality determination, the accuracy of abnormality detection can be improved. Moreover, since the accumulated degree of deviation QCi(tm) is calculated based on the average value of the voltage variations VA of the battery cells 13 excluding the target cell, the accuracy of the abnormality detection can be further enhanced.

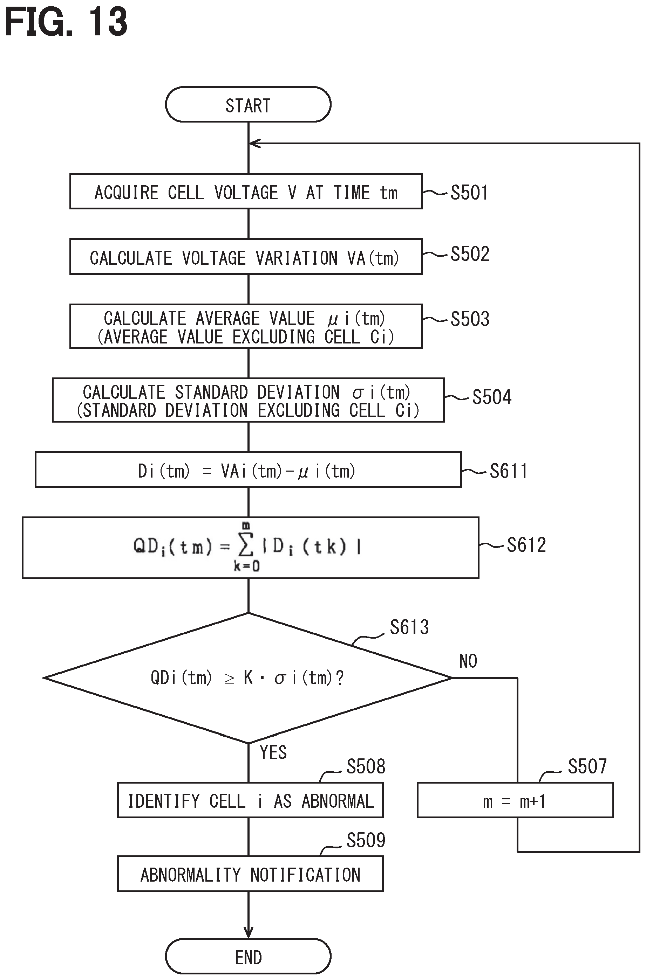

It is also possible to modify the abnormality detection process shown in FIG. 11 as illustrated in FIG. 13. The process of FIG. 13 is a modification of part of the process of FIG. 11, and steps S611 to S613 are different from those in FIG. 11.

In FIG. 13, in steps S501 to S504, the average value μi(tm) of the voltage variation VA(tm) and the standard deviation σi(tm) of the voltage variation VA(tm) are calculated for each battery cell 13 by the same processing as in FIG. 11. In this case, as described above, the voltage variation VA(tm) of the target battery cell 13 is excluded when calculating the average value μi(tm) and the standard deviation σi(tm).

Thereafter, in step S611, for each battery cell 13, the deviation Di(tm), which is a difference between the voltage variation VAi(tm) and the average value μi(tm), is calculated. At this time, the deviation Di(tm) is calculated for each target battery cell 13 using the average value μi(tm) of the voltage variations VA(tm) of the battery cells 13 excluding the target cell. In addition, in step S612, the absolute values of the deviations Di(tm) are accumulated to calculate the accumulated deviation value QDi(tm). It should be noted that step S611 corresponds to a deviation calculation unit, and step S612 corresponds to an accumulated value calculation unit.

In step S613, for each battery cell 13, it is determined whether the accumulated deviation value QDi(tm) is equal to or greater than a threshold value (K × σi(tm)), which is the product of the standard deviation σi(tm) and a predetermined coefficient K.

Then, when the accumulated deviation value QDi(tm) has not reached the threshold in all of the battery cells 13, step S613 is negated, the value m is incremented by one in step S507, and the process returns to step S501. Additionally, when the accumulated deviation value QDi(tm) in any one of the battery cells 13 among all the battery cells 13 has reached or exceeded the threshold, step S613 is affirmed and the process proceeds to step S508. In step S508, it is determined that an abnormality has occurred in the battery cell 13, and in step S509, notification of the occurrence of the abnormality is provided.

When an internal short circuit occurs in any of the battery cells 13 in the battery module 11, the average value μ(tm) and the standard deviation σ(tm) of the voltage variation VA(tm) of each battery cell 13 fluctuate due to the effects thereof. In this case, when detecting abnormalities in the target cell by comparing the accumulated deviation value QD(tm) of the voltage variation VA(tm) of each battery cell 13 with the threshold set based on the standard deviation σ(tm), there is concern that the detection accuracy may decrease. Regarding this, the average value μ(tm) of the voltage variation VA(tm) of the remaining battery cells 13, excluding the target cell, among the battery cells 13 is used to calculate the deviation D(tm), and the voltage variation VA(tm) of the remaining battery cells 13, excluding the target cell, among the battery cells 13 is also used to calculate the standard deviation σ(tm). As a result, the accuracy of the abnormality detection can be improved.

Fourth Embodiment

In the present embodiment, based on voltage variations VAi+1(tm), VAi(tm), and VAi-1(tm) of three consecutive battery cells 13 connected in series among battery cells 13, a difference calculation is performed twice to obtain a double difference value ΔΔVi+1,i,i-1(tm). Furthermore, the degree of deviation of the double difference value ΔΔVi+1,i,i-1(tm) from the average value of the double difference values ΔΔV(tm) is calculated, and the abnormality of the target cell is detected based on this degree of deviation.

In such a case, when an internal short circuit occurs in any of the battery cells 13 within the battery module 11, the influence thereof causes the voltage difference value ΔV(tm) in combinations of battery cells 13 including the abnormal cell to differ from the voltage difference value ΔV(tm) in combinations of normal cells. As a result, the average value of the double difference value ΔΔV(tm) changes. In this case, the accuracy of the deviation of the double difference value ΔΔV(tm) of the target cell relative to the average value of the double difference values ΔΔV(tm) decreases, raising concerns about a decline in the accuracy of abnormality detection based on the degree of deviation.

Therefore, in the present embodiment, when calculating the double difference value ΔΔV(tm) by designating each battery cell 13 in the battery module 11 one by one as a specified cell, the double difference value ΔΔV(tm) calculated with the target cell as the specified cell is defined as a specific double difference value. Then, among the double difference values ΔΔV(tm) calculated by designating each battery cell 13 in the battery module 11 one by one as the specified cell, the degree to which the specific double difference value deviates from the average value of the remaining double difference values ΔΔV(tm), excluding the specific double difference value, is calculated as the degree of deviation.

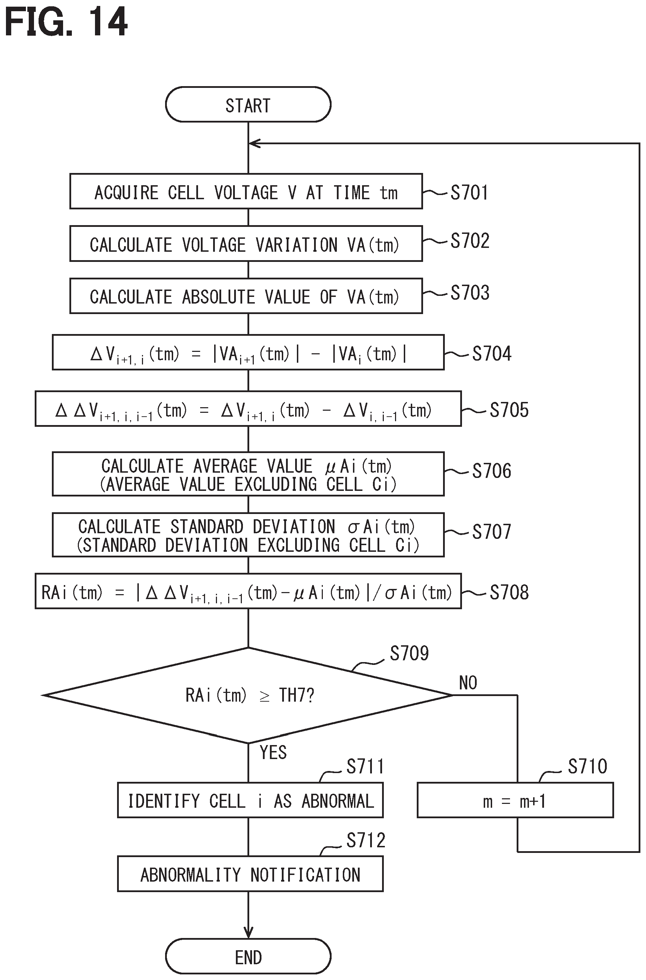

FIG. 14 is a flowchart showing the procedure for abnormality detection processing of the battery cell 13 in the present embodiment, and this processing is executed by the battery ECU 20.

In FIG. 14, in step S701, the cell voltage V(tm) of each battery cell 13 at time point tm is acquired. In step S702, for each battery cell 13, the voltage variation VA(tm), which is a change amount in cell voltage from the initial value, is calculated. In the subsequent step S703, the absolute value of the voltage variation VA(tm) is calculated. Further, in step S704, the voltage difference value ΔVi+1,i(tm) is calculated, and in step S705, the double difference value ΔΔVi+1,i,i-1(tm) is calculated. It should be noted that steps S701 to S705 correspond to the processing of steps S301 to S305 in FIG. 9.

In particular, in the present embodiment, in step S704, each battery cell 13 of the battery module 11 is designated one by one as a target cell. The voltage difference value ΔV(tm), which is the difference in voltage variation VA(tm) between the target cell and the first adjacent cell on the negative electrode side, and the voltage difference value ΔV(tm), which is the difference in voltage variation VA(tm) between the target cell and the second adjacent cell on the positive electrode side, are each calculated by subtraction in either ascending or descending order of the cell serial sequence. Further, in step S705, for all combinations where the designated cell is the middle battery cell 13 among three consecutive cells in series, the double difference value ΔΔVi+1,i,i-1(tm) is calculated.

Subsequently, in step S706, for each battery cell 13 of the battery module 11 designated one by one as the target cell, the average value μAi(tm) of the calculated double difference values ΔΔV(tm) is determined. More specifically, among the double difference values ΔΔV(tm) calculated by designating each battery cell 13 one by one as the target cell, the average value μAi(tm) of the double difference values ΔΔV(tm) is calculated by excluding the double difference value ΔΔVi+1,i,i-1(tm) that is obtained when the target cell (cell Ci) is designated as the specified cell, i.e., by excluding this particular double difference value. In step S706, multiple average values $\mu Ai(tm)$ are calculated for all possible combinations in the battery module 11.

In step S707, the standard deviation $\sigma Ai(tm)$ of the double difference values $\Delta\Delta V(tm)$, calculated by designating each battery cell 13 of the battery module 11 one by one as the target cell, is determined. The standard deviation $\sigma Ai(tm)$ is preferably calculated as the square root of the variance, which is the mean of the squared differences between the double difference values $\Delta\Delta V(tm)$, obtained by designating each battery cell 13 one by one as the target cell, and the average value $\mu Ai(tm)$. More specifically, when the double difference value $\Delta\Delta Vi+1,i,i-1(tm)$, calculated by designating the target cell (cell Ci) as the specified cell, is set as the specific double difference value, the standard deviation $\sigma Ai(tm)$ of the double difference values $\Delta\Delta V(tm)$ is calculated using the double difference values $\Delta\Delta V(tm)$ obtained by designating each battery cell 13 one by one as the specified cell, excluding the specific double difference value, and the average value $\mu Ai(tm)$ calculated with the specific double difference value excluded. In step S707, multiple standard deviations $\sigma Ai(tm)$ are calculated for all possible combinations of the battery module 11.

In step S708, for each battery cell 13, the ratio of the absolute value of the difference between the double difference value $\Delta\Delta Vi+1,i,i-1(tm)$ and the average value $\mu Ai(tm)$ to the standard deviation $\sigma Ai(tm)$ is calculated as the degree of deviation RAi(tm). The degree of deviation RAi(tm) is calculated using the following equation (4).

$$RAi(tm) = |\, \Delta\Delta Vi+1,i,i-1(tm) - \mu Ai(tm)\, | \,/\, \sigma Ai(tm) \ \ldots(4)$$

In steps S706 to S708, when the double difference value $\Delta\Delta Vi+1,i,i-1(tm)$, calculated by designating the target cell (cell Ci) as the specified cell, is set as the specific double difference value, the degree to which this specific double difference value deviates from the average of the remaining double difference values $\Delta\Delta V(tm)$, excluding the specific double difference value, from among those calculated for each battery cell 13 designated one by one as the specified cell, is calculated as the degree of deviation RAi(tm).

Thereafter, in step S709, it is determined for all battery cells 13 whether the degree of deviation RAi(tm) is equal to or greater than a predetermined threshold TH7. The threshold TH7 is a positive-side threshold.

Then, when the degree of deviation RAi(tm) for all battery cells 13 does not reach or exceed the threshold TH7, the determination in step S709 is negative, a value m is incremented by 1 in step S710, and the process returns to step S701. Additionally, when the degree of deviation RAi(tm) for any of the battery cells 13 reaches or exceeds the threshold TH7, the determination in step S709 is affirmative, and the process proceeds to step S711. In step S711, it is determined that an abnormality has occurred in the battery cell 13 for which the condition in step S709 has been satisfied. Thereafter, in step S712, notification of the occurrence of the abnormality is given.

Among the double-difference values $\Delta\Delta V(tm)$ calculated by designating each battery cell as the specified cell one by one, the degree of deviation of a specific double-difference value (i.e., the double-difference value calculated by designating the target cell as the specified cell) is calculated with reference to the average value of the remaining double-difference values $\Delta\Delta V(tm)$, excluding the specific double-difference value. This degree of deviation is used as the abnormality determination parameter. Here, when the target cell is assumed to be an abnormal cell, the specific double-difference value is the double-difference value $\Delta\Delta V(tm)$ that is affected by the fluctuation in the voltage variation VA(tm) of the abnormal cell. By calculating the average value $\mu i(tm)$ and the standard deviation $\sigma i(tm)$ while excluding this specific double-difference value, the accuracy of abnormality detection can be improved.

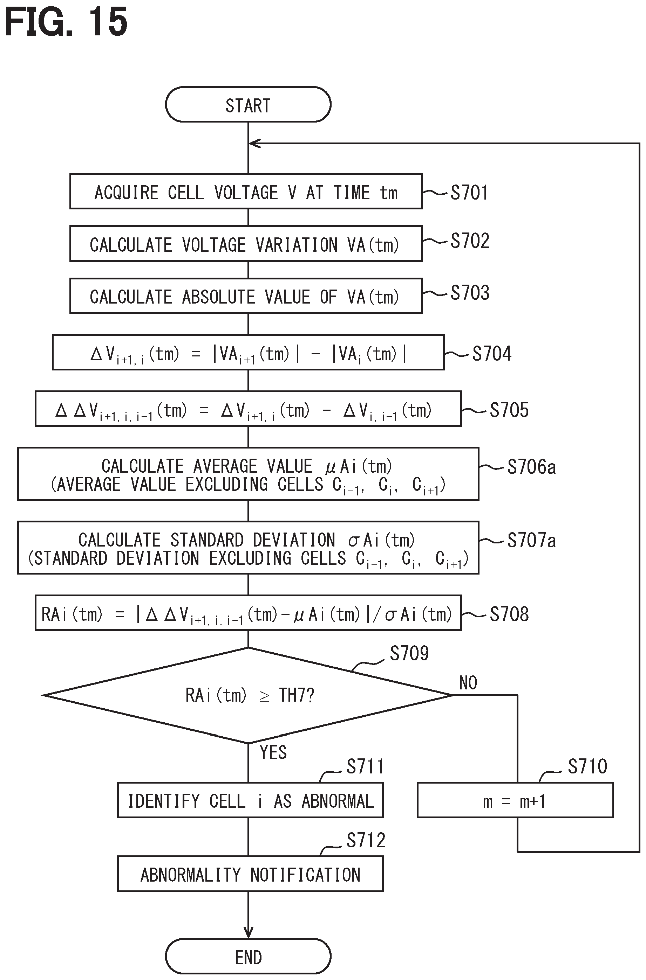

The abnormality detection process shown in FIG. 14 can also be modified as shown in FIG. 15. The process in FIG. 15 is a modified version of a part of the process in FIG. 14, with steps S706 to S707 in FIG. 14 replaced by steps S706a to S707a.

In steps S706a to S707a, among the double-difference values $\Delta\Delta V(tm)$ calculated by designating each battery cell 13 as the specified cell one by one, the degree of deviation RAi(tm) is calculated by measuring how much the specific double-difference value deviates from the average value of the remaining double-difference values $\Delta\Delta V(tm)$, excluding both the specific double-difference value and those calculated by designating the first adjacent cell and the second adjacent cell as the specified cell, respectively.

Here, for convenience, the specific double-difference value (the double-difference value $\Delta\Delta Vi+1,i,i-1(tm)$ calculated by designating the target cell as the specified cell), as well as the double-difference values $\Delta\Delta Vi,i-1,i-2(tm)$ and $\Delta\Delta Vi+2,i+1,i(tm)$ calculated by designating the first adjacent cell and the second adjacent cell as the specified cell, respectively, are collectively referred to as a specific double-difference value group X.

In step S706a, the average value $\mu Ai(tm)$ of the double-difference values $\Delta\Delta V(tm)$ is calculated by excluding the specific double-difference value group X ($\Delta\Delta Vi,i-1,i-2(tm)$, $\Delta\Delta Vi+1,i,i-1(tm)$, and $\Delta\Delta Vi+2,i+1,i(tm)$)from among the double-difference values $\Delta\Delta V(tm)$ calculated by designating each battery cell 13 as the specified cell one by one.

In step S707a, the standard deviation $\sigma Ai(tm)$ of the double-difference values $\Delta\Delta V(tm)$ calculated for each battery cell 13 as a designated cell is calculated using the double-difference values $\Delta\Delta V(tm)$ other than the specific double-difference value group X ($\Delta\Delta Vi,i-1,i-2(tm)$, $\Delta\Delta Vi+1,i,i-1(tm)$, and $\Delta\Delta Vi+2,i+1,i(tm)$), along with the average value $\mu Ai(tm)$ calculated by excluding the specific double-difference value group X.

Then, as described above, the degree of deviation RAi(tm) is calculated, and based on this degree of deviation RAi(tm), abnormality determination for each battery cell 13 is performed (steps S708, S709).

When the target cell is an abnormal cell, the specific double-difference value group X (the specific double-difference value, as well as the double-difference values calculated by designating the first adjacent cell and the second adjacent cell as the specified cell, respectively) are double-difference values $\Delta\Delta V(tm)$ that are affected by fluctuations in the abnormal cell's voltage variation VA(tm). By excluding this specific double-difference value group X when calculating the average value $\mu i(tm)$ and standard deviation $\sigma i(tm)$, the accuracy of abnormality detection can be improved.

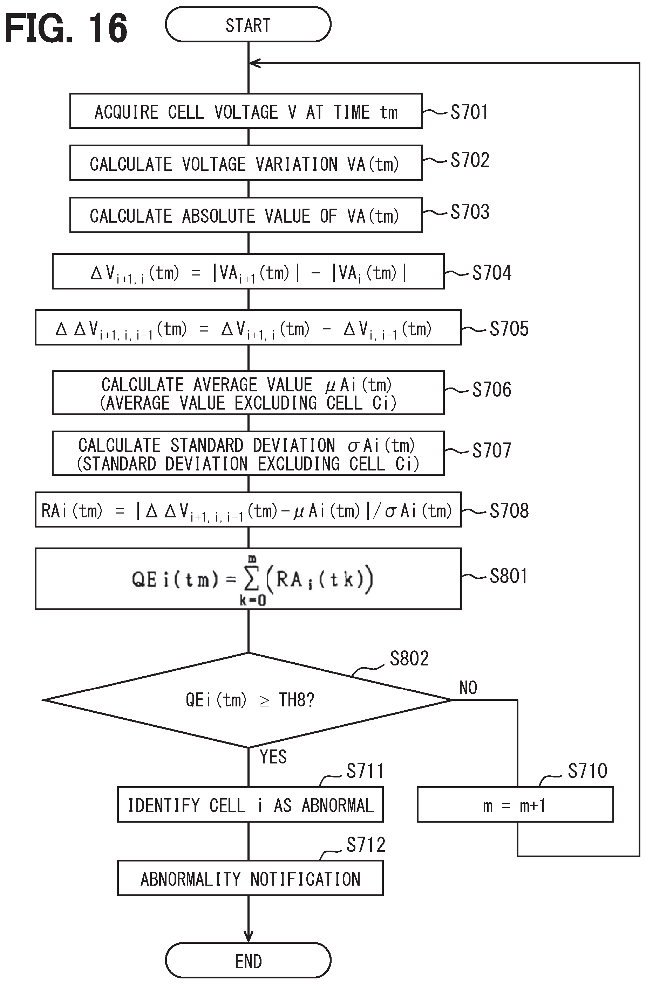

The abnormality detection process shown in FIG. 14 can also be modified as shown in FIG. 16. The process shown in FIG. 16 is a modification of part of the process shown in FIG. 14, with steps S801 to S802 involving different processing from that in FIG. 14.

In FIG. 16, after calculating the degree of deviation RAi(tm), in step S801, the degree of deviation RAi(tm) calculated for each time point tm is accumulated to compute the accumulated deviation value QEi(tm). Further, in step S802, it is determined whether the accumulated deviation value QEi(tm) is equal to or greater than a predetermined threshold TH8. The threshold TH8 is a positive-side threshold.

Then, when the accumulated deviation value QEi(tm) has not reached or exceeded the threshold TH8 in any of the battery cells 13, step S802 is answered in the negative, "m" is incremented by 1 in step S710, and the process returns to step S701. Further, when the accumulated deviation value QEi(tm) in any of the battery cells 13 among all the battery cells 13 has reached or exceeded the threshold TH8, step S802 is affirmed, and the process proceeds to step S711. In step S711, it is determined that an abnormality has occurred in the battery cell 13, and in step S712, notification of the occurrence of the abnormality is provided.

Fifth Embodiment

In a fifth embodiment, in a configuration where each battery cell 13 of the battery pack B is divided into battery cell groups, a provisional abnormality determination is performed for all the battery cell groups as a first stage of abnormality detection, and a final abnormality determination is performed for the battery cell groups that were provisionally determined to be abnormal as a second stage.

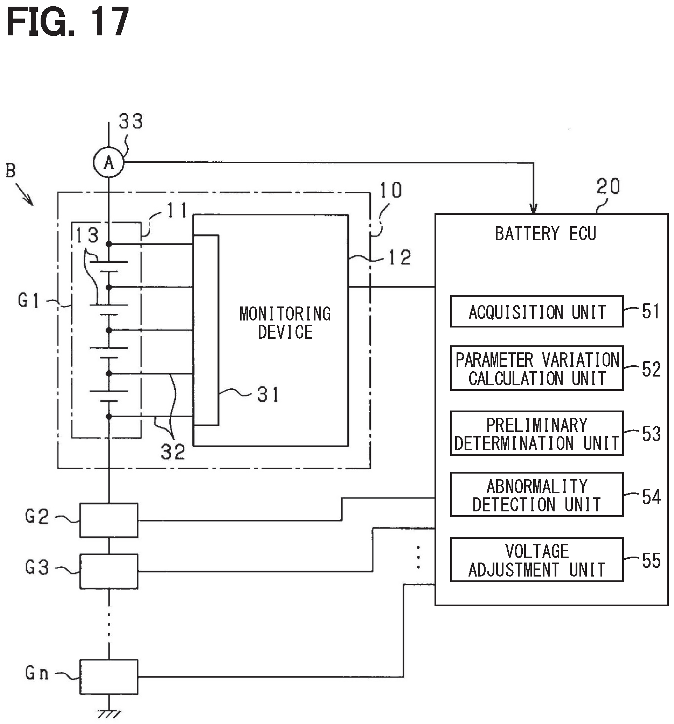

FIG. 17 is a diagram showing the configuration of the battery system in the present embodiment. In a battery unit 10, battery cell groups G1, G2, ... Gn are formed from battery cells 13 connected in series. Each battery cell group G1 to Gn is composed of three or more battery cells 13 connected in series with each other. For example, each battery module 11 shown in FIG. 1 may correspond to each battery cell group G1 to Gn. In the battery unit 10 shown in FIG. 17, a monitoring device 12 is provided for each battery cell group G1 to Gn. However, it is also possible to have a configuration in which a single monitoring device 12 is provided for two or more battery cell groups G1 to Gn.

In the present embodiment, the battery ECU 20 includes an acquisition unit 51, a parameter change amount calculation unit 52, a preliminary determination unit 53, an abnormality detection unit 54, and a voltage adjustment unit 55. The acquisition unit 51 acquires the cell voltage V (state detection value) of each battery cell 13, detected by the voltage sensor 31 (state detection unit), from each monitoring device 12 in each battery cell group G1 to Gn. The parameter change amount calculation unit 52 calculates the voltage variation VA (parameter change amount), which is the change amount in cell voltage V over a predetermined period acquired by the acquisition unit 51, for each battery cell group G1 to Gn. The preliminary determination unit 53 makes a preliminary determination of abnormalities in each battery cell 13, based on the voltage variation VA, for each battery cell group G1 to Gn. The abnormality detection unit 54, in a battery cell group containing a battery cell 13 preliminarily determined to be abnormal by the preliminary determination unit 53 among the battery cell groups G1 to Gn, sequentially designates each battery cell 13 as a target cell for abnormality detection and performs abnormality detection for that target cell.

In the present embodiment, as an execution condition for abnormality detection, it is stipulated that the terminal voltages of each battery cell 13 in each battery cell group G1 to Gn are adjusted to the same voltage, and abnormality detection for each battery cell 13 (target cell) is executed when this execution condition is satisfied. More specifically, the battery ECU 20 has an equalization function that adjusts the terminal voltage of each battery cell 13 to the same voltage, and under the condition that the equalization processing (cell balancing processing) for each battery cell 13 has been carried out, the abnormality detection is performed using the cell voltage of each battery cell 13. The voltage adjustment unit 55 performs voltage equalization by discharging or charging each battery cell 13 individually. For example, the voltage adjustment unit 55 executes the equalization process when variation in the terminal voltages of the battery cells 13 occurs while the vehicle is stopped (parked). Alternatively, the voltage adjustment unit 55 periodically executes the equalization process, that is, at predetermined intervals.

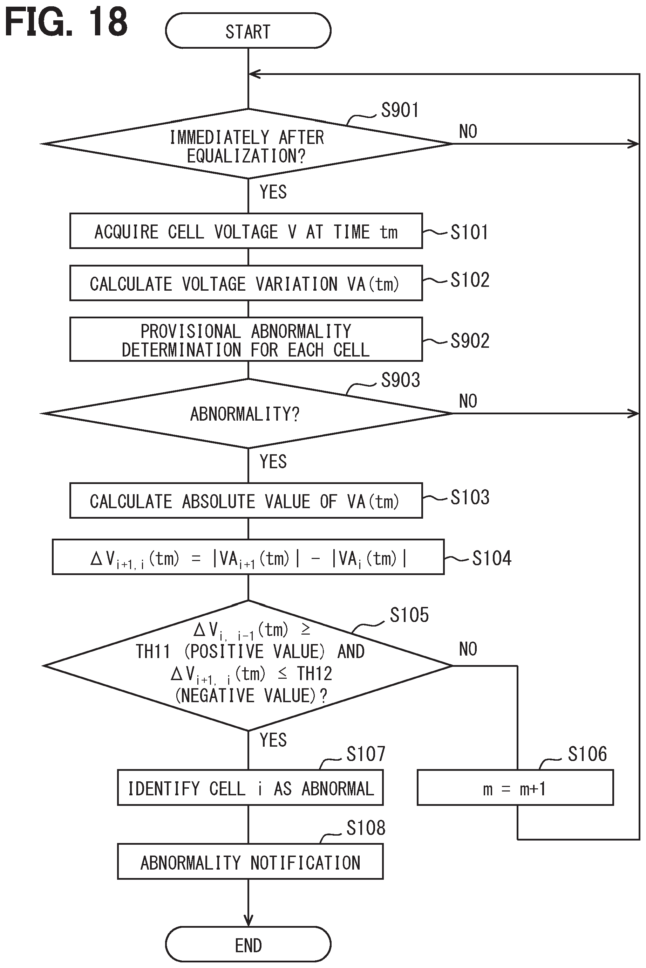

FIG. 18 is a flowchart showing the procedure for the abnormality detection processing of the battery cells 13 according to the present embodiment, and this process is executed by the battery ECU 20. FIG. 18 is a modified version of a part of FIG. 5 described above, and the same process steps as in FIG. 5 are assigned the same step numbers for simplification of explanation. The process shown in FIG. 18 is executed for each group of battery cells. It should be noted that the process in FIG. 18 is configured to be executable while the power switch of the vehicle is off, assuming that the equalization process is performed while the vehicle is stopped.

In FIG. 18, step S901 determines whether the equalization process for each battery cell 13 has just been executed. For example, when the equalization process is performed while the vehicle is stopped, step S901 is affirmed when it is before the next vehicle startup and within a predetermined period after the execution of the equalization process. Then, on the condition that step S901 is affirmed, the process proceeds to the subsequent step S101.

In steps S101 and S102, the cell voltage $V(tm)$ of each battery cell 13 is acquired, and for each battery cell 13, the voltage variation $VA(tm)$, which is the change in cell voltage $V(tm)$ from the initial value (initial voltage value), is calculated ($VA(tm) = V(tm)$ - initial value).

Subsequently, in step S902, a provisional determination is made regarding the presence or absence of abnormalities for each battery cell 13 based on the voltage variation $VA(tm)$ of each battery cell 13. In the following step S903, it is determined whether the group of battery cells currently being monitored for detection contains any battery cell 13 that has been provisionally determined to be abnormal. The processing in step S902 corresponds to the first stage of abnormality detection. At this time, the voltage variation $VA(tm)$ of each battery cell 13 within the battery cell group is compared with one another, and when there exists a battery cell 13 with a large degree of deviation, it is determined that there is a possibility of abnormality in the battery cell group that includes that battery cell 13. More specifically, the average value of the voltage variation $VA(tm)$ for each battery cell 13 within the battery cell group is calculated, and any battery cell 13 whose voltage variation $VA(tm)$ deviates from this average value by a predetermined amount or more may be provisionally determined to be a battery cell 13 in which an abnormality has occurred (abnormal cell).

Subsequently, in steps S103 and S104, the absolute value of the voltage variation $VA(tm)$ is calculated, and for all battery cells 13, a difference in the absolute values of the voltage variation $VA(tm)$ between each pair of adjacent battery cells 13 in the series path is calculated as a voltage difference value $\Delta V_{i+1,i}(tm)$. In step S105, each battery cell 13 (cells C1 to Cn) is individually designated as a target cell, and for each target cell, the voltage difference values $\Delta V_{i,i-1}(tm)$ and $\Delta V_{i+1,i}(tm)$ are compared with a predetermined threshold value. Then, when any of the battery cells 13 among all the battery cells 13 meets a condition that the voltage difference value $\Delta V_{i,i-1}(tm)$ is equal to or greater than the positive-side threshold TH11 and the voltage difference value $\Delta V_{i+1,i}(tm)$ is equal to or less than the negative-side threshold TH12, then step S105 is affirmed, and the process proceeds to step S107. In step S107, it is determined that an abnormality has occurred in the battery cell 13 for which the condition in step S105 has been satisfied. The processing in steps S103 to S107 corresponds to the second stage of abnormality detection.

In the abnormality detection processing of FIG. 18, the abnormality detection of battery cell 13 is configured to be performed, as the second stage of abnormality detection (main determination), based on the voltage difference values $\Delta V_{i,i-1}(tm)$ and $\Delta V_{i+1,i}(tm)$. However, the processing for this main determination may also be modified as described below.

(1) In each battery cell group, a difference accumulation values $QA_{i,i-1}(tm)$ and $QA_{i+1,i}(tm)$ may be calculated by accumulating the absolute values of the voltage difference values $\Delta V_{i+1,i}(tm)$ computed for each time point tm, and based on these difference accumulation values $QA_{i,i-1}(tm)$ and $QA_{i+1,i}(tm)$, abnormality detection (main determination) of the battery cell 13 may be performed (see steps S202 and S203 in FIG. 6).

(2) In each battery cell group, the voltage difference value $\Delta V_{i+1,i}(tm)$ may be calculated as a difference between the absolute values of the voltage change $VA(tm)$ of two battery cells 13 that are adjacent in the series path. Further, a difference between two adjacent voltage difference values $\Delta V_{i+1,i}(tm)$ and $\Delta V_{i,i-1}(tm)$ in the series arrangement of battery cells 13 may be calculated as a second difference value $\Delta\Delta V_{i+1,i,i-1}(tm)$, and based on the second difference value $\Delta\Delta V_{i+1,i,i-1}(tm)$, the abnormality detection (main determination) of battery cell 13 may be performed (see steps S304 to S306 in FIG. 9).

(3) In each battery cell group, the second difference accumulation value $QB_{i+1,i,i-1}(tm)$ may be calculated by accumulating the second difference values $\Delta\Delta V_{i+1,i,i-1}(tm)$ computed for each time point tm, and based on this second difference accumulation value $QB_{i+1,i,i-1}(tm)$, abnormality detection (main determination) of battery cell 13 may be performed (see steps S401 and S402 in FIG. 10).

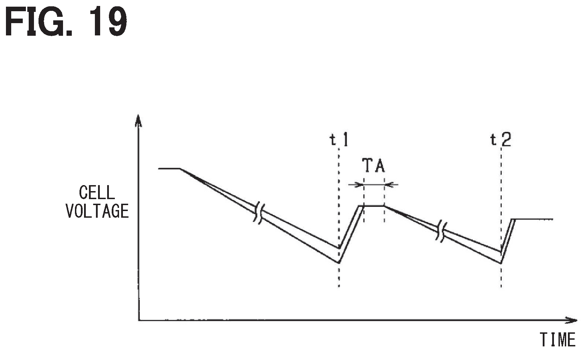

FIG. 19 is a time chart showing changes in cell voltage in a battery pack B. In FIG. 19, for convenience of explanation, changes in the cell voltages of two battery cells 13 are shown.

In FIG. 19, timings t1 and t2 are the time points at which equalization processing of each battery cell 13 is performed, and after these timings t1 and t2, the cell voltages of each battery cell 13 are equalized. For example, when the equalization processing is performed at timing t1, period TA is immediately after equalization and is a pre-discharge period during which no discharge to onboard rotary electric machines or the like is performed while the vehicle is in an activated state. It is preferable that the abnormality detection processing for the battery cell 13 is started with period TA as a reference point.

In the above embodiment, the voltage adjustment unit 55 is configured to perform the voltage equalization processing for each battery cell 13 as a voltage adjustment process, but this may be modified. For example, the voltage adjustment unit 55 may be configured to perform charging of the battery pack B (each battery module 11) to a fully charged state by means of a charging device as the voltage adjustment process. In this case, it is preferable that the battery ECU 20 executes the abnormality detection (main determination) for the target cell on a condition that a predetermined period of time has not yet elapsed after the battery pack B (each battery module 11) has been fully charged. The charging device is preferably an external charging device provided outside the vehicle.

It should be noted that a configuration in which the execution condition for the abnormality detection is that the terminal voltages of all battery cells 13 have been adjusted to the same voltage can also be applied to the abnormality detection processes other than those of the present embodiment. For example, in each of the abnormality detection processes of the first to fourth embodiments, it is also possible to adopt a configuration in which the abnormality detection for each battery cell 13 is performed based on the voltage difference value $\Delta V$, the second-order difference value $\Delta\Delta V$, or the like, on the condition that the terminal voltages of all battery cells 13 have been adjusted to the same voltage.

In the present embodiment described above, by combining a preliminary determination and a main determination as described above when detecting abnormalities in each battery cell 13, it is possible to achieve appropriate abnormality detection while reducing excessive computational load.

In addition, a configuration is adopted in which the abnormality detection is performed on the target cell on the condition that the terminal voltages of all battery cells 13 have been adjusted to the same voltage through the equalization process or the like. In this case, it is possible to reduce false detection of abnormalities for each battery cell 13.

Sixth Embodiment

In a sixth embodiment, a configuration will be described in which abnormality detection is performed in two stages in the abnormality detection processing shown in FIG. 11 described above. It should be noted that, in the present embodiment, the preliminary determination of abnormalities is performed for each battery cell 13, rather than for each battery cell group in the battery pack B.

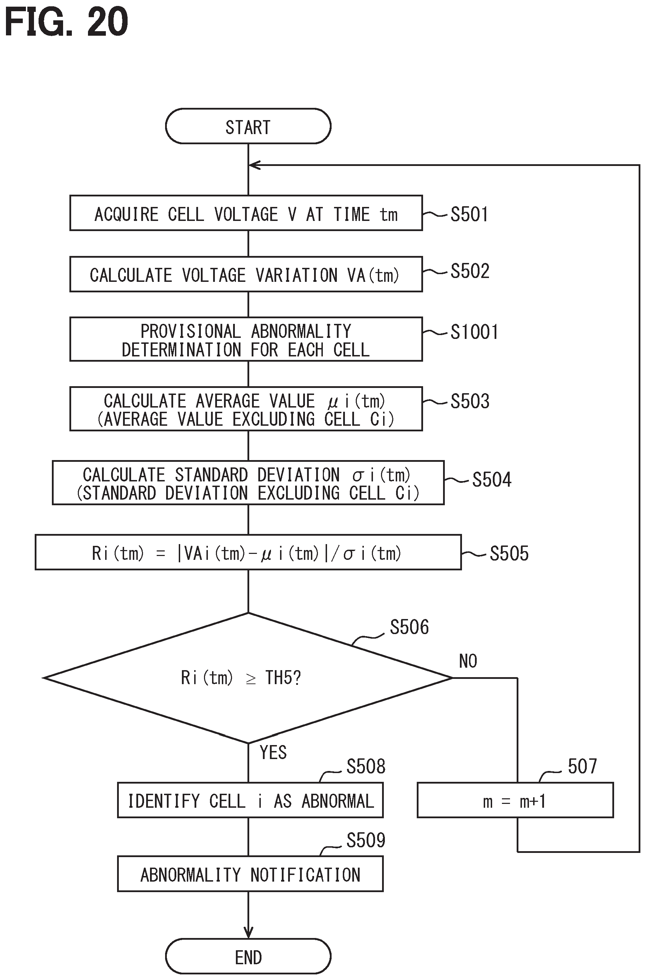

FIG. 20 is a flowchart showing the procedure for the abnormality detection processing of the battery cells 13 according to the present embodiment, and this process is executed by the battery ECU 20. FIG. 20 is a modified version of a part of FIG. 11 described above, and the same process steps as in FIG. 11 are assigned the same step numbers for simplification of explanation.

In FIG. 20, in steps S501 and S502, the cell voltage V(tm) of each battery cell 13 is acquired, and for each battery cell 13, the voltage variation VA(tm), which is a change amount in cell voltage from the initial value, is calculated.

Subsequently, in step S1001, a preliminary determination of the presence or absence of an abnormality is performed for each battery cell 13 based on the voltage variation VA(tm) of each battery cell 13. At this time, when there is any battery cell 13 for which a difference between its voltage variation VA(tm) and the average value of the voltage variations VA(tm) of all battery cells 13 is equal to or greater than a predetermined value, that battery cell 13 is preliminarily determined as an abnormal cell. In the present embodiment, step S1001 corresponds to a preliminary determination unit.

Subsequently, in steps S503 to S506, each battery cell 13 that was preliminarily determined to be an abnormal cell in step S1001 is individually set as a target cell for the abnormality detection, and it is determined whether a predetermined deviation has occurred in the target cell. In this case, in steps S503 to S506, not all battery cells 13 in the battery module 11 are targeted for the abnormality detection. Only the battery cells 13 that have been preliminarily determined as abnormal cells are targeted for abnormality detection.

More specifically, in step S503, the average value $\mu i(tm)$ of the voltage variation VA(tm) is calculated for all battery cells 13 in the battery module 11. At this time, when each battery cell 13 preliminarily determined to be an abnormal cell in step S1001 is individually set as a target cell, the average value $\mu i(tm)$ of the voltage variation VA(tm) is calculated without using the voltage variation VA(tm) of the target cell, that is, in other words, by excluding the voltage variation VA(tm) of the target battery cell 13. In step S504, the standard deviation $\sigma i(tm)$ of the voltage variation VA(tm) is calculated without using the voltage variation VA(tm) of the target cell. Instead, the voltage variations VA(tm) of the remaining battery cells 13 (excluding the target cell) and the average value $\mu i(tm)$ calculated with the target cell excluded are used.

In step S505, for each battery cell 13 serving as the target cell, the ratio of the absolute value of the difference between the voltage variation VAi(tm) and the average value $\mu i(tm)$ to the standard deviation $\sigma i(tm)$ is calculated as the degree of deviation Ri(tm). Thereafter, in step S506, the abnormality detection is performed for each battery cell 13 subject to the abnormality detection, based on the degree of deviation Ri(tm).

Although not shown, it is preferable that the abnormality detection processes shown in FIG. 12 and FIG. 13 also perform the preliminary determination of the presence or absence of an abnormality for each battery cell 13 based on the voltage variation VA(tm) of each battery cell 13, as in step S1001 in FIG. 20. That is, in the abnormality detection processes of FIGS. 12 and 13, it is preferable to execute the processing of step S1001 between step S502 and step S503.

In the present embodiment described above, the preliminary determination of abnormal cells is performed for the battery cells 13 based on the difference from the average value of the voltage variation VA (parameter variation), and each preliminarily determined abnormal cell is treated as a target cell, for which a final determination of abnormality is made. As a result, it is possible to achieve appropriate abnormality detection while reducing excessive computational load.

Seventh Embodiment

In a seventh embodiment, in a configuration where each battery cell 13 of the battery pack B is divided into battery cell groups, a provisional abnormality determination is performed for all the battery cell groups as a first stage of abnormality detection, and a final abnormality determination is performed for the battery cell groups that were provisionally determined to be abnormal as a second stage.

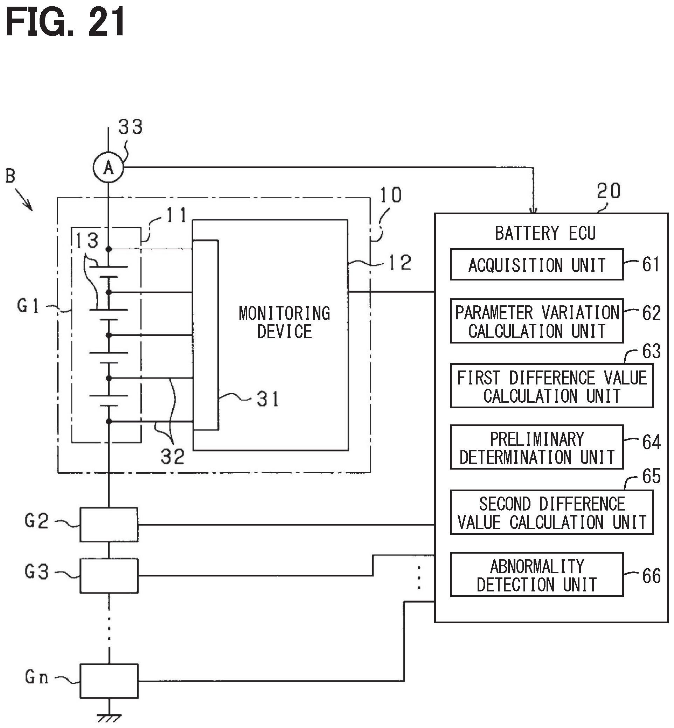

FIG. 21 is a diagram showing a configuration of a battery system in the present embodiment. In a battery unit 10, battery cell groups G1, G2, ... Gn are formed from battery cells 13 connected in series. Each battery cell group G1 to Gn is composed of three or more battery cells 13 connected in series with each other. For example, each battery module 11 shown in FIG. 1 may correspond to each battery cell group G1 to Gn. In the battery unit 10 shown in FIG. 21, a monitoring device 12 is provided for each battery cell group G1 to Gn. However, it is also possible to have a configuration in which a single monitoring device 12 is provided for two or more battery cell groups G1 to Gn.

In the present embodiment, the battery ECU 20 is provided with an acquisition unit 61, a parameter variation calculation unit 62, a first differential value calculation unit 63, a preliminary determination unit 64, a second differential value calculation unit 65, and an abnormality detection unit 66.

The acquisition unit 61 acquires the cell voltage V (state detection value) of each battery cell 13 detected by the voltage sensor 31 (state detection unit). The parameter variation calculation unit 62 calculates the voltage variation VA (parameter variation amount), which is a change amount in the cell voltage V acquired by the acquisition unit 51 over a predetermined period.

The first differential value calculation unit 63 calculates, for each battery cell group G1 to Gn, a voltage differential value $\Delta V$, which is the difference in voltage variation VA (parameter variation amount) between the target cell to be monitored for abnormality and two or more different battery cells 13, as a first differential value. The preliminary determination unit 64 performs a provisional determination of the presence or absence of abnormality in each battery cell 13, for each battery cell group G1 to Gn, based on the voltage differential value $\Delta V$ calculated by the first differential value calculation unit 63.

The second differential value calculation unit 65, among the battery cell groups G1 to Gn, in those cell groups that have been provisionally determined as abnormal by the preliminary determination unit 64, designates the battery cell 13 adjacent to the target cell on the negative electrode side as the first adjacent cell and the battery cell 13 adjacent to the target cell on the positive electrode side as the second adjacent cell. The variation difference values between each of these adjacent cells and the target cell are calculated as the first differential value and the second differential value, respectively, by subtracting in ascending or descending order of the cell serial sequence. A difference between the first differential value and the second differential value is then calculated as a second differential value $\Delta\Delta V$. The procedures for calculating the voltage differential value $\Delta V$ and the second differential value $\Delta\Delta V$ are as explained in FIG. 8. The abnormality detection unit 66 determines that a predetermined deviation indicating a cell abnormality has occurred in the target cell when the second differential value $\Delta\Delta V$ exceeds a predetermined threshold.

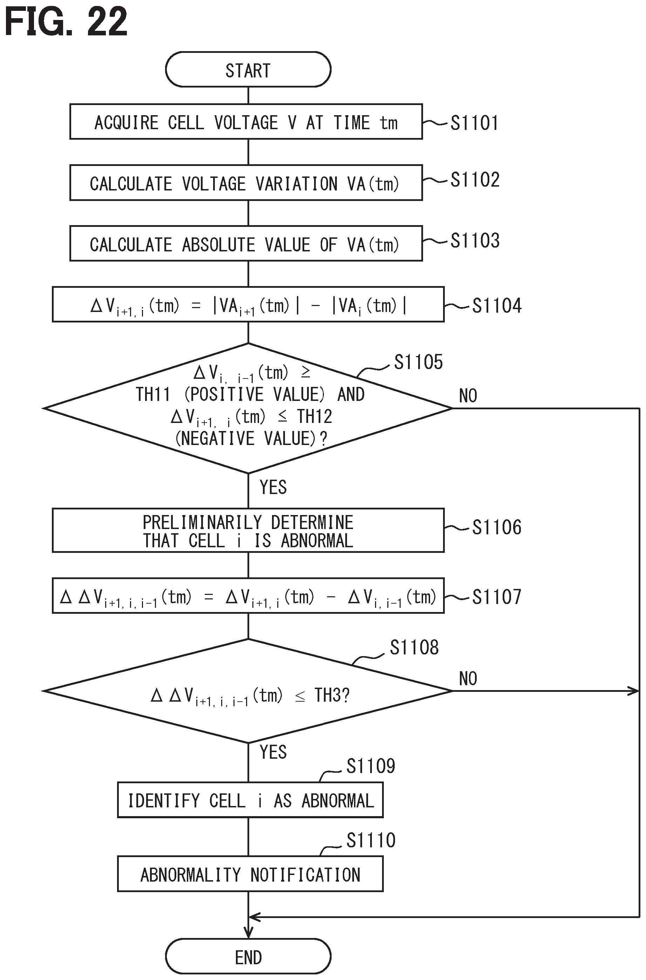

FIG. 22 is a flowchart illustrating the procedure for the abnormality detection processing of the battery cell 13 in the present embodiment, and this processing is executed by the battery ECU 20. In the abnormality detection processing of FIG. 22, as the preliminary abnormality determination process, the process described in FIG. 5, namely, the process for provisionally determining abnormalities in each battery cell 13 based on the voltage differential value $\Delta V$ of the battery cell 13, is executed. In addition, as the final abnormality determination process, the process described in FIG. 9, namely, the process for finally determining abnormalities in each battery cell 13 based on the second differential value $\Delta\Delta V$ of the battery cell 13, is executed. Below, the procedure of FIG. 22 will be explained while indicating the correspondence between the abnormality detection processing of FIG. 5 and the abnormality detection processing of FIG. 9.

In FIG. 22, in steps S1101 and S1102, the cell voltage V(tm) of each battery cell 13 is acquired, and for each battery cell 13, the voltage variation VA(tm), which is the change amount in the cell voltage V(tm) from the initial value (voltage initial value), is calculated (VA(tm) = V(tm) - initial value). In steps S1103 and S1104, the absolute value of the voltage variation VA(tm) is calculated, and for all battery cells 13, a difference in the absolute values of the voltage variation VA(tm) between each pair of adjacent battery cells 13 in the series path is calculated as a voltage difference value $\Delta V_{i+1,i}(tm)$. Thereafter, in step S1105, each battery cell 13 (cells C1 to Cn) is successively designated as a target cell, and for each target cell, the voltage differential values $\Delta V_{i,i-1}(tm)$ and $\Delta V_{i+1,i}(tm)$ are compared with a predetermined threshold value. The above steps S1101 to S1105 are the same processes as steps S101 to S105 in FIG. 5.

Then, in the battery cell group currently targeted for detection, when step S1105 is negated for all battery cells 13, the abnormality detection process is terminated at this point in order to discontinue processing for the current battery cell group. Further, in the battery cell group currently targeted for detection, when step S1105 is affirmed for any of the battery cells 13, the process proceeds to step S1106. In step S1106, the provisional determination is made that an abnormality has occurred in the battery cell 13 for which the condition in step S1105 was satisfied.

Subsequently, in step S1107, the difference between the two voltage difference values ΔVi+1,i(tm) and ΔVi,i-1(tm), which are adjacent in the series arrangement of battery cells 13, is calculated as the second-order difference value ΔΔVi+1,i,i-1(tm). In step S1108, it is determined whether the second-order difference value ΔΔVi+1,i,i-1(tm) is equal to or less than the predetermined negative threshold TH3. Then, when step S1108 is affirmed, the process proceeds to step S1109.

In step S1109, it is determined that an abnormality has occurred in the battery cell 13 for which the condition in step S1108 was satisfied. In other words, it is determined that a predetermined deviation has occurred in the voltage variation VA(tm) of the target cell relative to the other battery cells 13. The determination result of step S1109 corresponds to the result of this determination. Thereafter, in step S1110, notification of the occurrence of an abnormality is made. The above steps S1107 to S1110 are the same processes as steps S305, S306, S308, and S309 in FIG. 9.

In the present embodiment described above, the abnormality determination is performed in two stages when detecting abnormalities in each battery cell 13. For each battery cell group, the provisional determination of cell abnormality is made based on the voltage difference value ΔV (single difference value). Then, among the battery cell groups, for those provisionally determined to be abnormal, the final determination is made for the battery cell 13 based on the double difference value ΔΔV, determining that a predetermined deviation has occurred. Here, when comparing the abnormality determination based on the voltage difference value ΔV (provisional determination) and abnormality determination based on the double difference value ΔΔV (final determination), the computational load required for the abnormality detection and the detection accuracy differ for each. In the abnormality determination based on the double difference value ΔΔV, as already explained with reference to FIG. 8, the computational load becomes higher. However, because abnormal cells can be clearly identified, cell abnormalities can be detected with high accuracy.

Further, in the present embodiment, in the first stage (provisional determination), abnormality determination with low computational load is performed in consideration of the large number of battery cell groups to be subjected to abnormality determination, and in the second stage (final determination), the accuracy of abnormality determination can be enhanced. In this case, abnormalities do not necessarily occur simultaneously in all battery cell groups (battery modules 11) within the battery pack B. Rather, appropriate abnormality detection can be performed sequentially, starting from the battery cell group that includes the battery cell 13 in which an abnormality has occurred.

It should be noted that, in the present embodiment, the processes of provisional abnormality determination and final abnormality determination are combined such that the processing loads required for parameter calculation and other operations differ. The former process may be a relatively low-load process, while the latter process may be a relatively high-load process. More specifically, as the processing for provisional abnormality determination, the processing described in FIG. 5, namely, the processing that provisionally determines abnormalities in each battery cell 13 based on the voltage difference value ΔV of the battery cell 13, is executed. As the processing for final abnormality determination, any one of the following processes may be used: (1) the processing described in FIG. 6, namely, the processing that performs abnormality detection of battery cell 13 based on the differential integrated value QA, which is obtained by integrating the voltage difference value ΔV of battery cell 13; (2) the processing described in FIG. 9, namely, the processing that performs abnormality detection of battery cell 13 based on the second-order differential value ΔΔV of the battery cell 13; or (3) the processing described in FIG. 10, namely, the processing that performs abnormality detection of battery cell 13 based on the integrated second-order differential value QB, which is obtained by integrating the second-order differential value ΔΔV of battery cell 13.

Alternatively, as the processing for provisional abnormality determination, in the case where the processing described in FIG. 5, namely, the processing that provisionally determines abnormalities in each battery cell 13 based on the voltage difference value ΔV of battery cell 13, is executed, the processing for final abnormality determination may be any one of the following: (1) the processing described in FIG. 11, namely, the processing that calculates the degree of deviation Ri of the voltage variation VA of a target cell among the battery cells 13, using as a reference the average value of the voltage variations VA of the remaining battery cells 13 excluding the target cell, and detects abnormalities in battery cell 13 based on this degree of deviation Ri; (2) the processing described in FIG. 12, namely, the processing that integrates the degree of deviation of the voltage variation VA of the target cell each time the degree of deviation is calculated, thereby obtaining an integrated deviation value QCi, and detects abnormalities in battery cell 13 based on this integrated deviation value QCi; (3) the processing described in FIG. 13, namely, the processing that integrates the deviation Di of the voltage variation VA of each battery cell 13 to calculate an integrated deviation value QDi, and detects abnormalities in battery cell 13 based on this integrated deviation value QDi; (4) the processing described in FIGS. 14 and 15, namely, the processing that calculates the standard deviation σAi of the double differential value ΔΔV for each battery cell 13, then calculates the degree of deviation RAi from this standard deviation σAi, and detects abnormalities in battery cell 13 based on the degree of deviation RAi; or (5) the processing described in FIG. 16, namely, the processing that integrates the degree of deviation RAi to calculate an integrated deviation value QEi, and detects abnormalities in battery cell 13 based on this integrated deviation value QEi.

Eighth Embodiment

In an eighth embodiment, an abnormality detection unit for detecting abnormalities in each battery cell 13 is provided with a first determination unit that determines whether a predetermined deviation has occurred in ae target cell based on a voltage differential value ΔV, which is a single differential value of the voltage variation VA. The abnormality detection unit is also provided with a second determination unit that determines whether a predetermined deviation has occurred in the target cell based on a double differential value ΔΔV, which is a difference between the voltage differential values ΔV of two cells. These first and second determination units are selectively used based on predetermined switching conditions. In the present embodiment, abnormality determination for each battery cell 13 based on the voltage differential value ΔV of battery cell 13 is defined as a first determination process, and abnormality determination for each battery cell 13 based on the double differential value ΔΔV of battery cell 13 is defined as a second determination process.

Abnormality determination for each battery cell 13 based on the voltage differential value ΔV of battery cell 13 corresponds to a process for detecting abnormalities in each battery cell 13 through low-load computational processing with a relatively small computational burden (first abnormality detection unit). In addition, abnormality determination for each battery cell 13 based on the double differential value ΔΔV of battery cell 13 corresponds to a process for detecting abnormalities in each battery cell 13 through high-load computational processing with a relatively large computational burden (second abnormality detection unit). Then, the processing of each of these abnormality detections is switched based on predetermined switching conditions (switching execution unit).

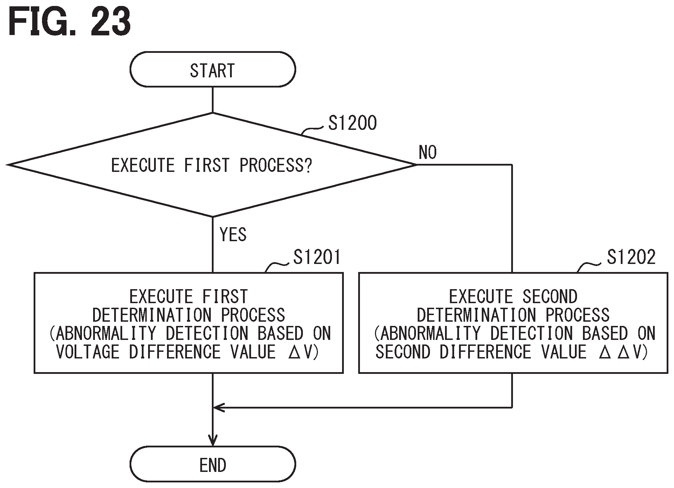

FIG. 23 is a flowchart showing the procedure of abnormality detection processing for battery cell 13 in the present embodiment, and this processing is executed by the battery ECU 20.

In FIG. 23, at step S1200, it is determined, based on predetermined switching conditions, whether to execute the first determination process or the second determination process. The determination in step S1200 may be performed as follows.

The battery ECU 20 determines, for the battery module 11 currently being targeted for detection, whether abnormality determination for each battery cell 13 based on the voltage difference value ΔV has already been executed, and whether any cell has been determined as abnormal by that determination. When none of the cells has been determined as abnormal based on the voltage difference value ΔV, the determination in step S1200 is affirmative and the process proceeds to step S1201. When any abnormality has been determined based on the voltage difference value ΔV, the determination in step S1200 is negative and the process proceeds to step S1202. In this case, the determination of abnormality based on the voltage difference value ΔV corresponds to the switching condition for transitioning from the first determination process to the second determination process.

Alternatively, it is also possible for the battery ECU 20 to determine that deterioration has occurred in each battery cell 13 of the battery module 11, or that there is a high possibility of deterioration occurring (deterioration determination unit), and to use the result of this determination as the switching condition. In this case, the determination that deterioration has occurred in each battery cell 13, or that there is a high possibility of deterioration occurring, corresponds to the switching condition for transitioning from the first determination process to the second determination process.

It is preferable that the determination of whether deterioration has occurred in each battery cell 13, or whether there is a high possibility of deterioration occurring, be made based on the SOH (State of Health) of the battery cell 13, for example. The SOH [%] of the battery cell 13 is preferably calculated as a ratio of an actual full charge capacity Cf [Ah] of the battery cell 13 to a reference full charge capacity Cf0 [Ah] of the battery cell 13 (SOH = Cf / Cf0). In this case, it is preferable that when the SOH is smaller than a predetermined value, an abnormality determination is made by the first determination process, and when the SOH is greater than the predetermined value, an abnormality determination is made by the second determination process.

It is also possible to determine whether deterioration has occurred in each battery cell 13, or whether there is a high possibility of deterioration occurring, based on the number of years of use since the vehicle was manufactured or the vehicle's mileage. For example, when the number of years of vehicle use exceeds five years, or when the mileage exceeds 100,000 km, it is determined that deterioration has occurred in each battery cell 13, or that there is a high possibility of deterioration occurring.

Furthermore, when the battery cell 13 is in a predetermined low temperature state (for example, below 10 degrees Celsius), lithium precipitates on the electrode, causing deterioration of the battery cell 13 to progress. Therefore, it is also possible to determine whether deterioration has occurred in each battery cell 13, or whether there is a high possibility of deterioration occurring, based on whether the battery cell 13 is in a low temperature state.

In step S1201, abnormality determination for each battery cell 13 is performed based on the voltage difference value ΔV of the battery cell 13. It should be noted that the processing in step S1201 is the same as the processing in steps S101 to S105 and S107 in FIG. 5, and a description thereof will be omitted here.

In step S1202, abnormality determination for each battery cell 13 is performed based on the second-order difference value ΔΔV of the battery cell 13. It should be noted that the processing in step S1202 is the same as the processing in steps S301 to S306 and S308 in FIG. 9, and a description thereof will be omitted here.

In the present embodiment described above, two types of abnormality determinations can be performed for detecting abnormalities in each battery cell 13, and these abnormality determinations are switched according to predetermined switching conditions. Here, when the battery cell 13 is used over a long period, situations may arise during the usage period in which cell abnormalities are more likely to be detected and situations in which they are less likely to be detected. In this case, by switching the abnormality determination processing according to predetermined switching conditions, it is possible to achieve appropriate abnormality detection while reducing excessive computational load.

Further, in the present embodiment, based on the degree of deterioration of each battery cell 13, switching is performed between the first determination process, which determines cell abnormality based on the voltage difference value $\Delta V$ (single difference value), and the second determination process, which determines cell abnormality based on the double difference value $\Delta\Delta V$. In this case, by performing abnormality detection according to the degree of deterioration of each battery cell 13, it is possible to achieve appropriate abnormality detection while reducing excessive computational load.

In FIG. 23, the combination of the low-load calculation process executed in step S1201 and the high-load calculation process executed in step S1202 may be other than the combination of the process in FIG. 5 and the process in FIG. 9. For example, as the low-load calculation process, any one of the processes shown in FIGS. 5, 6, 9, or 10 may be executed, and as the high-load calculation process, any one of the processes shown in FIGS. 11 to 16 may be executed.

Other Embodiments

The above embodiments may be modified as follows, for example.

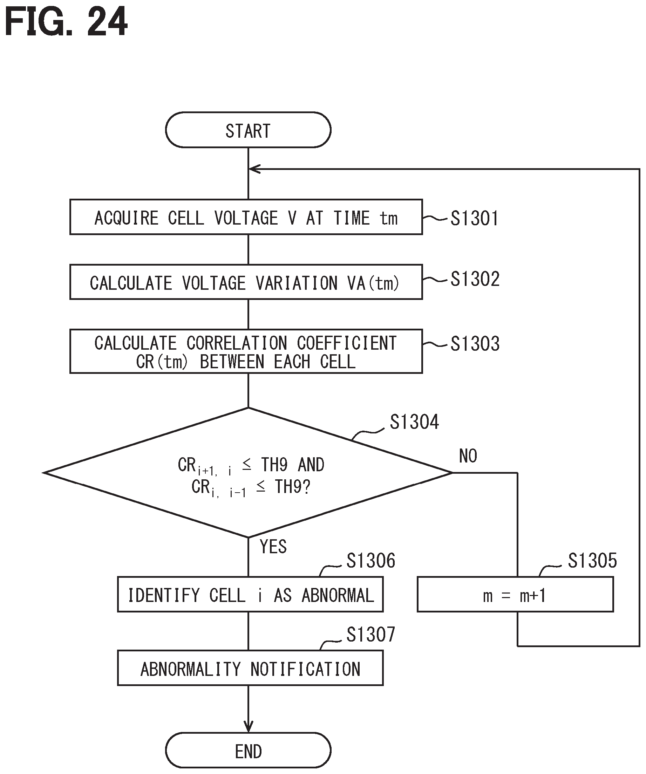

As an abnormality detection process for the battery cell 13, it is also possible for the battery ECU 20 to execute the process shown in FIG. 24.

In FIG. 24, in step S1301, the cell voltage V(tm) of each battery cell 13 at time point tm is acquired, and in step S1302, for each battery cell 13, the voltage variation VA(tm), which is the change amount in cell voltage from the initial value, is calculated. It should be noted that steps S1301 to S1302 are processes similar to steps S101 to S102 in FIG. 5.

Subsequently, in step S1303, a correlation coefficient CR(tm) between adjacent battery cells 13 in the series path is calculated. The correlation coefficient CR(tm) is an index indicating the strength of the correlation (relationship) between two data sets, and specifically, it may be calculated using the following equation (5).
[Equation 1]

$$CR = \frac{s_{xy}}{s_x s_y} = \frac{\sum_{j=1}^{N}(x_j - \bar{x})(y_j - \bar{y})}{\sqrt{\sum_{j=1}^{N}(x_j - \bar{x})^2 \sum_{j=1}^{N}(y_j - \bar{y})^2}} \quad \cdots (5)$$

In equation (5), for two sets of data (x1, x2, ..., xN) and (y1, y2, ..., yN), the sample covariance is denoted as sxy, and the sample standard deviations are denoted as sx and sy, respectively. The correlation coefficient CR is defined as a ratio of the sample covariance sxy to the product of the sample standard deviations sx and sy.

In step S1303, for the target cell (cell Ci), the voltage variation amounts VA from the present time to the past N instances are used as the data x1, x2, ..., xN. For the first adjacent cell (cell Ci-1) located on the negative side of the target cell, the voltage variation amounts VA from the present time to the past N instances are used as the data y1, y2, ..., yN. The correlation coefficient CRi,i-1(tm) is then calculated. Similarly, for the target cell (cell Ci), the voltage variation amounts VA from the present time to the past N instances are used as the data x1, x2, ..., xN. For the second adjacent cell (cell Ci+1) located on the positive side of the target cell, the voltage variation amounts VA from the present time to the past N instances are used as the data y1, y2, ..., yN. The correlation coefficient CRi+1,i(tm) is then calculated. At this time, in the combination of the target cell and the adjacent cell, when the target cell is an abnormal cell, the correlation between these two cells becomes weak, that is, the correlation coefficient CR(tm) becomes smaller. As a result, it becomes possible to determine whether the cell is an abnormal cell.

Thereafter, in step S1304, it is determined whether the correlation coefficients CRi+1,i(tm) and CRi,i-1(tm) are each equal to or less than a predetermined threshold value TH9. The threshold value TH9 is a value greater than 0 and less than 1.

Then, when there is no battery cell 13 for which both correlation coefficients CRi+1,i(tm) and CRi,i-1(tm) are equal to or less than the threshold value TH9, step S1304 is negated, "m" is incremented by 1 in step S1305, and the process returns to step S1301. In addition, when any one of the battery cells 13 among all the battery cells 13 meets a condition that both correlation coefficients CRi+1,i(tm) and CRi,i-1(tm) are equal to or less than the threshold value TH9, step S1304 is affirmed and the process proceeds to step S1306. In step S1306, it is determined that an abnormality has occurred in the battery cell 13 for which the condition in step S1304 has been satisfied. Thereafter, in step S1307, notification of the occurrence of the abnormality is provided.

When any of the battery cells 13 in the battery module 11 is an abnormal cell, a difference will arise between the correlation coefficient CR(tm) calculated from the voltage variations VA(tm) of two normal cells and the correlation coefficient CR(tm) calculated from the voltage variations VA(tm) of two cells including the abnormal cell. Therefore, it is possible to accurately detect abnormalities in the target cell.

In the above embodiment, the configuration is such that the voltage variation VA(tm) for each battery cell 13 is calculated as the change amount in cell voltage V(tm) from the initial value, but this may be modified. For example, a configuration may be such that the change amount of cell voltage V(tm) within a predetermined time cycle, that is, a time rate of change of the voltage variation VA(tm), is calculated as the voltage variation VA(tm). In this case, the change amount in cell voltage V(tm) per unit time, that is, a slope of cell voltage V(tm) along the time axis, may be calculated as the voltage variation VA(tm).

In the above embodiment, the cell voltage V(tm) detected by the voltage sensor 31 is used as the state parameter of the battery cell 13, but this may be modified. For example, a temperature sensor may be provided for each battery cell 13 in the battery module 11, and the cell temperature detected by each temperature sensor may be used as the state parameter. In this case, the change amount in the cell temperature of each battery cell 13 over a predetermined period may be calculated as a temperature change amount (parameter change amount), and it is preferable to detect an abnormality in the target cell based on whether a predetermined deviation has occurred in the temperature change amount of the target cell compared to the other battery cells 13. The specific abnormality detection method may be the same as the methods in the above embodiments. **It** is also possible to provide a strain sensor for detecting strain occurring in each battery cell 13 and a pressure sensor for detecting an internal pressure of the battery cell 13 in each battery cell 13 of the battery module 11, and to use the detection values (state detection values) of these sensors as state parameters.

It is also possible to use, as a state parameter, a state calculated value that is calculated based on state detection values such as cell voltage or cell temperature, and that indicates the state of the battery cell 13. More specifically, an impedance of each battery cell 13 is calculated based on the cell voltage and the conduction electric current of each battery cell 13. Then, the change in impedance of each battery cell 13 over a predetermined period is calculated as an impedance change amount (parameter change amount), and it is preferable to detect an abnormality in the target cell based on whether a predetermined deviation in impedance change amount has occurred in the target cell compared to the other battery cells 13. The specific abnormality detection method may be the same as the methods in the above embodiments.

It is also possible to adopt a configuration in which a State of Charge (SOC) as a state parameter is calculated based on the cell voltage and conduction electric current of each battery cell 13, and abnormalities in the battery cells 13 are detected based on the change in SOC over a predetermined period. Alternatively, the impedance may be calculated based on the temperature detection values from the temperature sensors of each battery cell 13, and this impedance may be used as the state parameter. In the battery module 11, it is also possible to provide a current sensor for each battery cell 13 to detect the current flowing through each cell, and to calculate the cell temperature as a state parameter based on the amount of current supplied to each battery cell 13.

In the above third embodiment, the degree of deviation Ri(tm) of the voltage variation VA(tm) in each battery cell 13 is calculated as the ratio of the absolute value of the difference between the voltage variation VAi(tm) and the average value $\mu i(tm)$ to the standard deviation $\sigma i(tm)$. However, this may be modified. For example, the deviation of the voltage variation VAi(tm), that is, a difference between the voltage variation VAi(tm) of the target cell and the average value $\mu i(tm)$ of the voltage variations VAi(tm) of each battery cell 13, may be used as the degree of deviation Ri(tm).

In this case, it is preferable for the battery ECU 20 to calculate the average value $\mu i(tm)$ of the voltage variations VAi(tm) of the remaining battery cells 13 excluding the target cell among the battery cells 13, and to calculate the deviation between this average value $\mu i(tm)$ and the voltage variation VAi(tm) of the target cell as the degree of deviation Ri(tm).

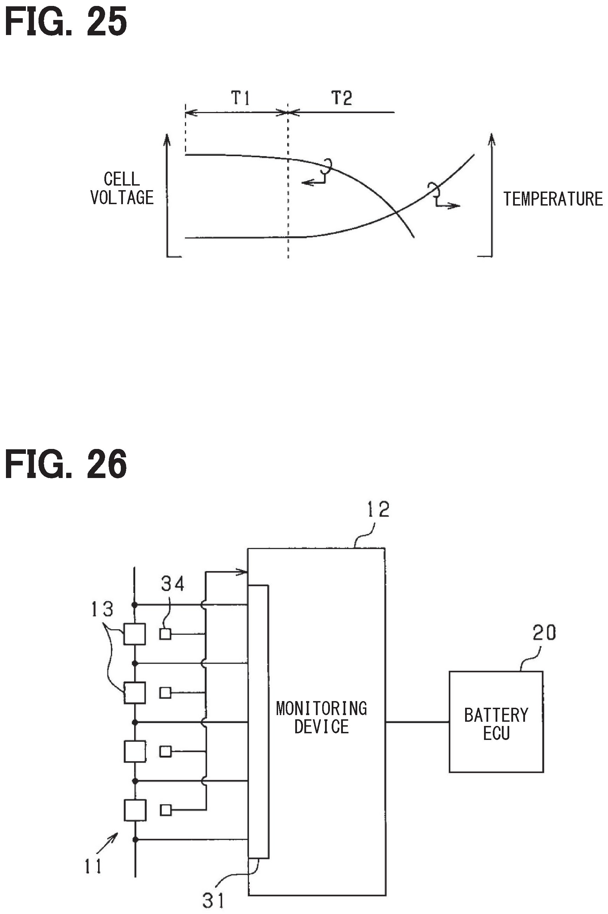

In a thermal runaway process of the battery cell 13, during the initial stage, which is the internal short-circuit phase, the cell voltage gradually changes in the initial period of the internal short-circuit phase due to changes in the internal short-circuit resistance of the battery cell 13, and in the subsequent period following the initial period, the cell temperature (internal temperature) gradually increases. FIG. 25 shows the changes in cell voltage and cell temperature during the initial period T1 and the subsequent period T2 in the internal short-circuit phase. In consideration of these changes in cell voltage and cell temperature, it is possible to detect abnormalities in the battery cell 13 based on the change amount in cell voltage during the initial period T1, and to detect abnormalities in the battery cell 13 based on the change amount in cell temperature during the subsequent period T2.

FIG. 26 shows an example configuration of the battery system. A voltage sensor 31 is connected to each battery cell 13 of the battery module 11. In addition, a temperature sensor 34 is provided for each battery cell 13, and the detection signals from each temperature sensor 34 are input to the monitoring device 12. The voltage sensor 31 corresponds to a first sensor, and the temperature sensor 34 corresponds to a second sensor.

The battery ECU 20 calculates the voltage variation VA (first parameter variation), which is the change amount in cell voltage over a predetermined period as detected by the voltage sensor 31, and also calculates the temperature variation TA (second parameter variation), which is the change amount in cell temperature over a predetermined period as detected by the temperature sensor 34. Additionally, the battery ECU 20 is capable of executing a first abnormality detection process that detects abnormalities in the target cell based on the voltage variation VA of each battery cell 13, and a second abnormality detection process that detects abnormalities in the target cell based on the temperature variation TA of each battery cell 13. The second abnormality detection process is executed on the condition that an abnormality in the target cell has been detected by the first abnormality detection process.

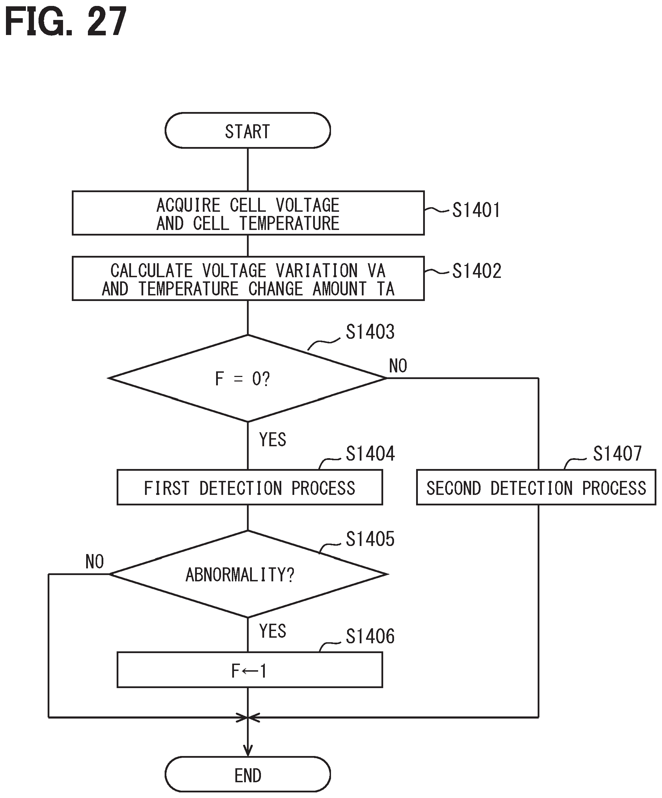

FIG. 27 is a flowchart showing the procedure for abnormality detection processing of the battery cell 13, and this processing is executed by the battery ECU 20.

In FIG. 27, in step S1401, the cell voltage of each battery cell 13 detected by the voltage sensor 31 and the cell temperature of each battery cell 13 detected by the temperature sensor 34 are acquired as state detection values. The cell voltage and the cell temperature are acquired at predetermined intervals. In step S1402, for each battery cell 13, the change in cell voltage from the initial value is calculated as a voltage variation VA(tm), and the change in cell temperature from the initial value is calculated as a temperature variation TA(tm). The initial value may be set at any arbitrarily predetermined timing.

In step S1403, it is determined whether an abnormality flag F is 0 or not. The abnormality flag F is a flag indicating whether any of the battery cells 13 has been determined to be abnormal in the first abnormality detection process. The abnormality flag F is set to 0 when there is no abnormality, and to 1 when there is an abnormality.

When step S1403 is affirmed, the process proceeds to step S1404. In step S1404, the first abnormality detection process is executed. In the first abnormality detection process, abnormality detection of the target cell is performed based on the voltage variation VA(tm) of each battery cell 13. In the first abnormality detection process, it is preferable that a process conforming to any of the abnormality detection processes of the above embodiments is performed. For example, when using the method described in FIG. 5, for all battery cells 13, the difference in absolute values of the voltage variations VA(tm) between two adjacent battery cells 13 in the series path is calculated as the voltage difference value $\Delta Vi+1,i(tm)$. Based on this voltage difference value $\Delta Vi+1,i(tm)$, it is determined whether each battery cell 13 contains an abnormal cell. Then, when it is determined that an abnormal cell is included in any of the battery cells 13, notification of abnormal occurrence or the like is performed.

In step S1405, it is determined whether an abnormal cell has been detected by the first abnormality detection process, and when no abnormal cell is detected, the process is terminated as is. In this case, the first abnormality detection process is repeatedly executed at predetermined intervals. When an abnormal cell is detected, the process proceeds to step S1406, where a value of 1 is set in the abnormality flag F.

After a value of 1 is set in the abnormality flag F, the determination in step S1403 becomes negative, and the process proceeds to step S1407. In step S1407, the second abnormality detection process is executed. In the second abnormality detection process, abnormality detection of the target cell is performed based on the temperature change amount TA(tm) of each battery cell 13. In the second abnormality detection process, it is preferable that a process conforming to any of the abnormality detection processes described in the above embodiments is performed. For example, when using the method described in FIG. 5, it is preferable to replace the voltage variation VA(tm) with the temperature change amount TA(tm) and execute the process accordingly. In this case, for all battery cells 13, a difference in absolute values of the temperature change amounts TA(tm) between two adjacent battery cells 13 in the series path is calculated as a temperature difference value $\Delta Ti+1,i(tm)$. Based on this temperature difference value $\Delta Ti+1,i(tm)$, it is determined whether any of the battery cells 13 contains an abnormal cell. Then, when it is determined that an abnormal cell is included in any of the battery cells 13, notification of abnormal occurrence or the like is performed.

According to the above configuration, it is possible to appropriately detect signs of thermal runaway in the battery cells 13 in a stepwise manner while taking into account changes in the state of the battery cells 13. It is also possible to use a strain sensor or a pressure sensor instead of the temperature sensor 34. The strain sensor is provided for each battery cell 13 and, for example, detects the strain of a case of the battery cell 13. In this case, the strain detection value detected by the strain sensor is used as a state detection value, and abnormalities in each battery cell 13 are detected based on a change amount in the strain detection value. Alternatively, a pressure sensor may be provided for each battery cell 13 to detect, for example, the pressure inside the case of the battery cell 13. In this case, a pressure detection value detected by the pressure sensor is used as a state detection value, and abnormalities in each battery cell 13 are detected based on a change amount in the pressure detection value.

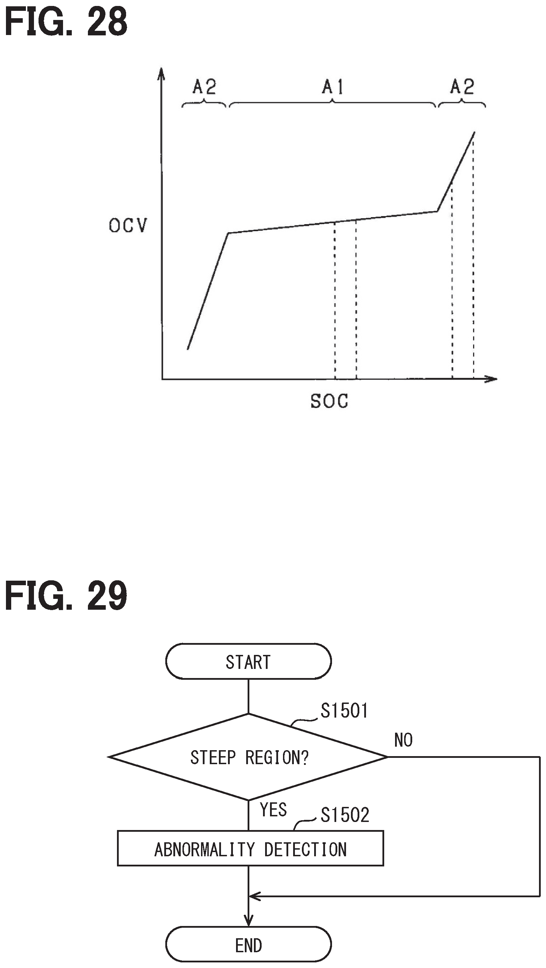

FIG. 28 is a diagram showing the voltage-capacity characteristic, which is the relationship between the voltage (OCV) and the electric capacity (SOC) in the battery cell 13. This voltage-capacity characteristic includes a flat plateau region A1 and a steep region A2, in which the voltage changes with respect to the electric capacity are steeper than in the plateau region A1. The steep region A2 is present on both a low SOC side and a high SOC side relative to the plateau region A1. For example, when the battery cell 13 is in a fully charged state, the SOC of the battery cell 13 enters the steep region A2 on the high SOC side.

Here, when comparing a case where the SOC is within the plateau region A1 to a case where the SOC is within the steep region A2, the voltage variation with respect to changes in SOC becomes larger in the steep region A2 than in the plateau region A1. Therefore, under circumstances where the battery module 11 contains an abnormal cell, it is considered that the difference in the voltage variation VA between the normal cell and the abnormal cell becomes even larger when the SOC is within the steep region A2. For example, when each battery cell 13 in the battery module 11 (battery pack B) is charged to a fully charged state, when the battery module 11 contains an abnormal cell, the difference in the amount of voltage change VA between the abnormal cell and the normal cell becomes pronounced, thereby improving the accuracy of abnormality detection. In view of this point, it is preferable to perform abnormality detection based on the voltage variation VA (parameter change amount), on a condition that the SOC of each battery cell 13 is within the steep region.

FIG. 29 is a flowchart showing the procedure for abnormality detection processing of the battery cell 13, and this processing is executed by the battery ECU 20. In FIG. 29, in step S1501, it is determined whether the SOC of the battery cell 13 has entered the steep region A2. At this time, for example, step S1501 is affirmed when the SOC of all battery cells 13 in the battery module 11 has entered the steep region A2.

Then, when step S1501 is affirmed, the process advances to step S1502, in which abnormality detection for each battery cell 13 is performed. In this abnormality detection, it is preferable that processing conforming to any of the abnormality detection procedures described in the above embodiments is carried out. For example, when using the method described in FIG. 5, for all battery cells 13, the difference in absolute values of the voltage variations VA(tm) between two adjacent battery cells 13 in the series path is calculated as the voltage difference value $\Delta V_{i+1,i}(tm)$. Based on this voltage difference value $\Delta V_{i+1,i}(tm)$, it is determined whether each battery cell 13 contains an abnormal cell. Then, when it is determined that an abnormal cell is included in any of the battery cells 13, notification of abnormal occurrence or the like is performed.

It is also possible to perform abnormality detection for each battery cell 13 both when the SOC of the battery cell 13 enters the plateau region A1 and when the SOC of the battery cell 13 enters the steep region A2. In this case, for each battery cell 13, it is possible to adopt a configuration in which the threshold value (such as TH11, TH12, etc.) for abnormality detection of the voltage difference value $\Delta V$ is changed according to whether the SOC is in the plateau region A1 or in the steep region A2, taking into consideration that the voltage variation corresponding to SOC change differs depending on whether the SOC is in the plateau region A1 or the steep region A2. For example, when the SOC is in the steep region A2, it is preferable to set the positive-side threshold TH11 larger in the positive direction and the negative-side threshold TH12 larger in the negative direction, compared to when the SOC is in the plateau region A1.

In the above embodiments, for the target cell, the differences in the voltage variation VA(tm) with respect to two different battery cells 13 are each calculated as a voltage difference value $\Delta V(tm)$. However, this may be modified such that differences in the voltage variation VA(tm) with respect to three or four different battery cells 13 are each calculated as the voltage difference value $\Delta V(tm)$. In this case, it is preferable to determine whether a predetermined deviation has occurred in the target cell based on the voltage difference values $\Delta V(tm)$ with other cells, which are calculated using three or four different combinations. In this case, by increasing the number of combinations used to calculate the voltage difference value $\Delta V(tm)$, the reliability of abnormality detection can be enhanced.

In the above embodiment, the battery ECU 20 is used as the battery state detection device. However, this configuration may be modified. For example, it is also possible to use the monitoring devices 12 of each battery unit 10 as the battery state detection device, or to use a device external to the vehicle as the battery state detection device.

The battery unit 10 in each of the above embodiments can also be applied not only to mobile bodies such as vehicles and aircraft, but also to stationary battery systems.

The control apparatus and the technique according to the present disclosure may be achieved by a dedicated computer provided by constituting a processor and a memory programmed to execute one or more functions embodied by a computer program. Alternatively, the control apparatus and the technique according to the present disclosure may be achieved by a dedicated computer provided by constituting a processor with one or more dedicated hardware logic circuits. Alternatively, the control apparatus and the technique according to the present disclosure may be achieved using one or more dedicated computers constituted by a combination of the processor and the memory programmed to execute one or more functions and the processor with one or more hardware logic circuits. Furthermore, the computer program may be stored on a computer-readable non-transitory tangible recording medium as instructions executed by a computer.

The technical ideas extracted from the above-described embodiments will be described below.

Configuration 1

A battery state detection device (20), applicable to a battery system including a battery module (11) having battery cells (13) connected in series, wherein a state of each battery cell is detected by a state detection unit, the battery state detection device comprising:

an acquisition unit configured to acquire state detection values of the respective battery cells detected by the state detection unit;

a parameter change amount calculation unit configured to:

use, as a state parameter of each battery cell, either a state detection value acquired by the acquisition unit or a state calculation value, the state calculation value being calculated based on the state detection value and

25

indicating the state of the battery cell; and
calculate, as a parameter change amount, a change in the state parameter over a predetermined period; and

an abnormality detection unit configured to:

sequentially set each of the battery cells, one by one, as a target cell for abnormality detection; and

detect an abnormality of the target cell based on whether a predetermined deviation occurs in the parameter change amount of the target cell relative to the parameter change amount of another of the battery cells.

Configuration 2

The battery state detection device according to configuration 1, further comprising:
a difference value calculation unit configured to calculate, for the target cell, difference values in the parameter change amount between the target cell and each of at least two different battery cells, wherein the abnormality detection unit is configured to:

determine whether the predetermined deviation occurs in the target cell based on the change amount difference values calculated by the difference value calculation unit; and
detect an abnormality of the target cell based on the determination result.

Configuration 3

The battery state detection device according to configuration 2, wherein

the difference value calculation unit is configured to:

calculate, as a first difference value, a change amount difference value between the target cell and a first non-target cell, which is a battery cell different from the target cell in the battery module; and
calculate, as a second difference value, a change amount difference value between the target cell and a second non-target cell, which is a battery cell different from the target cell and the first non-target cell in the battery module, and

the abnormality detection unit is configured to determine that the predetermined deviation occurs in the target cell when both an absolute value of the first difference value and an absolute value of the second difference value are greater than a predetermined threshold.

Configuration 4

The battery state detection device according to configuration 2, wherein

the difference value calculation unit is configured to, at a predetermined cycle:

calculate, as a first difference value, a change amount difference value between the target cell and a first non-target cell, which is a battery cell different from the target cell in the battery module;
calculate, as a second difference value, a change amount difference value between the target cell and a second non-target cell, which is a battery cell different from the target cell and the first non-target cell in the battery module;
accumulate, as a first accumulated difference value, an absolute value of the first difference value each time the first difference value is calculated; and
accumulate, as a second accumulated difference value, an absolute value of the second difference value each time the second difference value is calculated, and

the abnormality detection unit is configured to determine that the predetermined deviation occurs in the target cell when both the first accumulated difference value and the second accumulated difference value are greater than a predetermined threshold.

Configuration 5

The battery state detection device according to configuration 2, wherein

a battery cell adjacent to a negative electrode side of the target cell is a first adjacent cell,
a battery cell adjacent to a positive electrode side of the target cell is a second adjacent cell,
the difference value calculation unit is configured to:

calculate, as a first difference value and a second difference value, respectively, change amount difference values between each adjacent cell and the target cell by subtraction in either ascending or descending order of cell series arrangement, in the same direction for both adjacent cells; and
calculate, as a second-order difference value, a difference between the first difference value and the second difference value, and

the abnormality detection unit is configured to determine that the predetermined deviation occurs in the target cell when the second-order difference value is greater than a predetermined threshold.

Configuration 6

The battery state detection device according to configuration 2, wherein

a battery cell adjacent to a negative electrode side of the target cell is a first adjacent cell,
a battery cell adjacent to a positive electrode side of the target cell is a second adjacent cell,
the difference value calculation unit is configured to:

calculate, as a first difference value and a second difference value, respectively, change amount difference values between each adjacent cell and the target cell by subtraction in ascending or descending order of cell series arrangement, in the same direction for both adjacent cells;
calculate, as a second-order difference value, a difference between the first difference value and the second difference value; and
accumulate, as a second-order accumulated difference value, the second-order difference value each time the second-order difference value is calculated, and

the abnormality detection unit is configured to determine that the predetermined deviation occurs in the target cell when the second-order accumulated difference value is greater than a predetermined threshold.

Configuration 7

The battery state detection device according to configuration 2, wherein

the battery system includes battery cell groups, each constituted by three or more battery cells connected in series with each other,
the battery state detection device further comprising:

a first difference value calculation unit configured to calculate, for the target cell, difference values in the parameter change amount between the target cell and each of at least two different battery cells, as first difference values, for each battery cell group;
a provisional abnormality determination unit configured to preliminarily determine, for each battery cell group, the presence or absence of an abnormality among the battery cells in each battery cell group based on the first difference values; and
a second difference value calculation unit, for a battery cell group preliminarily determined to have an abnormality by the provisional abnormality determination unit, configured to:

calculate, as a first difference value and a second difference value, respectively, change amount difference values between a first adjacent cell, which is a battery cell adjacent to the negative electrode side of the target cell, and the target cell, and between a second adjacent cell, which is a battery cell adjacent to the positive electrode side of the target cell, and the target cell, by subtraction in ascending or descending order of cell series arrangement, in the same direction for both adjacent cells; and

calculate, as a second-order difference value, a difference between the first difference value and the second difference value, wherein

the abnormality detection unit is configured to determine whether the predetermined deviation occurs in the target cell based on the second-order difference value calculated by the second difference value calculation unit.

Configuration 8

The battery state detection device according to configuration 2, further comprising:

a first difference value calculation unit configured to calculate, for the target cell, change amount difference values in the parameter change amount between the target cell and each of at least two different battery cells as first difference values;
a second difference value calculation unit configured to:

calculate, as a first difference value and a second difference value, respectively, change amount difference values between a first adjacent cell, which is a battery cell adjacent to the negative electrode side of the target cell, and the target cell, and between a second adjacent cell, which is a battery cell adjacent to the positive electrode side of the target cell, and the target cell, by subtraction in ascending or descending order of cell series arrangement, in the same direction for both adjacent cells; and
calculate, as a second-order difference value, a difference between the first difference value and the second difference value, wherein

the abnormality detection unit includes:

a first determination unit configured to determine whether the predetermined deviation occurs in the target cell based on the first difference values;
a second determination unit configured to determine whether the predetermined deviation occurs in the target cell based on the second-order difference value; and
a switching execution unit configured to switch, based on a predetermined switching condition, whether to detect an abnormality of the target cell according to a determination result of the first determination unit or according to a determination result of the second determination unit.

Configuration 9

The battery state detection device according to configuration 8, further comprising:

a degradation determination unit configured to determine whether a situation in which degradation of the respective battery cells has occurred or a situation in which a possibility of degradation is high occurs in the battery module, wherein
the switching execution unit is configured to:

use a determination result by the degradation determination unit as the predetermined switching condition; and
detect an abnormality of the target cell according to the determination result of the second determination unit when it is determined that a situation in which degradation of the respective battery cells has occurred or a situation in which a possibility of degradation is high occurs.

Configuration 10

The battery state detection device according to configuration 1, further comprising:

a degree-of-deviation calculation unit configured to calculate, as a degree of deviation, the degree to which the parameter change amount of the target cell deviates from an average value of parameter change amounts of the battery cells in the battery module, wherein
the abnormality detection unit is configured to:

determine whether the predetermined deviation occurs in the target cell based on the degree of deviation calculated by the degree-of-deviation calculation unit; and

detect an abnormality of the target cell based on a result of the determination, and

the degree-of-deviation calculation unit is configured to calculate the degree to which the parameter change amount of the target cell deviates from an average value of parameter change amounts of the remaining battery cells excluding the target cell among the battery cells.

Configuration 11

The battery state detection device according to configuration 1, further comprising:

a degree-of-deviation calculation unit configured to:

calculate, at each predetermined cycle, a degree of deviation of the parameter change amount of the target cell relative to an average value of parameter change amounts of the battery cells in the battery module; and accumulate, as an accumulated degree-of-deviation value, the degree of deviation each time the degree of deviation is calculated, wherein

the abnormality detection unit is configured to:

determine whether the predetermined deviation occurs in the target cell based on the accumulated degree-of-deviation value calculated by the degree-of-deviation calculation unit; and detect an abnormality of the target cell based on a result of the determination, and

the degree-of-deviation calculation unit is configured to calculate the degree to which the parameter change amount of the target cell deviates from an average value of parameter change amounts of the remaining battery cells excluding the target cell among the battery cells.

Configuration 12

The battery state detection device according to configuration 1, further comprising:

a deviation calculation unit configured to calculate, as a deviation, a difference between the parameter change amount of the target cell and an average value of parameter change amounts of the battery cells; a standard deviation calculation unit configured to calculate a standard deviation by taking a square root of a mean of the squares of differences between parameter change amounts of the battery cells and the average value; and an accumulated value calculation unit configured to accumulate, as an accumulated deviation value, an absolute value of the deviation each time the deviation is calculated, wherein the abnormality detection unit is configured to determine whether the predetermined deviation occurs in the target cell by comparing the accumulated deviation value calculated by the accumulated value calculation unit with a threshold set based on the standard deviation calculated by the standard deviation calculation unit, the deviation calculation unit is configured to calculate the deviation using an average value of parameter change amounts of the remaining battery cells excluding the target cell, and the standard deviation calculation unit is configured to calculate the standard deviation using parameter change amounts of the remaining battery cells excluding the target cell.

Configuration 13

The battery state detection device according to configuration 1, further comprising:

a difference value calculation unit configured, when a specified cell is designated one by one among the battery cells and a battery cell adjacent to a negative electrode side of the specified cell is a first adjacent cell and a battery cell adjacent to a positive electrode side of the specified cell is a second adjacent cell, to:

calculate, by subtraction in either ascending or descending order of the cell series arrangement, in the same direction for both adjacent cells, difference values in parameter change amount between the specified cell and the first adjacent cell and between the specified cell and the second adjacent cell, respectively, as the first difference value and the second difference value; and calculate a difference between the first difference value and the second difference value as a second-order difference value; and

a degree-of-deviation calculation unit configured to:

set, as a specific second-order difference value, the second-order difference value calculated with the target cell set as the specified cell; and

calculate, as a degree of deviation, a degree to which the specific second-order difference value deviates from an average value of second-order difference values calculated by setting each of the battery cells in the battery module one by one as the specified cell, wherein

the abnormality detection unit is configured to:

determine whether the predetermined deviation occurs in the target cell based on the degree of deviation calculated by the degree-of-deviation calculation unit; and

detect an abnormality of the target cell based on a result of the determination, and

the degree-of-deviation calculation unit is configured to calculate the degree to which the specific second-order difference value deviates from an average value of remaining second-order difference values excluding the specific second-order difference value among the second-order difference values calculated by setting each of the battery cells one by one as the specified cell.

Configuration 14

The battery state detection device according to configuration 1, further comprising:

a difference value calculation unit configured, when a specified cell is designated one by one among the battery cells and a battery cell adjacent to a negative electrode side of the specified cell is a first adjacent cell and a battery cell adjacent to a positive electrode side of the specified cell is a second adjacent cell, to:

calculate, by subtraction in either ascending or descending order of the cell series arrangement, in the same direction for both adjacent cells, difference values in parameter change amount between the specified cell and the first adjacent cell and between the specified cell and the second adjacent cell, respectively, as the first difference value and the second difference value; and

calculate a difference between the first difference value and the second difference value as a second-order difference value, and

a degree-of-deviation calculation unit configured to:

set, as a specific second-order difference value, the second-order difference value calculated with the target cell set as the specified cell; and

calculate, as a degree of deviation, a degree to which the specific second-order difference value deviates from an average value of second-order difference values calculated by setting each of the battery cells in the battery module one by one as the specified cell, wherein

the abnormality detection unit is configured to:

determine whether the predetermined deviation occurs in the target cell based on the degree of deviation calculated by the degree-of-deviation calculation unit; and

detect an abnormality of the target cell based on a result of the determination, and

the degree-of-deviation calculation unit is configured to calculate the degree to which the specific second-order difference value deviates from an average value of remaining second-order difference values, excluding the specific second-order difference value and the second-order difference values calculated by setting each of the first adjacent cell and the second adjacent cell individually as the specified cell among the second-order difference values calculated by setting each of the battery cells one by one as the specified cell.

Configuration 15

The battery state detection device according to any one of configurations 1 to 14, further comprising:

a provisional abnormality determination unit configured to preliminarily determine, as an abnormal cell, a battery cell among the battery cells for which a difference from an average value of parameter change amounts is greater than or equal to a predetermined value, wherein
the abnormality detection unit is configured to sequentially set each abnormal cell preliminarily determined by the provisional abnormality determination unit as the target cell and determine whether the predetermined deviation occurs in the target cell.

Configuration 16

The battery state detection device according to configuration 1, further comprising:

a correlation coefficient calculation unit configured to calculate, for the target cell, correlation coefficients, each serving as a metric indicating strength of correlation of the parameter change amount with respect to at least two different battery cells, wherein
the abnormality detection unit is configured to:

determine whether the predetermined deviation occurs in the target cell based on the correlation coefficients calculated by the correlation coefficient calculation unit; and
detect an abnormality of the target cell based on a result of the determination.

Configuration 17

The battery state detection device according to configuration 1, wherein,

the state detection unit includes a first sensor (31) configured to detect a cell voltage, which is a terminal voltage between terminals of each of the battery cells, and a second sensor (34) configured to detect a temperature, strain, or internal pressure of each of the battery cells;
the acquisition unit is configured to acquire, as the state detection values, the cell voltages of the respective battery cells detected by the first sensor and the temperature, strain, or internal pressure of the respective battery cells detected by the second sensor,
the parameter change amount calculation unit is configured to calculate, as the parameter change amounts, a first parameter change amount based on the cell voltages of the respective battery cells detected by the first sensor and a second parameter change amount based on the temperatures or the strains of the respective battery cells detected by the second sensor, and
the abnormality detection unit is configured to:

perform a first abnormality detection process that detects an abnormality of the target cell based on the first parameter change amount and a second abnormality detection process that detects an abnormality of the target cell based on the second parameter change amount; and
perform the second abnormality detection process on condition that an abnormality of the target cell has been detected by the first abnormality detection process.

Configuration 18

A battery state detection device, applicable to a battery system including a battery module (11) having battery cells (13) connected in series, wherein a state of each battery cell is detected by a state detection unit, the battery state detection device comprising:

a first abnormality detection unit configured to detect abnormalities of the respective battery cells by a calculation process with a relatively small computational load based on state detection values of the respective battery cells detected by the state detection unit;
a second abnormality detection unit configured to detect abnormalities of the respective battery cells by a calculation process with a relatively large computational load based on state detection values of the respective battery cells detected by the state detection unit; and

a switching execution unit configured to switch, based on a predetermined switching condition, whether to detect abnormalities of the respective battery cells by the first abnormality detection unit or by the second abnormality detection unit.

Configuration 19

The battery state detection device according to configuration 18, wherein
the switching execution unit is configured to use, as the predetermined switching condition, that an abnormality is detected by the first abnormality detection unit in any one of the battery cells in the battery module and, upon satisfaction of the switching condition, causes the second abnormality detection unit to perform abnormality detection.

Configuration 20

The battery state detection device according to configuration 18, further comprising:

a degradation determination unit configured to determine whether a situation in which degradation of the respective battery cells has occurred or a situation in which a possibility of degradation is high occurs in the battery module, wherein
the switching execution unit is configured to:

use a determination result by the degradation determination unit as the predetermined switching condition; and cause the second abnormality detection unit to perform abnormality detection when it is determined that a situation in which degradation of the respective battery cells has occurred or a situation in which a possibility of degradation is high occurs.

Configuration 21

The battery state detection device according to any one of configurations 1 to 20, wherein

each of the battery cells has, in a voltage-capacity characteristic indicating a relationship between voltage and electric capacity, a plateau region and a steep region in which the change in voltage with respect to electric capacity is greater than in the plateau region, and
the abnormality detection unit is configured to determine whether the predetermined deviation occurs based on the parameter change amount on condition that an electric capacity of each of the battery cells is in the steep region.

Configuration 22

The battery state detection device according to any one of configurations 1 to 21, wherein

the battery system includes a voltage adjustment unit configured to adjust terminal voltages of the respective battery cells to the same voltage in the battery module,
the acquisition unit is configured to acquire, as the state detection values, the terminal voltages of the respective battery cells, and
the abnormality detection unit is configured to determine whether the predetermined deviation occurs based on the parameter change amount on condition that a voltage adjustment by the voltage adjustment unit has been executed.

The present disclosure has been described in accordance with the embodiments. However, it is understood that the present disclosure is not limited to these embodiments or structures. The present disclosure encompasses various modifications and variations within the scope of equivalents. In addition, while the various elements are shown in various combinations and configurations, which are exemplary, other combinations and configurations, including more, less or only a single element, are also within the spirit and scope of the present disclosure.

**Claims**

1. A battery state detection device (20), applicable to a battery system including a battery module (11) having battery cells (13) connected in series, wherein a state of each battery cell is detected by a state detection unit, the battery state detection device comprising:

an acquisition unit configured to acquire state detection values of the respective battery cells detected by the state detection unit;

a parameter change amount calculation unit configured to:

use, as a state parameter of each battery cell, either a state detection value acquired by the acquisition unit or a state calculation value, the state calculation value being calculated based on the state detection value and indicating the state of the battery cell; and

calculate, as a parameter change amount, a change in the state parameter over a predetermined period; and

an abnormality detection unit configured to:

sequentially set each of the battery cells, one by one, as a target cell for abnormality detection; and detect an abnormality of the target cell based on whether a predetermined deviation occurs in the parameter change amount of the target cell relative to the parameter change amount of another of the battery cells.

2. The battery state detection device according to claim 1, further comprising:

a difference value calculation unit configured to calculate, for the target cell, difference values in the parameter change amount between the target cell and each of at least two different battery cells, wherein the abnormality detection unit is configured to:

determine whether the predetermined deviation occurs in the target cell based on the change amount difference values calculated by the difference value calculation unit; and detect an abnormality of the target cell based on the determination result.

3. The battery state detection device according to claim 2, wherein

the difference value calculation unit is configured to:

calculate, as a first difference value, a change amount difference value between the target cell and a first non-target cell, which is a battery cell different from the target cell in the battery module; and calculate, as a second difference value, a change amount difference value between the target cell and a second non-target cell, which is a battery cell different from the target cell and the first non-target cell in the battery module, and

the abnormality detection unit is configured to determine that the predetermined deviation occurs in the target cell when both an absolute value of the first difference value and an absolute value of the second difference value are greater than a predetermined threshold.

4. The battery state detection device according to claim 2, wherein

the difference value calculation unit is configured to, at a predetermined cycle:

calculate, as a first difference value, a change amount difference value between the target cell and a first non-target cell, which is a battery cell different from the target cell in the battery module; calculate, as a second difference value, a change amount difference value between the target cell and a second non-target cell, which is a battery cell different from the target cell and the first non-target cell in the battery module; accumulate, as a first accumulated difference value, an absolute value of the first difference value each time the first difference value is calculated; and accumulate, as a second accumulated difference value, an absolute value of the second difference value each time the second difference value is calculated, and

the abnormality detection unit is configured to determine that the predetermined deviation occurs in the target cell when both the first accumulated difference value and the second accumulated difference value are greater than a predetermined threshold.

5. The battery state detection device according to claim 2, wherein

a battery cell adjacent to a negative electrode side of the target cell is a first adjacent cell,
a battery cell adjacent to a positive electrode side of the target cell is a second adjacent cell,
the difference value calculation unit is configured to:

calculate, as a first difference value and a second difference value, respectively, change amount difference values between each adjacent cell and the target cell by subtraction in either ascending or descending order of cell series arrangement, in the same direction for both adjacent cells; and
calculate, as a second-order difference value, a difference between the first difference value and the second difference value, and

the abnormality detection unit is configured to determine that the predetermined deviation occurs in the target cell when the second-order difference value is greater than a predetermined threshold.

6. The battery state detection device according to claim 2, wherein

a battery cell adjacent to a negative electrode side of the target cell is a first adjacent cell,
a battery cell adjacent to a positive electrode side of the target cell is a second adjacent cell,
the difference value calculation unit is configured to:

calculate, as a first difference value and a second difference value, respectively, change amount difference values between each adjacent cell and the target cell by subtraction in ascending or descending order of cell series arrangement, in the same direction for both adjacent cells;
calculate, as a second-order difference value, a difference between the first difference value and the second difference value; and
accumulate, as a second-order accumulated difference value, the second-order difference value each time the second-order difference value is calculated, and

the abnormality detection unit is configured to determine that the predetermined deviation occurs in the target cell when the second-order accumulated difference value is greater than a predetermined threshold.

7. The battery state detection device according to claim 2, wherein

the battery system includes battery cell groups, each constituted by three or more battery cells connected in series with each other,
the battery state detection device further comprising:

a first difference value calculation unit configured to calculate, for the target cell, difference values in the parameter change amount between the target cell and each of at least two different battery cells, as first difference values, for each battery cell group;
a provisional abnormality determination unit configured to preliminarily determine, for each battery cell group, presence or absence of an abnormality among the battery cells in each battery cell group based on the first difference values; and
a second difference value calculation unit, for a battery cell group preliminarily determined to have an abnormality by the provisional abnormality determination unit, configured to:

calculate, as a first difference value and a second difference value, respectively, change amount difference values between a first adjacent cell, which is a battery cell adjacent to the negative electrode side of the target cell, and the target cell, and between a second adjacent cell, which is a battery cell adjacent to the positive electrode side of the target cell, and the target cell, by subtraction in ascending or descending order of cell series arrangement, in the same direction for both adjacent cells; and
calculate, as a second-order difference value, a difference between the first difference value and the second difference value, wherein

the abnormality detection unit is configured to determine whether the predetermined deviation occurs in the target cell based on the second-order difference value calculated by the second difference value calculation unit.

8. The battery state detection device according to claim 2, further comprising:

a first difference value calculation unit configured to calculate, for the target cell, change amount difference values in the parameter change amount between the target cell and each of at least two different battery cells as first difference values;

a second difference value calculation unit configured to:

calculate, as a first difference value and a second difference value, respectively, change amount difference values between a first adjacent cell, which is a battery cell adjacent to the negative electrode side of the target cell, and the target cell, and between a second adjacent cell, which is a battery cell adjacent to the positive electrode side of the target cell, and the target cell, by subtraction in ascending or descending order of cell series arrangement, in the same direction for both adjacent cells; and

calculate, as a second-order difference value, a difference between the first difference value and the second difference value, wherein

the abnormality detection unit includes:

a first determination unit configured to determine whether the predetermined deviation occurs in the target cell based on the first difference values;

a second determination unit configured to determine whether the predetermined deviation occurs in the target cell based on the second-order difference value; and

a switching execution unit configured to switch, based on a predetermined switching condition, whether to detect an abnormality of the target cell according to a determination result of the first determination unit or according to a determination result of the second determination unit.

9. The battery state detection device according to claim 8, further comprising:

a degradation determination unit configured to determine whether a situation in which degradation of the respective battery cells has occurred or a situation in which a possibility of degradation is high occurs in the battery module, wherein

the switching execution unit is configured to:

use a determination result by the degradation determination unit as the predetermined switching condition; and

detect an abnormality of the target cell according to the determination result of the second determination unit when it is determined that a situation in which degradation of the respective battery cells has occurred or a situation in which a possibility of degradation is high occurs.

10. The battery state detection device according to claim 1, further comprising:

a degree-of-deviation calculation unit configured to calculate, as a degree of deviation, the degree to which the parameter change amount of the target cell deviates from an average value of parameter change amounts of the battery cells in the battery module, wherein

the abnormality detection unit is configured to:

determine whether the predetermined deviation occurs in the target cell based on the degree of deviation calculated by the degree-of-deviation calculation unit; and

detect an abnormality of the target cell based on a result of the determination, and

the degree-of-deviation calculation unit is configured to calculate the degree to which the parameter change amount of the target cell deviates from an average value of parameter change amounts of the remaining battery cells excluding the target cell among the battery cells.

11. The battery state detection device according to claim 1, further comprising:

a degree-of-deviation calculation unit configured to:

calculate, at each predetermined cycle, a degree of deviation of the parameter change amount of the target cell relative to an average value of parameter change amounts of the battery cells in the battery module; and

accumulate, as an accumulated degree-of-deviation value, the degree of deviation each time the degree of deviation is calculated, wherein

the abnormality detection unit is configured to:

determine whether the predetermined deviation occurs in the target cell based on the accumulated degree-of-deviation value calculated by the degree-of-deviation calculation unit; and
detect an abnormality of the target cell based on a result of the determination, and

the degree-of-deviation calculation unit is configured to calculate the degree to which the parameter change amount of the target cell deviates from an average value of parameter change amounts of the remaining battery cells excluding the target cell among the battery cells.

12. The battery state detection device according to claim 1, further comprising:

a deviation calculation unit configured to calculate, as a deviation, a difference between the parameter change amount of the target cell and an average value of parameter change amounts of the battery cells;
a standard deviation calculation unit configured to calculate a standard deviation by taking a square root of a mean of the squares of differences between parameter change amounts of the battery cells and the average value; and
an accumulated value calculation unit configured to accumulate, as an accumulated deviation value, an absolute value of the deviation each time the deviation is calculated, wherein
the abnormality detection unit is configured to determine whether the predetermined deviation occurs in the target cell by comparing the accumulated deviation value calculated by the accumulated value calculation unit with a threshold set based on the standard deviation calculated by the standard deviation calculation unit,
the deviation calculation unit is configured to calculate the deviation using an average value of parameter change amounts of the remaining battery cells excluding the target cell, and
the standard deviation calculation unit is configured to calculate the standard deviation using parameter change amounts of the remaining battery cells excluding the target cell.

13. The battery state detection device according to claim 1, further comprising:

a difference value calculation unit configured, when a specified cell is designated one by one among the battery cells and a battery cell adjacent to a negative electrode side of the specified cell is a first adjacent cell and a battery cell adjacent to a positive electrode side of the specified cell is a second adjacent cell, to:

calculate, by subtraction in either ascending or descending order of the cell series arrangement, in the same direction for both adjacent cells, difference values in parameter change amount between the specified cell and the first adjacent cell and between the specified cell and the second adjacent cell, respectively, as the first difference value and the second difference value; and
calculate a difference between the first difference value and the second difference value as a second-order difference value; and

a degree-of-deviation calculation unit configured to:

set, as a specific second-order difference value, the second-order difference value calculated with the target cell set as the specified cell; and
calculate, as a degree of deviation, a degree to which the specific second-order difference value deviates from an average value of second-order difference values calculated by setting each of the battery cells in the battery module one by one as the specified cell, wherein

the abnormality detection unit is configured to:

determine whether the predetermined deviation occurs in the target cell based on the degree of deviation calculated by the degree-of-deviation calculation unit; and
detect an abnormality of the target cell based on a result of the determination, and

the degree-of-deviation calculation unit is configured to calculate the degree to which the specific second-order difference value deviates from an average value of remaining second-order difference values excluding the specific second-order difference value among the second-order difference values calculated by setting each of the battery cells one by one as the specified cell.

14. The battery state detection device according to claim 1, further comprising:

a difference value calculation unit configured, when a specified cell is designated one by one among the battery cells and a battery cell adjacent to a negative electrode side of the specified cell is a first adjacent cell and a battery cell adjacent to a positive electrode side of the specified cell is a second adjacent cell, to:

calculate, by subtraction in either ascending or descending order of the cell series arrangement, in the same direction for both adjacent cells, difference values in parameter change amount between the specified cell and the first adjacent cell and between the specified cell and the second adjacent cell, respectively, as the first difference value and the second difference value; and
calculate a difference between the first difference value and the second difference value as a second-order difference value, and

a degree-of-deviation calculation unit configured to:

set, as a specific second-order difference value, the second-order difference value calculated with the target cell set as the specified cell; and
calculate, as a degree of deviation, a degree to which the specific second-order difference value deviates from an average value of second-order difference values calculated by setting each of the battery cells in the battery module one by one as the specified cell, wherein

the abnormality detection unit is configured to:

determine whether the predetermined deviation occurs in the target cell based on the degree of deviation calculated by the degree-of-deviation calculation unit; and
detect an abnormality of the target cell based on a result of the determination, and

the degree-of-deviation calculation unit is configured to calculate the degree to which the specific second-order difference value deviates from an average value of remaining second-order difference values, excluding the specific second-order difference value and the second-order difference values calculated by setting each of the first adjacent cell and the second adjacent cell individually as the specified cell among the second-order difference values calculated by setting each of the battery cells one by one as the specified cell.

15. The battery state detection device according to any one of claims 1 to 14, further comprising:

a provisional abnormality determination unit configured to preliminarily determine, as an abnormal cell, a battery cell among the battery cells for which a difference from an average value of parameter change amounts is greater than or equal to a predetermined value, wherein
the abnormality detection unit is configured to sequentially set each abnormal cell preliminarily determined by the provisional abnormality determination unit as the target cell and determine whether the predetermined deviation occurs in the target cell.

16. The battery state detection device according to claim 1, further comprising:

a correlation coefficient calculation unit configured to calculate, for the target cell, correlation coefficients, each serving as a metric indicating strength of correlation of the parameter change amount with respect to at least two different battery cells, wherein
the abnormality detection unit is configured to:

determine whether the predetermined deviation occurs in the target cell based on the correlation coefficients calculated by the correlation coefficient calculation unit; and
detect an abnormality of the target cell based on a result of the determination.

17. The battery state detection device according to claim 1, wherein,

the state detection unit includes a first sensor (31) configured to detect a cell voltage, which is a terminal voltage

**EP 4 779 753 A1**

between terminals of each of the battery cells, and a second sensor (34) configured to detect a temperature, strain, or internal pressure of each of the battery cells;

the acquisition unit is configured to acquire, as the state detection values, the cell voltages of the respective battery cells detected by the first sensor and the temperature, strain, or internal pressure of the respective battery cells detected by the second sensor,

the parameter change amount calculation unit is configured to calculate, as the parameter change amounts, a first parameter change amount based on the cell voltages of the respective battery cells detected by the first sensor and a second parameter change amount based on the temperature or the strain of the respective battery cells detected by the second sensor, and

the abnormality detection unit is configured to:

perform a first abnormality detection process that detects an abnormality of the target cell based on the first parameter change amount and a second abnormality detection process that detects an abnormality of the target cell based on the second parameter change amount; and

perform the second abnormality detection process on condition that an abnormality of the target cell has been detected by the first abnormality detection process.

18. A battery state detection device, applicable to a battery system including a battery module (11) having battery cells (13) connected in series, wherein a state of each battery cell is detected by a state detection unit, the battery state detection device comprising:

a first abnormality detection unit configured to detect abnormalities of the respective battery cells by a calculation process with a relatively small computational load based on state detection values of the respective battery cells detected by the state detection unit;

a second abnormality detection unit configured to detect abnormalities of the respective battery cells by a calculation process with a relatively large computational load based on state detection values of the respective battery cells detected by the state detection unit; and

a switching execution unit configured to switch, based on a predetermined switching condition, whether to detect abnormalities of the respective battery cells by the first abnormality detection unit or by the second abnormality detection unit.

19. The battery state detection device according to claim 18, wherein

the switching execution unit is configured to use, as the predetermined switching condition, that an abnormality is detected by the first abnormality detection unit in any one of the battery cells in the battery module and, upon satisfaction of the switching condition, causes the second abnormality detection unit to perform abnormality detection.

20. The battery state detection device according to claim 18, further comprising:

a degradation determination unit configured to determine whether a situation in which degradation of the respective battery cells has occurred or a situation in which a possibility of degradation is high occurs in the battery module, wherein

the switching execution unit is configured to:

use a determination result by the degradation determination unit as the predetermined switching condition; and

cause the second abnormality detection unit to perform abnormality detection when it is determined that a situation in which degradation of the respective battery cells has occurred or a situation in which a possibility of degradation is high occurs.

21. The battery state detection device according to claim 1, wherein

each of the battery cells has, in a voltage-capacity characteristic indicating a relationship between voltage and electric capacity, a plateau region and a steep region in which the change in voltage with respect to electric capacity is greater than in the plateau region, and

the abnormality detection unit is configured to determine whether the predetermined deviation occurs based on the parameter change amount on condition that an electric capacity of each of the battery cells is in the steep region.

38

**22.** The battery state detection device according to claim 1, wherein

the battery system includes a voltage adjustment unit configured to adjust terminal voltages of the respective battery cells to the same voltage in the battery module,

the acquisition unit is configured to acquire, as the state detection values, the terminal voltages of the respective battery cells, and

the abnormality detection unit is configured to determine whether the predetermined deviation occurs based on the parameter change amount on condition that a voltage adjustment by the voltage adjustment unit has been executed.

**23.** A program executable by a computer (20), applicable to a battery system including a battery module (11) having battery cells (13) connected in series, wherein a state of each battery cell is detected by a state detection unit, the program causing the computer to execute:

an acquisition process for acquiring state detection values of the respective battery cells, the state detection values being detected by the state detection unit;

a parameter change amount calculation process for using, as a state parameter of a battery cell, either a state detection value acquired by the acquisition process or a state calculation value calculated based on the state detection value and indicating the state of the battery cell, and for calculating, as a parameter change amount, a change in the state parameter over a predetermined period; and

an abnormality detection process for sequentially setting each of the battery cells, one by one, as a target cell for abnormality detection and detecting an abnormality of the target cell based on whether a predetermined deviation occurs in a parameter change amount of the target cell relative to another of the battery cells.

**24.** A program executable by a computer (20), applicable to a battery system including a battery module (11) having battery cells (13) connected in series, with a state of each battery cell being detected by a state detection unit, the program causing the computer to execute:

a first abnormality detection process for detecting abnormalities of the respective battery cells by a calculation process with a relatively small computational load based on state detection values of the respective battery cells detected by the state detection unit;

a second abnormality detection process for detecting abnormalities of the respective battery cells by a calculation process with a relatively large computational load based on state detection values of the respective battery cells detected by the state detection unit; and

a switching execution process for switching, based on a predetermined switching condition, whether to detect abnormalities of the respective battery cells by the first abnormality detection process or by the second abnormality detection process.

# FIG. 1

# FIG. 2

# FIG. 3

# FIG. 4

# FIG. 5

```
                    ┌──────────────┐
                    │    START     │
                    └──────┬───────┘
                           │  ◄──────────────────────────────┐
                           ▼                                  │
        ┌──────────────────────────────────────┐             │
        │ ACQUIRE CELL VOLTAGE V AT TIME tm     │─── S101     │
        └──────────────────┬───────────────────┘             │
                           ▼                                  │
        ┌──────────────────────────────────────┐             │
        │ CALCULATE VOLTAGE VARIATION VA(tm)    │─── S102     │
        └──────────────────┬───────────────────┘             │
                           ▼                                  │
        ┌──────────────────────────────────────┐             │
        │ CALCULATE ABSOLUTE VALUE OF VA(tm)    │─── S103     │
        └──────────────────┬───────────────────┘             │
                           ▼                                  │
        ┌──────────────────────────────────────┐             │
        │ ΔV_{i+1,i}(tm) = |VA_{i+1}(tm)| − |VA_i(tm)| │─ S104 │
        └──────────────────┬───────────────────┘             │
                           ▼                                  │
```

$$\Delta V_{i+1,\,i}(tm) = |VA_{i+1}(tm)| - |VA_i(tm)|$$

S104

S105

$$\Delta V_{i,\,i-1}(tm) \geq TH11 \text{ (POSITIVE VALUE) AND } \Delta V_{i+1,\,i}(tm) \leq TH12 \text{ (NEGATIVE VALUE)?}$$

NO

YES

S107

IDENTIFY CELL i AS ABNORMAL

S106

$$m = m+1$$

S108

ABNORMALITY NOTIFICATION

END

# FIG. 6

```
                    ┌─────────────┐
                    │    START    │
                    └─────────────┘
                           │
                           ▼
      ┌─────────────────────────────────────┐
      │  ACQUIRE CELL VOLTAGE V AT TIME tm   │ ～S101
      └─────────────────────────────────────┘
                           │
                           ▼
      ┌─────────────────────────────────────┐
      │  CALCULATE VOLTAGE VARIATION VA(tm)  │ ～S102
      └─────────────────────────────────────┘
                           │
                           ▼
      ┌─────────────────────────────────────┐
      │  CALCULATE ABSOLUTE VALUE OF VA(tm)  │ ～S103
      └─────────────────────────────────────┘
                           │
                           ▼
      ┌─────────────────────────────────────┐
      │                                     │ ～S104
      └─────────────────────────────────────┘
                           │
                           ▼
      ┌─────────────────────────────────────┐
      │                                     │ ～S201
      └─────────────────────────────────────┘
                           │
                           ▼
      ┌─────────────────────────────────────┐
      │                                     │ ～S202
      └─────────────────────────────────────┘
```

$$\Delta V_{i+1,\,i}(tm) = |VA_{i+1}(tm)| - |VA_i(tm)|$$ — S104

CALCULATE ABSOLUTE VALUE OF $\Delta V_{i+1,\,i}(tm)$ — S201

$$QA_{i+1,\,i}(tm) = \sum_{k=0}^{m} |\Delta V_{i+1,\,i}(tk)|$$ — S202

S203

$$QA_{i,\,i-1}(tm) \geq TH2$$
$$\text{AND } QA_{i+1,\,i}(tm) \geq TH2?$$

NO

YES

IDENTIFY CELL i AS ABNORMAL — S107

m = m+1 — S106

ABNORMALITY NOTIFICATION — S108

END

# FIG. 7

# FIG. 8

# FIG. 9

START

ACQUIRE CELL VOLTAGE V AT TIME tm — S301

CALCULATE VOLTAGE VARIATION VA(tm) — S302

CALCULATE ABSOLUTE VALUE OF VA(tm) — S303

$\Delta V_{i+1, i}(tm) = |VA_{i+1}(tm)| - |VA_i(tm)|$ — S304

$\Delta \Delta V_{i+1, i, i-1}(tm) = \Delta V_{i+1, i}(tm) - \Delta V_{i, i-1}(tm)$ — S305

S306

$\Delta \Delta V_{i+1, i, i-1}(tm) \leq TH3?$

NO

YES

IDENTIFY CELL i AS ABNORMAL — S308

m = m+1 — S307

ABNORMALITY NOTIFICATION — S309

END

# FIG. 10

```
                    ( START )
                        │
                        ▼
        ┌───────────────────────────────────┐
        │ ACQUIRE CELL VOLTAGE V AT TIME tm  │──S301
        └───────────────────────────────────┘
                        │
                        ▼
        ┌───────────────────────────────────┐
        │ CALCULATE VOLTAGE VARIATION VA(tm) │──S302
        └───────────────────────────────────┘
                        │
                        ▼
        ┌───────────────────────────────────┐
        │ CALCULATE ABSOLUTE VALUE OF VA(tm) │──S303
        └───────────────────────────────────┘
                        │
                        ▼
        ┌───────────────────────────────────┐
        │                                    │──S304
        └───────────────────────────────────┘
```

$$\Delta V_{i+1,i}(tm) = |VA_{i+1}(tm)| - |VA_i(tm)| \quad \text{S304}$$

$$\Delta\Delta V_{i+1,i,\,i-1}(tm) = \Delta V_{i+1,i}(tm) - \Delta V_{i,\,i-1}(tm) \quad \text{S305}$$

$$QB_{i+1,i,i-1}(tm) = \sum_{k=0}^{m}\left(\Delta\Delta V_{i+1,i,i-1}(tk)\right) \quad \text{S401}$$

**S402**

$$QB_{i+1,i,\,i-1}(tm) \geq TH4?$$

NO → **S307** $m = m+1$

YES

**S308** IDENTIFY CELL i AS ABNORMAL

**S309** ABNORMALITY NOTIFICATION

( END )

# FIG. 11

START

ACQUIRE CELL VOLTAGE V AT TIME tm ～S501

CALCULATE VOLTAGE VARIATION VA(tm) ～S502

CALCULATE AVERAGE VALUE $\mu$i(tm)
(AVERAGE VALUE EXCLUDING CELL Ci) ～S503

CALCULATE STANDARD DEVIATION $\sigma$i(tm)
(STANDARD DEVIATION EXCLUDING CELL Ci) ～S504

Ri(tm) = |VAi(tm)－$\mu$i(tm)|/$\sigma$i(tm) ～S505

S506

Ri(tm) ≥ TH5?

NO

YES

IDENTIFY CELL i AS ABNORMAL ～S508

507

m = m+1

ABNORMALITY NOTIFICATION ～S509

END

# FIG. 12

```
                    ┌─────────────┐
                    │    START    │
                    └──────┬──────┘
                           │ ◄──────────────────────────┐
                           ▼                             │
        ┌───────────────────────────────────┐           │
        │ ACQUIRE CELL VOLTAGE V AT TIME tm  │─── S501   │
        └──────────────────┬────────────────┘           │
                           ▼                             │
        ┌───────────────────────────────────┐           │
        │ CALCULATE VOLTAGE VARIATION VA(tm) │─── S502   │
        └──────────────────┬────────────────┘           │
                           ▼                             │
        ┌───────────────────────────────────┐           │
        │ CALCULATE AVERAGE VALUE μi(tm)     │─── S503   │
        │ (AVERAGE VALUE EXCLUDING CELL Ci)  │           │
        └──────────────────┬────────────────┘           │
                           ▼                             │
        ┌───────────────────────────────────┐           │
        │ CALCULATE STANDARD DEVIATION σi(tm)│─── S504   │
        │(STANDARD DEVIATION EXCLUDING CELL Ci)│         │
        └──────────────────┬────────────────┘           │
                           ▼                             │
        ┌───────────────────────────────────┐           │
        │ Ri(tm) = |VAi(tm)−μi(tm)|/σi(tm)   │─── S505   │
        └──────────────────┬────────────────┘           │
                           ▼                             │
        ┌───────────────────────────────────┐           │
        │                                    │─── S601   │
        └──────────────────┬────────────────┘           │
```

Step S601:

$$QC_i(tm) = \sum_{k=0}^{m} |R_i(tk)|$$

```
                           ▼
                    ╱───────────────╲  ─── S602
                  ╱                   ╲
                ╱                       ╲        NO
               ⟨   QCi(tm) ≥ TH6?        ⟩──────────┐
                ╲                       ╱           │
                  ╲                   ╱             ▼
                    ╲───────────────╱      ┌──────────────┐
                           │ YES           │   m = m+1     │─── S507
                           ▼               └──────┬───────┘
        ┌───────────────────────────────┐         └──────────┘ (back to top)
        │ IDENTIFY CELL i AS ABNORMAL    │─── S508
        └──────────────┬────────────────┘
                       ▼
        ┌───────────────────────────────┐
        │ ABNORMALITY NOTIFICATION       │─── S509
        └──────────────┬────────────────┘
                       ▼
                ┌─────────────┐
                │     END     │
                └─────────────┘
```

# FIG. 13

```
                    ┌─────────────┐
                    │    START    │
                    └─────────────┘
                           │
    ┌──────────────────────────────────────────┐
    │  ACQUIRE CELL VOLTAGE V AT TIME tm         │──S501
    └──────────────────────────────────────────┘
                           │
    ┌──────────────────────────────────────────┐
    │  CALCULATE VOLTAGE VARIATION VA(tm)        │──S502
    └──────────────────────────────────────────┘
                           │
    ┌──────────────────────────────────────────┐
    │  CALCULATE AVERAGE VALUE μi(tm)            │──S503
    │  (AVERAGE VALUE EXCLUDING CELL Ci)         │
    └──────────────────────────────────────────┘
                           │
    ┌──────────────────────────────────────────┐
    │  CALCULATE STANDARD DEVIATION σi(tm)       │──S504
    │  (STANDARD DEVIATION EXCLUDING CELL Ci)    │
    └──────────────────────────────────────────┘
                           │
    ┌──────────────────────────────────────────┐
    │  Di(tm) = VAi(tm) − μi(tm)                 │──S611
    └──────────────────────────────────────────┘
                           │
    ┌──────────────────────────────────────────┐
    │  QDi(tm) = Σ |Di(tk)|                      │──S612
    └──────────────────────────────────────────┘
```

$$QD_i(tm) = \sum_{k=0}^{m} |D_i(tk)|$$

S613

$$QD_i(tm) \geq K \cdot \sigma_i(tm)\,?$$

NO → S507: $m = m+1$

YES

S508: IDENTIFY CELL i AS ABNORMAL

S509: ABNORMALITY NOTIFICATION

END

# FIG. 14

START

ACQUIRE CELL VOLTAGE V AT TIME tm — S701

CALCULATE VOLTAGE VARIATION VA(tm) — S702

CALCULATE ABSOLUTE VALUE OF VA(tm) — S703

$\Delta V_{i+1, i}(tm) = |VA_{i+1}(tm)| - |VA_i(tm)|$ — S704

$\Delta \Delta V_{i+1, i, i-1}(tm) = \Delta V_{i+1, i}(tm) - \Delta V_{i, i-1}(tm)$ — S705

CALCULATE AVERAGE VALUE $\mu Ai(tm)$
(AVERAGE VALUE EXCLUDING CELL Ci) — S706

CALCULATE STANDARD DEVIATION $\sigma Ai(tm)$
(STANDARD DEVIATION EXCLUDING CELL Ci) — S707

$RAi(tm) = |\Delta \Delta V_{i+1, i, i-1}(tm) - \mu Ai(tm)| / \sigma Ai(tm)$ — S708

S709

$RAi(tm) \geq TH7?$

NO

YES

S711

IDENTIFY CELL i AS ABNORMAL

S710

m = m+1

S712

ABNORMALITY NOTIFICATION

END

# FIG. 15

START

ACQUIRE CELL VOLTAGE V AT TIME tm ～S701

CALCULATE VOLTAGE VARIATION VA(tm) ～S702

CALCULATE ABSOLUTE VALUE OF VA(tm) ～S703

$\Delta V_{i+1,\,i}(tm) = |VA_{i+1}(tm)| - |VA_i(tm)|$ ～S704

$\Delta \Delta V_{i+1,\,i,\,i-1}(tm) = \Delta V_{i+1,\,i}(tm) - \Delta V_{i,\,i-1}(tm)$ ～S705

CALCULATE AVERAGE VALUE $\mu Ai(tm)$
(AVERAGE VALUE EXCLUDING CELLS $C_{i-1}$, $C_i$, $C_{i+1}$) ～S706a

CALCULATE STANDARD DEVIATION $\sigma Ai(tm)$
(STANDARD DEVIATION EXCLUDING CELLS $C_{i-1}$, $C_i$, $C_{i+1}$) ～S707a

$RAi(tm) = |\Delta \Delta V_{i+1,\,i,\,i-1}(tm) - \mu Ai(tm)| / \sigma Ai(tm)$ ～S708

S709

$RAi(tm) \geq TH7?$

NO

YES

IDENTIFY CELL i AS ABNORMAL ～S711

S710
m = m+1

ABNORMALITY NOTIFICATION ～S712

END

# FIG. 16

START

ACQUIRE CELL VOLTAGE V AT TIME tm ~S701

CALCULATE VOLTAGE VARIATION VA(tm) ~S702

CALCULATE ABSOLUTE VALUE OF VA(tm) ~S703

$\Delta V_{i+1, i}(tm) = |VA_{i+1}(tm)| - |VA_i(tm)|$ ~S704

$\Delta \Delta V_{i+1, i, i-1}(tm) = \Delta V_{i+1, i}(tm) - \Delta V_{i, i-1}(tm)$ ~S705

CALCULATE AVERAGE VALUE $\mu Ai(tm)$
(AVERAGE VALUE EXCLUDING CELL Ci) ~S706

CALCULATE STANDARD DEVIATION $\sigma Ai(tm)$
(STANDARD DEVIATION EXCLUDING CELL Ci) ~S707

$RAi(tm) = |\Delta \Delta V_{i+1, i, i-1}(tm) - \mu Ai(tm)| / \sigma Ai(tm)$ ~S708

$$QEi(tm) = \sum_{k=0}^{m} \left( RA_i(tk) \right)$$ ~S801

S802

$QEi(tm) \geq TH8?$ — NO

YES

IDENTIFY CELL i AS ABNORMAL ~S711

m = m+1 ~S710

ABNORMALITY NOTIFICATION ~S712

END

# FIG. 17

# FIG. 18

START

S901

IMMEDIATELY AFTER EQUALIZATION? — NO

YES

ACQUIRE CELL VOLTAGE V AT TIME tm — S101

CALCULATE VOLTAGE VARIATION VA(tm) — S102

PROVISIONAL ABNORMALITY DETERMINATION FOR EACH CELL — S902

S903

ABNORMALITY? — NO

YES

CALCULATE ABSOLUTE VALUE OF VA(tm) — S103

$\Delta V_{i+1, i}(tm) = |VA_{i+1}(tm)| - |VA_i(tm)|$ — S104

S105

$\Delta V_{i, i-1}(tm) \geq$ TH11 (POSITIVE VALUE) AND $\Delta V_{i+1, i}(tm) \leq$ TH12 (NEGATIVE VALUE)? — NO

YES

S107
IDENTIFY CELL i AS ABNORMAL

S106
m = m+1

S108
ABNORMALITY NOTIFICATION

END

# FIG. 19

# FIG. 20

```
                    ┌─────────────┐
                    │    START    │
                    └──────┬──────┘
                           │
        ┌──────────────────▼──────────────────┐
        │ ACQUIRE CELL VOLTAGE V AT TIME tm    │～S501
        └──────────────────┬──────────────────┘
        ┌──────────────────▼──────────────────┐
        │ CALCULATE VOLTAGE VARIATION VA(tm)   │～S502
        └──────────────────┬──────────────────┘
        ┌──────────────────▼──────────────────┐
        │      PROVISIONAL ABNORMALITY         │～S1001
        │    DETERMINATION FOR EACH CELL       │
        └──────────────────┬──────────────────┘
        ┌──────────────────▼──────────────────┐
        │ CALCULATE AVERAGE VALUE μi(tm)       │～S503
        │   (AVERAGE VALUE EXCLUDING CELL Ci)  │
        └──────────────────┬──────────────────┘
        ┌──────────────────▼──────────────────┐
        │ CALCULATE STANDARD DEVIATION σi(tm)  │～S504
        │(STANDARD DEVIATION EXCLUDING CELL Ci)│
        └──────────────────┬──────────────────┘
        ┌──────────────────▼──────────────────┐
        │ Ri(tm) = |VAi(tm)-μi(tm)|/σi(tm)     │～S505
        └──────────────────┬──────────────────┘
                           │
                           ▼        S506
                      ◇──────────◇
                     ◇            ◇      NO
                    ◇  Ri(tm) ≥ TH5? ◇──────────┐
                     ◇            ◇              │
                      ◇──────────◇              │
                           │ YES                │
              S508         │                    │    507
        ┌──────────────────▼──────────────────┐ │ ┌──────────┐
        │     IDENTIFY CELL i AS ABNORMAL      │ │ │ m = m+1  │
        └──────────────────┬──────────────────┘ │ └──────────┘
              S509         │                    │
        ┌──────────────────▼──────────────────┐ │
        │       ABNORMALITY NOTIFICATION       │ │
        └──────────────────┬──────────────────┘ │
                           │
                    ┌──────▼──────┐
                    │     END     │
                    └─────────────┘
```

$$Ri(tm) = |VAi(tm) - \mu i(tm)| / \sigma i(tm)$$

$$Ri(tm) \geq TH5?$$

58

# FIG. 21

BATTERY ECU

ACQUISITION UNIT — 61

PARAMETER VARIATION CALCULATION UNIT — 62

FIRST DIFFERENCE VALUE CALCULATION UNIT — 63

PRELIMINARY DETERMINATION UNIT — 64

SECOND DIFFERENCE VALUE CALCULATION UNIT — 65

ABNORMALITY DETECTION UNIT — 66

MONITORING DEVICE

# FIG. 22

START

ACQUIRE CELL VOLTAGE V AT TIME tm ~S1101

CALCULATE VOLTAGE VARIATION VA(tm) ~S1102

CALCULATE ABSOLUTE VALUE OF VA(tm) ~S1103

$\Delta V_{i+1, i}(tm) = |VA_{i+1}(tm)| - |VA_i(tm)|$ ~S1104

S1105

$\Delta V_{i, i-1}(tm) \geq$ TH11 (POSITIVE VALUE) AND $\Delta V_{i+1, i}(tm) \leq$ TH12 (NEGATIVE VALUE)? — NO

YES

PRELIMINARILY DETERMINE THAT CELL i IS ABNORMAL ~S1106

$\Delta \Delta V_{i+1, i, i-1}(tm) = \Delta V_{i+1, i}(tm) - \Delta V_{i, i-1}(tm)$ ~S1107

S1108

$\Delta \Delta V_{i+1, i, i-1}(tm) \leq$ TH3? — NO

YES

S1109

IDENTIFY CELL i AS ABNORMAL

S1110

ABNORMALITY NOTIFICATION

END

60

# FIG. 23

```
        ┌─────────────┐
        │    START    │
        └──────┬──────┘
               │
               │           ╭─ S1200
          ◇────┴────◇                        NO
         EXECUTE FIRST PROCESS? ──────────────────┐
          ◇─────────◇                             │
               │                                  │
               │ YES                              │
               │    ╭─ S1201                      │    ╭─ S1202
   ┌───────────┴───────────┐        ┌─────────────┴────────────┐
   │    EXECUTE FIRST       │        │    EXECUTE SECOND         │
   │ DETERMINATION PROCESS  │        │ DETERMINATION PROCESS     │
   │(ABNORMALITY DETECTION  │        │(ABNORMALITY DETECTION     │
   │ BASED ON VOLTAGE       │        │ BASED ON SECOND           │
   │ DIFFERENCE VALUE △V)   │        │ DIFFERENCE VALUE △△V)     │
   └───────────┬───────────┘        └─────────────┬────────────┘
               │                                  │
               │◄─────────────────────────────────┘
               │
        ┌──────┴──────┐
        │     END     │
        └─────────────┘
```

# FIG. 24

START

ACQUIRE CELL VOLTAGE V AT TIME tm — S1301

CALCULATE VOLTAGE VARIATION VA(tm) — S1302

CALCULATE CORRELATION COEFFICIENT CR(tm) BETWEEN EACH CELL — S1303

S1304

$CR_{i+1, \ i} \leq TH9$ AND
$CR_{i, \ i-1} \leq TH9$?

NO

YES

IDENTIFY CELL $i$ AS ABNORMAL — S1306

$m = m+1$ — S1305

ABNORMALITY NOTIFICATION — S1307

END

# FIG. 25

# FIG. 26

# FIG. 27

START

ACQUIRE CELL VOLTAGE
AND CELL TEMPERATURE — S1401

CALCULATE VOLTAGE VARIATION VA
AND TEMPERATURE CHANGE AMOUNT TA — S1402

S1403

F = 0?

NO

YES

S1404
FIRST DETECTION PROCESS

S1407
SECOND DETECTION PROCESS

S1405
ABNORMALITY?

NO

YES     S1406

F←1

END

# FIG. 28

# FIG. 29

# EP 4 779 753 A1

## INTERNATIONAL SEARCH REPORT

International application No.

**PCT/JP2024/029780**

### A. CLASSIFICATION OF SUBJECT MATTER

*H01M 10/48*(2006.01)i; *G01R 31/382*(2019.01)i; *G01R 31/385*(2019.01)i; *G01R 31/387*(2019.01)i; *G01R 31/389*(2019.01)i; *G01R 31/392*(2019.01)i; *G01R 31/396*(2019.01)i; *H02J 7/00*(2006.01)i
FI: H01M10/48 301; H02J7/00 Y; G01R31/389; G01R31/385; G01R31/392; G01R31/387; G01R31/382; H01M10/48 P; G01R31/396

According to International Patent Classification (IPC) or to both national classification and IPC

### B. FIELDS SEARCHED

Minimum documentation searched (classification system followed by classification symbols)

H01M10/48; G01R31/382; G01R31/385; G01R31/387; G01R31/389; G01R31/392; G01R31/396; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | US 2021/0098998 A1 (SAMSUNG SDI CO., LTD.) 01 April 2021 (2021-04-01) paragraphs [0111]-[0118] | 1-3, 10, 21, 23 |
| A | | 4-9, 11-15, 17, 22 |
| X | WO 2019/243950 A1 (SEMICONDUCTOR ENERGY LABORATORY CO., LTD.) 26 December 2019 (2019-12-26) paragraph [0014] | 1, 16 |
| X | JP 2013-24617 A (DENSO CORPORATION) 04 February 2013 (2013-02-04) paragraphs [0032]-[0088], fig. 5 | 18-20, 24 |

☐ Further documents are listed in the continuation of Box C.   ☑ See patent family annex.

| | | |
|---|---|---|
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" | document member of the same patent family |

| Date of the actual completion of the international search | Date of mailing of the international search report |
|---|---|
| **11 October 2024** | **29 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT

International application No.

**PCT/JP2024/029780**

---

**Box No. III    Observations where unity of invention is lacking (Continuation of item 3 of first sheet)**

---

This International Searching Authority found multiple inventions in this international application, as follows:

(Invention 1) Claims 1-17, and 21-23

Claims 1-17, and 21-23 have the special technical feature of an "abnormality detector which sets each of a plurality of battery cells as a target cell to be subjected to abnormality detection and detects an abnormality in the target cell on the basis of whether a predetermined deviation occurs in the amount of parameter changes between the target cell and battery cells other than the target cell," and are thus classified as invention 1.

(Invention 2) Claims 18-20, and 24

Claims 18-20, and 24 share, with invention 1 classified as claim 1, the common technical feature of being "applied to a battery system which includes a battery module having a plurality of battery cells connected in series, and in which a state of each of the battery cells is detected by a state detection unit." However, the technical feature does not make a contribution over the prior art in light of the disclosures of documents 1-3, and thus cannot be said to be a special technical feature. Also, there are no other same or corresponding special technical features between these inventions.

Additionally, claims 18-20, and 24 do not depend from claim 1. Furthermore, claims 18-20, and 24 are not substantially identical to or similarly closely related to any of the claims classified as invention 1.

Therefore, claims 18-20, and 24 cannot be classified as invention 1.

Moreover, claims 18-20, and 24 have the special technical feature of a "first abnormality detector which detects an abnormality in each battery cell through a calculation process requiring a relatively small calculation load on the basis of a state detection value of each battery cell, a second abnormality detector which detects an abnormality for each of the battery cells through a calculation process requiring a relatively large calculation load on the basis of a state detection value of each battery cell, and a switching execution unit which is switched, on the basis of a predetermined switching condition, between whether the first abnormality detector detects an abnormality in each of the battery cells and whether the second abnormality detector detects an abnormality in each of the battery cells," and are thus classified as invention 2.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

INTERNATIONAL SEARCH REPORT
Information on patent family members

International application No.

**PCT/JP2024/029780**

| Patent document cited in search report | | | Publication date (day/month/year) | Patent family member(s) | | | Publication date (day/month/year) |
|---|---|---|---|---|---|---|---|
| US | 2021/0098998 | A1 | 01 April 2021 | EP | 3800762 | A1 | |
| | | | | KR | 10-2021-0039267 | A | |
| WO | 2019/243950 | A1 | 26 December 2019 | US | 2021/0257681 | A1 | |
| | | | | paragraph [0013] | | | |
| JP | 2013-24617 | A | 04 February 2013 | (Family: none) | | | |

Form PCT/ISA/210 (patent family annex) (July 2022)

**REFERENCES CITED IN THE DESCRIPTION**

**Patent documents cited in the description**

- JP 2023148760 A
- JP 2024097399 A
- JP 2015068821 A